# EUROPEAN PATENT APPLICATION

(11) **EP 4 810 502 A1**
(43) Date of publication of application: **23.09.2026**
(21) Application number: 24891056.4
(22) Date of filing: 30.08.2024
(51) Int. Cl.: C07F 7/22, G03F 7/004, G03F 7/20, G03F 7/00

(54) **TIN COMPOUND, TIN COMPOSITION, METHODS FOR PRODUCING SAME, RESIST SOLUTION, PATTERN FORMING METHOD, THIN FILM, PATTERNED THIN FILM, AND METHOD FOR PRODUCING SUBSTRATE**

(30) Priority: 15.11.2023 US 202363599038 P; 29.11.2023 US 202363603833 P; 30.11.2023 US 202363604355 P; 01.12.2023 JP 2023204286
(71) Applicant: Mitsubishi Chemical Corporation, Tokyo 100-8251 (JP); Gelest, Inc., Morrisville, PA 19067 (US)
(72) Inventor: HIOKI Yuta, Tokyo 100-8251 (JP); YAHATA Sumiko, Tokyo 100-8251 (JP); OKABE URUSHIBARA Ko, Tokyo 100-8251 (JP)
(74) Representative: Vossius & Partner Patentanwälte Rechtsanwälte mbB
(86) International application number: PCT/JP2024/031130
(87) International publication number: WO 2025/105013

(57) **Abstract**

As a high-performance resist material, a tin compound is provided which has properties such as solubility, hydrophobicity, and resist sensitivity with good balance. A tin compound includes a tin atom; an organic group R; and at least one of an oxo-ligand and a hydroxo-ligand. , One molecule of the tin compound includes two or more types of organic group R and includes a Sn-O-Sn structure, and the organic group R has 1 to 30 carbon atoms.

## Description

### TECHNICAL FIELD

The present disclosure relates to a tin compound, a tin composition, a production method therefor, a resist solution, a patterning method, a thin film, a patterned thin film, and a method for producing a substrate.

### BACKGROUND ART

In recent years, there has been a need to handle a greater amount of information at higher speeds with higher precision against the backdrop of a paradigm shift to the advanced information society, and technologies related to semiconductor devices such as integrated circuits using semiconductors have been advancing noticeably day by day.

Evolution of semiconductor design requires formation of features that are finer than ever before on a semiconductor substrate material. Each feature is not greater than about 22 nanometers (nm), and possibly less than 10 nm in some cases. One challenge in production of a device with such fine features is the ability to form a photolithography mask having sufficient resolution securely and reproducibly. To achieve a feature size of smaller than the wavelength of light, it is necessary to use complicated resolution improvement technology, such as multiple patterning. Therefore, it is important to develop photolithography technology using shorter wavelength light, such as extreme ultraviolet radiation (EUV) having a wavelength of 10 nm to 15 nm (for example, 13.5 nm).

A conventional organic chemically amplifying resist (CAR) has a low adsorption coefficient particularly in the EUV region, and may cause a blur with diffusion of an optically active chemical species, large line width roughness (LWR), pattern collapse, etc., and thereby has a latent disadvantage for use in EUV lithography. Therefore, there remains a necessity for an improved EUV photoresist material having properties of higher sensitivity, lower line width roughness (LWR), and better etching resistance.

Accordingly, a metal material using an organotin compound has been used in recent years particularly as a resist applicable for EUV. Specifically, for example, it has been reported that an alkyltin oxo-hydroxo compound synthesized by hydrolysis of a highly pure monoalkyltin compound as a raw material is a resist material applicable for EUV, which may achieve extremely fine negative-type patterning with high resolution and low line width roughness (LWR). It is also reported that a branched alkyl group yields particularly excellent sensitivity as an alkyl group (PTL 1).

In addition, it is reported that use of a monoalkyltin compound containing a dialkyltin compound as an impurity at a low amount as a resist material yields excellent outgas reduction (PTL 2).

It is reported that an alkyltin oxo-hydroxo compound synthesized from a hydrolysable tin compound having a plurality of types of alkyl group as a raw material may achieve both high sensitivity and low line width roughness (LWR) (PTL 3). In addition, reported is an example of synthesizing an alkyltin oxo-hydroxo compound by mixing organometallic compounds having a hydrolysable group having no alkyl group (PTL 4).

### RELATED ART DOCUMENT

### PATENT DOCUMENT

PTL 1: JP-A-2021-21953
PTL 2: JP-A-2021-519340
PTL 3: JP-A-2019-500490
PTL-4: JP-A-2023-27078

### SUMMARY

The alkyltin oxo-hydroxo compounds that have been reported, however, are insufficient for satisfying performance as a resist material. Particularly, structure selection of the alkyl group and blending composition that affect sensitivity and hydrophobicity involved with performance and quality have not been optimized as a resist material, and a preferable cluster structure and composition of the alkyl group in the alkyltinoxo-hydroxo compound have not been clarified.

Thus, under such circumstances, the present disclosure provides a tin compound and/or a tin composition that has good balance of properties such as solubility, hydrophobicity, and resist sensitivity to be usable as a high-performance resist material.

The present inventors have made earnest study to solve the above problem, and consequently found that the above object is achieved with a tin compound including a tin atom, an organic group R, and at least one of an oxo-ligand and a hydroxo-ligand, wherein the tin compound includes a Sn-O-Sn structure and two or more types of the organic group R in one molecule.

Specifically, the present disclosure has the following aspects.
[1] A tin compound, comprising:
   a tin atom;
   an organic group R; and
   at least one of an oxo-ligand and a hydroxo-ligand,
   wherein one molecule of the tin compound includes two or more types of the organic group R and includes a Sn-O-Sn structure, and
   wherein the organic group R has 1 to 30 carbon atoms.
[2] The tin compound according to [1], wherein the tin compound is represented by formula RSnO_{(3/2-X/2)}(OH)_{X}, wherein 0 ≤ x ≤ 3.
[3] The tin compound according to [1] or [2], wherein the tin compound is a compound including a cation represented by a chemical formula (RSn)₁₂O₁₄(OH)₆⁺².
[4] The tin compound according to any one of [1] to [3], wherein the organic group R has 3 to 10 carbon atoms.
[5] The tin compound according to any one of [1] to [4], wherein the organic group R is a hydrocarbon group.
[6] The tin compound according to any one of [1] to [5], wherein the organic group R is a hydrocarbon group, and 20 to 99 mol% of substituents constituting the organic group R is a secondary hydrocarbon group R².
[7] The tin compound according to any one of [1] to [5], wherein the organic group R is a hydrocarbon group, and 1 to 50 mol% of substituents constituting the organic group R is a tertiary hydrocarbon group R³.
[8] The tin compound according to any one of [1] to [5], wherein the organic group R is a hydrocarbon group, and 1 to 50 mol% of substituents constituting the organic group R is a cyclic hydrocarbon group R^{c}.
[9] The tin compound according to any one of [1] to [5], wherein the organic group R is a hydrocarbon group, and 1 to 50 mol% of substituents constituting the organic group R is a hydrocarbon group R^{u} having an unsaturated bond.
[10] The tin compound according to any one of [1] to [9], wherein the organic group R has an isopropyl group and a t-butyl group.
[11] The tin compound according to any one of [1] to [10], wherein the organic group R has an isopropyl group and a methylcyclopentyl group.
[12] The tin compound according to any one of [1] to [11], wherein the organic group R has a saturated hydrocarbon group.
[13] The tin compound according to any one of [1] to [12], wherein the organic group R has not less than 50 mol% of isopropyl groups.
[14] A tin composition, comprising:
   the tin compound according to any one of [1] and [3] to [13], wherein three or more types of a tin compound (P3AB) have a cation represented by a chemical formula (R^{A}Sn)ₓ(R^{B}Sn)_{y}O₁₄(OH)₆⁺² measured by ESI-mass,
   wherein "x" represents an integer satisfying 0 < x < 12, "y" represents an integer satisfying 0 < y < 12, "x" and "y" satisfy x+y=12, and
   in a proportion of a composition of the organic group R calculated by NMR measurement of the tin composition,
   an organic group in a largest proportion is represented by R^{A},
   an organic group in a second largest proportion is represented by R^{B}, and
   wherein the organic group R may have an organic group other than the organic groups R^{A} and R^{B}.
[15] The tin composition according to [14], wherein a total value of a content (%) of the tin compound (P3AB) calculated by calculation formula A is not less than 80%,
   <calculation formula A> 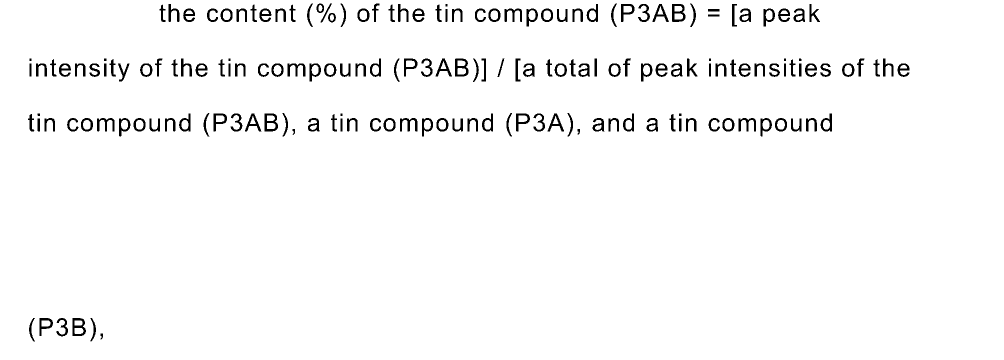 the content (%) of the tin compound (P3AB) = [a peak intensity of the tin compound (P3AB)] / [a total of peak intensities of the tin compound (P3AB), a tin compound (P3A), and a tin compound (P3B),
   wherein the peak intensity refers to a peak intensity measured by ESI-MASS,
   the tin compound (P3A) represents a tin compound having only the single organic group R^{A}, and
   the tin compound (P3B) represents a tin compound having only the single organic group R^{B}.
[16] The tin composition according to [15], wherein a content (%) of a tin compound (P3AB-1) with the largest content (%) calculated by the calculation formula A is larger than a content of the tin compound (P3A) having only the single organic group R^{A}.
[17] The tin composition according to any one of [14] to [16],
   wherein, as for a distribution shape of a graph of the contents (%) of tin compounds (P3AB), (P3A), and (P3B),
   wherein the tin compound (P3A), and the tin compound (P3B) in the tin composition are plotted as a y-axis and a number of the organic groups R^{A} contained in one molecule is plotted as an x-axis, when a tin compound with a largest content is represented as a tin compound (P3AB-1),
   the tin compound (P3AB-1) exhibits a peak top (maximum point), and
   the distribution shape has a single-top distribution structure.
[18] The tin composition according to any one of [14] to [17], wherein a value of a molecular weight distribution Mw/Mn is 1.00001 to 1.05, the value being calculated from peak molecular weights (Mi) and contents (%) (Ni) of the tin compound (P3AB), a tin compound (P3A), and a tin compound (P3B) in the tin composition.
[19] The tin composition according to any one of [14] to [18], wherein the tin compound has a ratio [(k1+ k2)/(k3)] of not less than 0.9, the ratio being of a total value (k1+k2) in ¹¹⁹Sn-NMR of a total (k1) of peak integration values of a five-coordinate Sn (-250 to -350 ppm) and a total (k2) of peak integration values of a six-coordinate Sn (-450 to - 600 ppm) relative to a total value (k3) of all peak integration values (including k1 and k2) within a range of 1000 to -1000 ppm detected from the 11⁹Sn-NMR.
[20] The tin composition according to any one of [14] to [19], wherein the tin compound has a ratio (k1/k2) of 0.5 to 2.5, the ratio being of a total (k1) of peak integration values of a five-coordinate Sn (-250 to - 350 ppm) relative to a total (k2) of peak integration values of a six-coordinate Sn (-450 to -600 ppm) in ¹¹⁹Sn-NMR.
[21] A method for producing at least one of a tin compound and a tin composition, comprising:
   a tin atom,
   an organic group R; and
   at least one of an oxo-ligand and a hydroxo-ligand,
   the method including following steps:
      <step 1> blending two or more precursors RSnX₃ (A1) having different structures of the organic group R to obtain a precursor mixture, wherein X represents a hydrolysable group; and
      <step 2> contacting a blend of the precursor mixture and an organic solvent with liquid water.
[22] The method for producing at least one of a tin compound and a tin composition according to [21], including a step of blending not less than 100 parts by mass of the organic solvent relative to 100 parts by mass of the precursor mixture.
[23] A tin compound or a tin composition produced by the method according to [21] or [22].
[24] A resist solution, including:
   at least one of the tin compound according to any one of [1] to [13] and the tin composition according to any one of [14] to [20]; and
   an organic solvent.
[25] A patterning method, including:
   a step of applying the resist solution according to [24] on a substrate;
   a step of exposing a thin film comprising the tin compound with radiation; and
   a step of developing the thin film by using a developer liquid.
[26] A thin film on a substrate, the thin film including at least one of the tin composition according to any one of [1] to [13] and the tin composition according to any one of [14] to [20].
[27] A patterned thin film on a substrate, the patterned thin film including at least one of the tin compound according to any one of [1] to [13] and the tin composition according to any one of [14] to [20].
[28] A method for producing a substrate, the method comprising the patterning method according to [25].

The tin compound and/or the tin composition of the present disclosure have properties such as solubility, hydrophobicity, and resist sensitivity with good balance to be usable as a high-performance resist material.

### BRIEF DESCRIPTION OF DRAWINGS

FIG 1 is a spectrum of electron-spray ionization mass spectrometry (ESI-MS) of a tin hydrolysate H1;
FIG. 2 is a spectrum of ESI-MS of a tin hydrolysate H2;
FIG. 3 is a spectrum of ESI-MS of a tin hydrolysate H3;
FIG. 4 is a spectrum of ESI-MS of a tin hydrolysate H4;
FIG. 5A is a ¹¹⁹Sn-NMR spectrum of a tin hydrolysate H5;
FIG. 5B is a ¹H-NMR spectrum of the tin hydrolysate H5;
FIG. 5C is a ¹³C-NMR spectrum of the tin hydrolysate H5;
FIG. 5D is a spectrum of ESI-MS of the tin hydrolysate H5;
FIG. 5E is a graph in which a number of organic groups R^{A} in each tin compound in a tin composition of the tin hydrolysate H5 is plotted as the x-axis, and the content (%) is plotted as the y-axis;
FIG. 6A is a ¹¹⁹Sn-NMR spectrum of a tin hydrolysate H6;
FIG. 6B is a ¹H-NMR spectrum of the tin hydrolysate H6;
FIG. 6C is a ¹³C-NMR spectrum of the tin hydrolysate H6;
FIG. 6D is a spectrum of ESI-MS of the tin hydrolysate H6;
FIG. 6E is a graph in which a number of organic groups R^{A} in each tin compound in a tin composition of the tin hydrolysate H6 is plotted as the x-axis, and the content (%) is plotted as the y-axis;
FIG. 7A is a ¹¹⁹Sn-NMR spectrum of a tin hydrolysate H7;
FIG. 7B is a ¹H-NMR spectrum of the tin hydrolysate H7;
FIG. 7C is a spectrum of ESI-MS of the tin hydrolysate H7;
FIG. 8 shows exemplary organic groups;
FIG. 9 shows exemplary organic groups;
FIG. 10 shows exemplary organic groups; and
FIG. 11 shows exemplary organic groups.

### EMBODIMENTS OF THE DISCLOSURE

Hereinafter, the present disclosure will be described based on examples of embodiment of the present disclosure. Note that the present disclosure is not limited to embodiments described as follows.

In the present disclosure, the expression "α to β," wherein α and β represent given numbers, encompasses "preferably greater than α" or "preferably less than β" in addition to a "not less than α and not greater than β" unless otherwise mentioned.

In the present disclosure, the expression "not less than α," wherein α represents a given number, or the expression "not greater than β," wherein β represents a given number encompasses "preferably greater than α" or "preferably less than β."

In the present disclosure, "at least one of γ and δ, wherein γ and δ represent a given constituent or component" means only γ; only δ; and γ and δ.

In a numerical range stepwise described in the present disclosure, an upper limit value or a lower limit value in a numerical range on a certain step may be appropriately combined with an upper limit value or a lower limit value in a numerical range on another step. In a numerical range described in the present description, an upper limit value or a lower limit value within this numerical range may be replaced with values described in Examples.

In the present embodiment, "main component" means a component that significantly affects physical properties of an object, and a content of the component is typically not less than 50 mass%, preferably not less than 55 mass%, more preferably not less than 60 mass%, and further preferably not less than 70 mass%, or may be 100 mass% in the object.

Hereinafter, the tin compound and the tin composition according to one embodiment of the present disclosure will be described in detail. Detailed definitions are described below, and the term "tin compound" means a compound represented by a single chemical formula. The term "tin composition" refers to a mixture of tin compounds represented by a plurality of chemical formulas. The "tin compound" and/or the "tin composition" that are synthesized by hydrolysis may be referred to as "tin hydrolysate" for convenience.

### <<Tin Compound>>

The tin compound (P1) according to one embodiment of the present disclosure is a tin compound having a tin atom, an organic group R, and at least one of an oxo-ligand and a hydroxo-ligand, wherein one molecule of the tin compound includes two or more types of the organic group R and includes a Sn-O-Sn structure, and the organic group R has 1 to 30 carbon atoms. Hereinafter, a substituent bonded to the tin atom may be referred to as "ligand."

Specifically, the present tin compound (P1) is an organotin compound having a plurality of tin atoms and at least a Sn-O-Sn structure. Each of the tin atoms typically has a ligand selected from an organic group R, an oxo-ligand (Sn-O structure or Sn=O structure) and a hydroxy-ligand (Sn-OH structure). In the present embodiment, the organic group R in the tin compound (P1) needs to have two or more types of organic groups with different chemical formulas. It is possible that the present tin compound (P1) has a plurality of tin atoms in one molecule, each of the tin atoms has an R-Sn bond, and the organic group R is two or more types. It is also possible that one tin atom in one molecule has two or more types of organic groups R. The present tin compound (P1) having two or more types of the organic group R in one molecule may be confirmed with analysis results by ESI-mass etc.

The present tin compound (P1) is typically formed with the above metal and ligand, but may have another metal atom and ligand (substituent) within a range not impairing the properties.

The present tin compound (P1) is synthesized by hydrolysis of, for example, RSnX₃ (monoalkyltin compound, which may be referred to as "precursor") as a main raw material using a method disclosed in, for example, JP-A-2021-21953.

Note that the X represents a hydrolysable group [substituent that may form an oxo-ligand (Sn-O structure) or a hydroxo-ligand (Sn-OH structure) via a hydrolysis reaction].

RSnOOH (in the below formula, x=2), RSn(OH)₃ (in the below formula, x=3), and a condensate (in the below formula, x=1), which are tin hydrolysates represented by the following formula, is obtained via a reaction of hydrolysis, condensation, etc. of RSnX₃ with water or another suitable reagent under an appropriate condition. These compounds can also undergo condensation reactions with each other to from reaction condensate. Among these, a tin compound having two or more types of organic groups R and having an Sn-O-Sn structure is a tin compound (P2). The tin compound (P2) is a compound having a tin atom and an organic group, and having an oxo-ligand and/or a hydroxo-ligand. For example, the tin hydrolysate (P2) includes a compound in which a tin atom having an organic group (and optionally having a hydroxo-ligand) forms a network structure via the oxo-ligand.

RSnO_{(1.5-(x/2))}(OH)ₓ, wherein 0 ≤ x ≤ 3 (P2)

Reaction formulas to yield the tin compound (P2) are:

·RSnX₃ + 3H₂O → RSn(OH)₃ + 3HX

·RSn(OH)₃ → RSnO_{(1.5-(x/2))}OHₓ + (x/2)H₂O

Among the compounds included in the present tin compound (P1), a tin compound having a specific structure and a specific number of tin atoms may be utilized as a high-performance resist material. For example, a compound having a tin dodecamer represented by the following chemical formula (tin compound) is a tin dodecamer cluster compound with a stable football shape, and useful as a resist material.

Chemical formula (P3) represents a cationic compound:

(RSn)₁₂O₁₄(OH)₆⁺² (P3)

wherein "+2" represents being a divalent cation.

The tin compound (P3), which is typically a divalent cationic compound, has a counter anion (Z) to be stabilized, and a salt combined with a monovalent counter anion (Z) is represented by the following chemical formula.

(RSn)₁₂O₁₄(OH)₆(Z)₂

The counter anion (Z) is not particularly limited, and examples thereof include an OH anion, a RCO₂ anion, a HCO₂ anion, an F anion, and a Cl anion.

As specific examples of the tin compound (P3), synthesis examples described in the following literature are known, for example.

Literature reporting the synthesis of (nBuSn)₁₂O₁₄(OH)₆⁺²: Eychenne-Baron et al., "New synthesis of the nanobuilding block {(BuSn)12O14(OH)6}2+ and exchange properties of {(BuSn)12O14(OH)6}(O3SC6H4CH3)2", J. Organometallic Chemistry, 1998, 567, 137-142.

Literature reporting the synthesis of (iPrSn)₁₂O₁₄(OH)₆⁺²: described in Puff et al., "Zur hydrolyse von monoorganylzinn-tri halogeniden (III. Isolierung und Roentgens trukturanalyse von Verbindungen mit dem nueartigen Kaefig-ion [(i-PrSn)12O14(OH)6+2]", J. Organometallic Chemistry 1989, 373, 173-184. These compounds have been identified by NMR, single-crystal X-ray structure, etc., and the analysis results are incorporated in the Examples of the present disclosure as support.

### <Tin Composition (M) containing Tin Compound (P1), (P2), or (P3)>

When the tin compound (P1), (P2), or (P3) is produced by hydrolysis, the tin compounds may be obtained as a mixture containing tin compounds having a plurality of types of structures. A mixture of the plurality of types of the tin compound (P1), (P2), or (P3) is referred to as "tin composition (M)." Specific examples of components constituting the mixture include the tin compound (P1), (P2), or (P3) having a plurality of types of the organic group R in one molecule and further having a plurality of different types of the organic group R. In addition, a mixture of the tin compound (P1) or (P2) having different numbers of tin atoms per molecule or a mixture of the tin compound (P1), (P2), or (P3) having different substituents bonded to the tin atom (organic group R, oxo-ligand, and hydroxo-ligand) may also be obtained. These mixtures correspond to the tin composition (M).

Hereinafter, a case of a tin composition (M) containing a tin compound (P3) will be specifically described as an example, but the same applies to a case of containing a tin compound (P1) or (P2). The structure, number of types, and contents of the plurality of the tin compounds (P3) contained in the present tin composition (M) may be analyzed by, for example, ESI-mass. Specific methods of analysis and analysis examples will be described later. The types of tin compound (P3) contained in the tin composition (M) is, as a number detected by ESI-mass, preferably not less than 3 types, further preferably not less than 5 types, and further preferably not less than 7 types as the lower limit. The upper limit is preferably not greater than 30 types, preferably not greater than 25 types, further preferably not greater than 20 types, further preferably not greater than 15 types, and further preferably not greater than 10 types. When the number of types of tin compound (P3) contained in the tin composition (M) is greater than the above lower limit, the crystallinity may be appropriately decreased to impart appropriate solubility when used as a resist solution, and an insoluble crystal is not generated during patterning to reduce roughness in some cases. When the number of types is less than the above upper limit, an amount of the tin compounds (P3) having different structure or molecular weights is small, and therefore a uniform pattern may be formed and roughness during patterning may be reduced.

### Organic Group R

The present tin compound (P1, P2, or P3, the same applies hereinafter) has an organic group R connected to the Sn atom. The organic group R has 1 to 30 carbon atoms.

The number of carbon atoms in the organic group R is not greater than 30 as the upper limit when considering ease of elimination of the R group during EUV exposure and volatilization of the generated component containing the R group. The number is preferably not greater than 20, and more preferably not greater than 10. From the viewpoint of stability of the eliminating component, the lower limit is not less than 1, preferably not less than 2, and more preferably not less than 3.

Examples of organic group R include a halogenated hydrocarbon group, a hydrocarbon group having a heteroatom such as an oxygen atom and a nitrogen atom, and a hydrocarbon group. Particularly, outgas generated by elimination after exposure when used as a resist is a hydrocarbon, and the organic group R is preferably a hydrocarbon group in terms of a small effect on a semiconductor device. When the organic group R has a heteroatom, decomposability with EUV light may increase to improve the resist performance, such as sensitivity.

When organic group R is a hydrocarbon group, preferable specific examples of the hydrocarbon group include: primary alkyl groups such as a methyl group, an ethyl group, an n-propyl group, an n-butyl group, an n-pentyl group, and an n-hexyl group; secondary alkyl groups such as an isopropyl group, an isobutyl group, a sec-butyl group, and an isopentyl group; tertiary alkyl groups such as a t-butyl group, a t-amyl group, a cyclopentyl group, a cyclohexyl group, a methylcyclopentyl group, and a methylcyclohexyl group; aromatic hydrocarbon groups such as aryl groups such as a phenyl group, a tolyl group, a benzyl group, and a naphthyl group and aralkyl groups such as a phenethyl group, an α-methylbenzyl group, and a 2-phenyl-2-propyl group; alkenyl groups such as a vinyl group, a 1-propenyl group, an allyl group, and a 3-butenyl group; and alkyl groups substituted with a halogen atom such as a 2-fluoroethyl group and a 2-iodoethyl group. In terms of the effect of the present disclosure, these organic groups R are preferably used in combination of two or more thereof.

Examples of the structure further include the compounds shown in Fig. 8 and Fig. 9, where R^{a} and R^{b} represent an organic group having 1 to 10 carbon atoms. Examples of the organic group R include a halogenated hydrocarbon group, a hydrocarbon group having a heteroatom such as an oxygen atom and a nitrogen atom, and a hydrocarbon group. Particularly, outgas generated by elimination after exposure when used as a resist is a hydrocarbon, and organic group R is preferably a hydrocarbon group in terms of a small effect on a semiconductor device. The substituent A on the aromatic ring is a halogen atom or an organic group having 1 to 10 carbon atoms. Examples of such an organic group include a hydrocarbon group having a heteroatom such as a nitrogen atom, and a hydrocarbon group, and a hydrocarbon group is preferable.

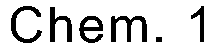

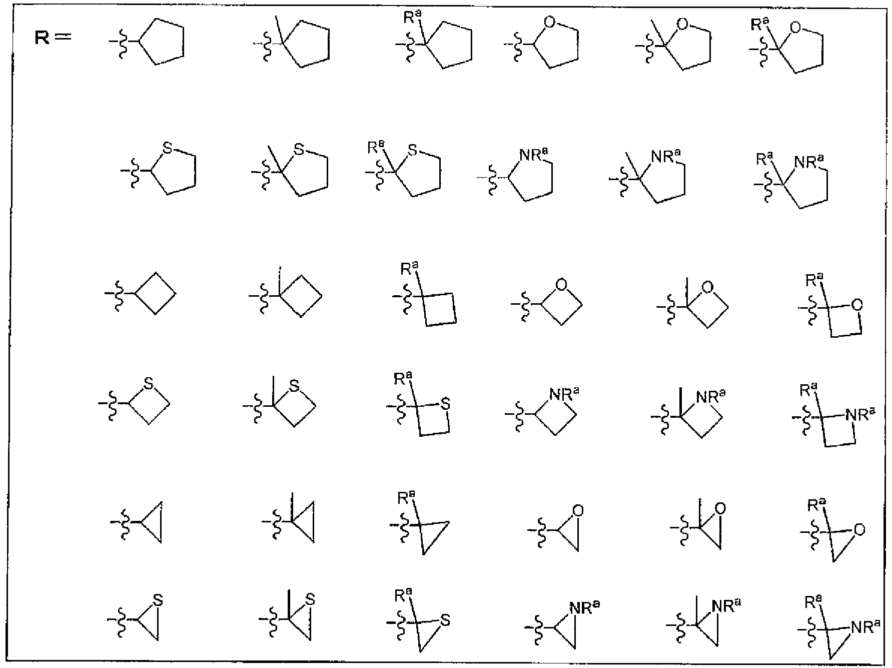

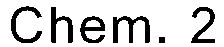

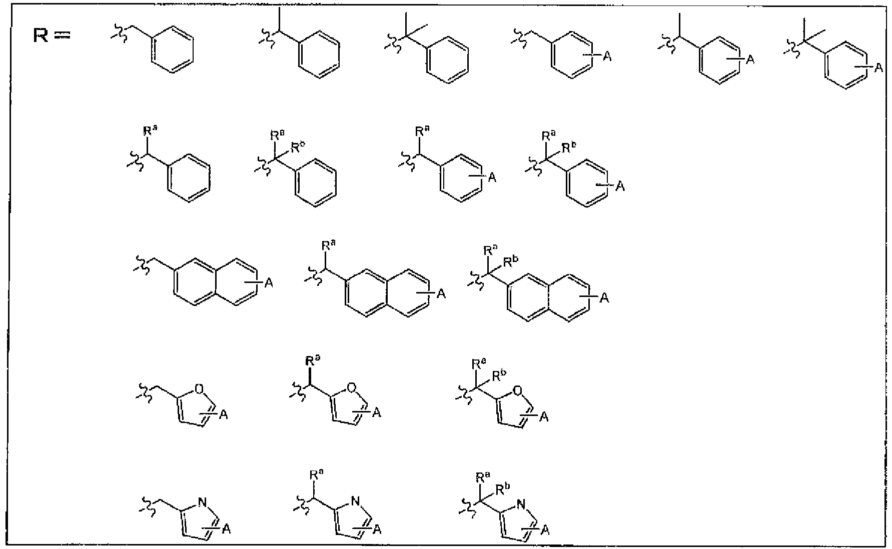

### (Preferable Hydrocarbon Group)

The hydrocarbon groups represented above are classified into primary hydrocarbon groups R¹, secondary hydrocarbon groups R², and tertiary hydrocarbon groups R³, or classified into saturated hydrocarbon groups such as cyclic hydrocarbon groups R^{c} and unsaturated hydrocarbon groups. These may exhibit different properties when used as a resist material. The hydrocarbon group is preferably a saturated hydrocarbon group from the viewpoint of sensitivity (light reactivity). In each classification, examples of a preferable substituent include primary hydrocarbon groups R¹, secondary hydrocarbon groups R², and tertiary hydrocarbon groups R³. From the viewpoint of sensitivity (light reactivity) when used for an EUV resist, secondary hydrocarbon groups R² and tertiary hydrocarbon groups R³, which are easily eliminated, are preferable, and tertiary hydrocarbon groups R³ are further preferable. Tertiary hydrocarbon groups R³ may mostly increase hydrophobicity near the tin atom from the viewpoint of hydrophobicity, and thus the tertiary hydrocarbon groups R³ are preferable from the viewpoint of controlling the solubility. If the hydrophobicity is excessively high, secondary hydrocarbon groups R² are preferable in some cases.

### (Mixing of Plurality of Types of Organic Group R)

The present tin compound has an organic group R, and this organic group R may have a plurality of types. For example, the present tin compound may have different two organic groups R^{A} and R^{B} as organic groups accounting for a major proportion in the organic group R (note that, by composition analysis of the organic group R by NMR, an organic group R in a largest proportion calculated by the following formula is R^{A}, an organic group in a second largest proportion is R^{B}, and an organic group other than the organic groups R^{A} and R^{B} may be contained). The structure of substituents R^{A} and R^{B} is selected within the range of R, and not particularly limited as long as the structures of R^{A} and R^{B} are different. As selection with the range of primary hydrocarbon group R¹, secondary hydrocarbon group R², and tertiary hydrocarbon group R³, the structures of R^{A} and R^{B} are preferably selected with each different range in order to optimize balance sensitivity and stability. As a particularly preferable combination, "R^{A}: primary hydrocarbon group / R^{B}: tertiary hydrocarbon group R³" or "R^{A}: secondary hydrocarbon group / R^{B}: tertiary hydrocarbon group R³" is preferable, and "R^{A}: secondary hydrocarbon group / R^{B}: tertiary hydrocarbon group R³" is particularly preferable to achieve balance between sensitivity and hydrophobicity. That is, a combination of "R^{A}: secondary hydrocarbon group / R^{B}: tertiary hydrocarbon group R³" is particularly preferable in terms of performance balance as a resist material. 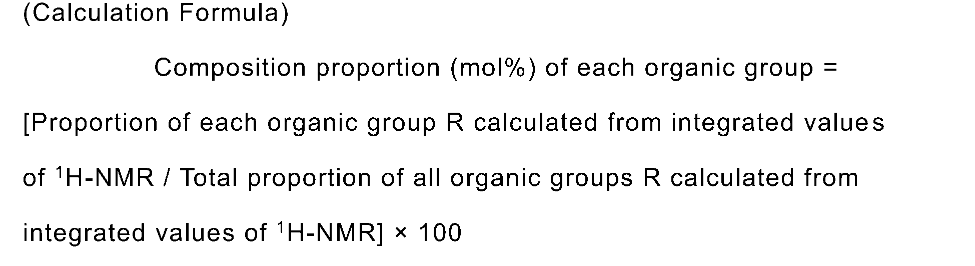 Composition proportion (mol%) of each organic group = [Proportion of each organic group R calculated from integrated values of 1H-NMR / Total proportion of all organic groups R calculated from integrated values of 1H-NMR] × 100

Note that the analysis method of each organic group R with NMR will be described in the section "Composition Analysis of The Tin Hydrolysate" described later.

### (Tin Compound in which Plurality of Types of Organic Group R are Mixed)

For example, as for the tin compound (P3) having a cation represented by (RSn)₁₂O₁₄(OH)₆⁺², when the organic group R contains only R^{A} and R^{B}, a tin compound (P3AB) having R^{A} and R^{B} in one molecule is represented as follows.

A tin compound having a cation represented by chemical formula (R^{A}Sn)ₓ(R^{B}Sn)_{y}O₁₄(OH)₆⁺² (P3AB)
wherein "x" represents an integer satisfying 0 < x < 12, "y" represents an integer satisfying 0 < y < 12, and "x" and "y" satisfy x+y=12.

The compounds represented hereby are specifically described as tin compounds having the following 11 types of cation: (R^{A}Sn)₁(R^{B}Sn)₁₁O₁₄(OH)₆⁺², (R^{A}Sn)₂(R^{B}Sn)₁₀O₁₄(OH)₆⁺², (R^{A}Sn)₃(R^{B}Sn)₉O₁₄(OH)₆⁺², (R^{A}Sn)₄(R^{B}Sn)₈O₁₄(OH)₆⁺², (R^{A}Sn)₅(R^{B}Sn)₇O₁₄(OH)₆⁺², (R^{A}Sn)₆(R^{B}Sn)₆O₁₄(OH)₆⁺², (R^{A}Sn)₇(R^{B}Sn)₅O₁₄(OH)₆⁺², (R^{A}SN)₈(R^{B}Sn)₄O₁₄(OH)₆⁺², (R^{A}Sn)₉(R^{B}Sn)₃O₁₄(OH)₆⁺², (R^{A}Sn)₁₀(R^{B}Sn)₂O₁₄(OH)₆⁺², and (R^{A}Sn)₁₁(R^{B}Sn)₁O₁₄(OH)₆⁺².

As tin compounds not having a plurality of types of the organic group R in one molecule, a tin compound (P3A) and a tin compound (P3B) described below are described as follows.

A tin compound having a cation represented by

(R^{A}Sn)₁₂O₁₄(OH)₆⁺² (P3A)

A tin compound having a cation represented by

(R^{B}Sn)₁₂O₁₄(OH)₆⁺² (P3B)

Furthermore, the tin compounds (P3A) and (P3B) do not contain a plurality of organic groups (R), so they are not included in the tin compound (P3) of this embodiment.

### (Method for Detecting Each Tin Compound in Tin Composition)

The structure and the number of types of the above-described tin compound (P3AB), tin compound (P3A), and tin compound (P3B) may be analyzed and detected by ESI-mass, and specific examples of the analysis will be described in the Examples described later. As for the types of the tin compound (P3) contained in the tin composition (M), a lower limit of the number as detected by ESI-mass is preferably not less than 3 types, further preferably not less than 5 types, and further preferably not less than 7 types. The upper limit is preferably not greater than 30 types, preferably not greater than 25 types, further preferably not greater than 20 types, further preferably not greater than 15 types, and further preferably not greater than 10 types.

The number of types of the tin compound (P3AB) in a large proportion contained in the tin composition (M) is more important for determining the resist physical properties. The lower limit of the number detected by ESI-mass is preferably not less than 2 types, further preferably not less than 5 types, and further preferably not less than 8 types as a preferable range of the number of types. The upper limit is preferably not greater than 10 types. When the number of types of the tin compound (P3AB) contained in the tin composition (M) is greater than the above lower limit, the crystallinity may be appropriately reduced, and when used as a resist solution, appropriate solubility may be imparted, and an insoluble crystal is not generated during patterning to reduce roughness in some cases. When the number is less than the above upper limit, the tin compound (P3) having different structures and molecular weights is reduced, and a more uniform pattern may be formed and roughness during patterning is reduced in some cases.

### (Content of Each Tin Compound in Tin Composition (M))

A content of each tin compound in the above-described tin compound (P3AB), tin compound (P3A), and tin compound (P3B) may be analyzed by quantifying a peak intensity of ESI-mass, and specific examples of the analysis will be described in the Examples described later. As the quantifying method, a peak intensity described in a spectrum of ESI-mass of tin compound (P3AB), tin compound (P3A), and tin compound (P3B) is quantified. The content (%) of each tin compound is calculated by the following formula. 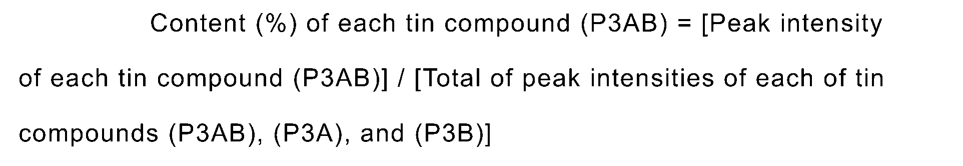 Content (%) of each tin compound (P3AB) = [Peak intensity of each tin compound (P3AB)] / [Total of peak intensities of each of tin compounds (P3AB), (P3A), and (P3B)]

Although the content of each tin compound (P3AB), (P3A), and (P3B) of which the peak is not detected is 0 (%) in this calculation formula, the contents of other tin compounds of which the peak is detected may be calculated.

A total value of the contents (%) of each of the tin compounds (P3AB) calculated by this calculation is preferably not less than 50%, further preferably not less than 60%, further preferably not less than 70%, and further preferably not less than 80%. The upper limit is 100%. The higher the value, the lower the amount of the proportions of the tin compound (P3A) and the tin compound (P3B) that have a single organic group, which is preferable because of reduction in an undissolved residue in the resist solvent, improvement of filterability, and prevention of crystallization to improve storage stability.

### (Content of Tin Compound (P3AB-1) with the Largest Content in Tin Composition (M))

A tin compound (P3AB) with the largest content in the tin composition (M) is defined as (R^{A}Sn)_{x'}(R^{B}Sn)_{y'} O₁₄(OH)₆⁺² (P3AB-1).

Note that x' represents an integer satisfying 0 < x' < 12, y' represents an integer satisfying 0 < y' < 12, and x' and y' satisfy x'+y' = 12.

An upper limit of a value of a content (%) of the tin compound (P3AB-1) calculated by the above formula is preferably not greater than 50%, more preferably not greater than 40%, further preferably not greater than 30%, and particularly preferably not greater than 20%. The lower limit is preferably not less than 5%, more preferably not less than 10%, and further preferably not less than 15%. When the content of the tin compound (P3AB-1) is within the above preferable range, the tin composition contains an appropriate amount of a compound to be major in the composition, and thereby balance between crystallinity and uniformity becomes high, and a resist material that may form an excellent pattern may be obtained. The content of the tin compound (P3AB-1) with the largest content is preferably larger than the content of the tin compound (P3A) having only a single organic group R^{A}. In this case, the proportion of the tin compound (P3A) having only a single organic group is small, which may improve storage stability because of reduction in an undissolved residue in the resist solvent, improvement of filterability, and prevention of crystallization.

### (Molecular Weight Distribution of Tin Compound (P3AB) in Tin Composition (M))

A distribution shape of a graph in which the content (%) of each of the tin compounds (P3AB), (P3A), and (P3B) in the tin composition (M) is plotted as the y-axis, and the content of the organic groups R^{A} in one molecule is plotted as the x-axis is preferably a single-peak distribution structure having a peak top (maximum point) of the tin compound (P3AB-1) with the largest content. When a plurality of peak tops are present, the distribution of the molecular weight is broadened and may cause roughness during patterning in some cases. When such a tin composition is dissolved in the resist solvent, distribution of the compounds having different solubilities is not wider, and thereby problems such as undissolved residue may occur.

From the peak molecular weight (Mi) and the content (%) (Ni) of each of the tin compounds (P3AB), (P3A), and (P3B), a number average molecular weight Mn, a weight average molecular weight Mw, and a molecular weight distribution Mw/Mn may be calculated. Specific calculation methods are described below based on calculation formulas of the molecular weight and the molecular weight distribution of the polymer.
·Number average molecular weight: Mn = Σ(Mi × Ni) / Σ(Ni)
·Weight average molecular weight: Mw = Σ(Mi² × Ni) / Σ(Mi × Ni)
·Molecular weight distribution: Mw/Mn

A lower limit of the value of the molecular weight distribution of the tin composition (M) calculated by these calculation formulas is preferably not less than 1.00001, more preferably not less than 1.00005, and further preferably not less than 1.0001. The upper limit is preferably not greater than 1.10, more preferably not greater than 1.05, further preferably not greater than 1.01, particularly preferably not greater than 1.005, and still particularly preferably not greater than 1.002. A molecular weight distribution of not greater than the above upper limit indicates uniform structure and molecular size of the tin compounds in the tin composition, and thereby an insoluble substance may be reduced in dissolution in the resist solvent and roughness during patterning may be reduced. A molecular weight distribution of not less than the above lower limit indicates a tin composition in which tin compounds having different molecular weights at a certain degree or more are mixed, and thereby crystallinity may be appropriately reduced to improve the solubility and storage stability of the resist solution.

### (Cyclic Hydrocarbon Group)

As for organic group R, containing a cyclic hydrocarbon group R^{c} improves reactivity during exposure due to strain of the cyclic skeleton, which may be preferable from the viewpoint of resist sensitivity. Examples of the cyclic skeleton contained in a preferable R^{c} include cyclopropyl, cyclobutyl, cyclopentyl, cyclohexyl, and cycloheptyl. Among these, a cyclic skeleton having an alkyl group such as a methyl group at the 1-position (carbon bonded to Sn) may be preferable because a tertiary hydrocarbon group is formed, and for example, 1-methyl-cyclopropyl, 1-methyl-cyclobutyl, 1-methylcyclopentyl, 1-methyl-cyclohexyl, 1-methyl-cycloheptyl, etc. are preferable. A proportion of the cyclic hydrocarbon group R^{c} in the organic group R is not particularly limited, and the upper limit is preferably not greater than 50 mol%, more preferably not greater than 40 mol%, further preferably not greater than 35 mol%, and particularly preferably not greater than 30 mol%. The lower limit is preferably not less than 1 mol%, more preferably not less than 5 mol%, further preferably not less than 10 mol%, and particularly preferably not less than 15 mol%.

### (Hydrocarbon Group having Unsaturated Bond)

As for organic group R, containing a hydrocarbon group R^{u} having an unsaturated bond allows the unsaturated bond to undergo a reaction or polymerization during exposure to change the structure, which may be preferable from the viewpoint of resist sensitivity. Examples of a skeleton having an unsaturated bond contained in a hydrocarbon group R^{u} having an unsaturated bond include alkene, alkyne, diene, triene, and benzene; alkene is preferable from the viewpoints of reactivity and stability, and terminal alkene is specifically preferable from the viewpoint of reactivity. Specific preferable examples thereof include a vinyl group, a 1-propenyl group, an allyl group, a 3-butenyl group, and a 4-pentenyl group. From the viewpoint of resist sensitivity, a vinyl group, a 1-propenyl group, and an allyl group in which the alkene is close to the Sn atom are preferable. From the viewpoint of stability, it is preferable that the unsaturated bond be distanced from the Sn atom by not less than two carbon atoms. In terms of the balance thereof, an allyl group, a 3-butenyl group, etc. are preferable. A proportion of the cyclic hydrocarbon group R^{c} in the organic group R is not particularly limited, and the upper limit is preferably not greater than 50 mol%, more preferably not greater than 40 mol%, further preferably not greater than 35 mol%, and particularly preferably not greater than 30 mol%. The lower limit is preferably not less than 1 mol%, more preferably not less than 5 mol%, further preferably not less than 10 mol%, and particularly preferably not less than 15 mol%.

### (Preferable Composition Proportions of R^{A} and R^{B})

As for preferable proportions of R^{A} and R^{B}, when a largest number of organic groups R is "R^{A}" and a second largest number of hydrocarbon atom is "R^{B}", a content of R^{A} is preferably not less than 50 mol%, more preferably not less than 60 mol%, and further preferably not less than 70 mol% of substituents constituting organic groups R. The upper limit is preferably not greater than 99 mol%, more preferably not greater than 95 mol%, and further preferably not greater than 90 mol%. When the organic group R^{A} accounting for a major proportion in organic groups R is within the above range, crystal formation during hydrolysis is appropriately regulated, which may yield a tin compound having appropriate crystallinity, without impairing performance of R^{A} as the resist material. A preferable content of R^{B} is preferably not greater than 50 mol%, more preferably not greater than 40 mol%, further preferably not greater than 35 mol%, and particularly preferably not greater than 30 mol%. The lower limit is preferably not less than 1 mol%, more preferably not less than 5 mol%, further preferably not less than 10 mol%, and particularly preferably not less than 15 mol%. The composition of R^{B} within the above range may impart properties of R^{B} without impairing performance of R^{A}, and may yield the tin compound having appropriate crystallinity.

R^{A} is preferably a secondary hydrocarbon group R², and specifically preferably an isopropyl group.

R^{B} is preferably any one of a tertiary hydrocarbon group R³, a cyclic hydrocarbon group R^{c}, and a hydrocarbon group R^{u} having an unsaturated bond, and preferably a t-butyl group among the tertiary hydrocarbon group R³. Among the cyclic hydrocarbon group R^{c}, a methylcyclopentyl group is preferable. Among the hydrocarbon group R^{u} having an unsaturated bond, a butenyl group is preferable.

In the combination of R^{A} and R^{B}, an upper limit of the difference between the number of carbon atoms in R^{A} and R^{B} is preferably not greater than 10, more preferably not greater than 5, and further preferably not greater than 3. The lower limit is preferably not less than 0, and more preferably not less than 1. When the difference between the number of carbon atoms in R^{A} and R^{B} is not greater than the above upper limit, the differences in the molecular weight and hydrophobicity of the organic groups R^{A} and R^{B} are sufficiently close, and thus the molecular weight distribution of the tin compound may be narrowed or solubility in the resist solvent may be uniformized, which may reduce roughness during patterning. Meanwhile, when the difference in the molecular weights is not less than the above lower limit, crystallinity may be appropriately reduced to improve solubility in the resist solvent or improve storage stability.

### Composition Analysis of The Present Tin Hydrolysate

As for the present tin hydrolysate, a composition of the contained substituent may be analyzed with analysis devices such as NMR (¹H-NMR, ¹³C-NMR, ¹¹⁹Sn-NMR, and correlation NMR thereof) and mass analysis (mass spectrometry). With NMR, the composition of the entire sample (composition of the tin composition) may be analyzed. For example, information on the ligand (organic group R etc.) of the tin atom, the number of coordinations per tin atom, etc. may be analyzed. In addition, the structure of organic group R may be identified, and an average composition of the tin composition of organic group R in the sample may be quantified.

A ratio (k1/k2) in ¹¹⁹Sn-NMR of the present tin hydrolysate a ratio of a total value (k1) of peak integration values of a five-coordinate Sn (-250 to -350 ppm) and a total value (k2) of peak integration values of a six-coordinate Sn (-450 to -600 ppm), is preferably 0.5 to 2.5, more preferably 1.0 to 2.4, further preferably 1.2 to 2.3, and particularly preferably 1.3 to 2.2. In the present tin hydrolysate, the five-coordinate Sn tends to have an OH group, and the six-coordinate Sn tends to have only an Sn-O-Sn bond and no OH bond due to a larger number of coordinating portions. That is, it may be said that a higher value of k1/k2 indicates a larger amount of OH groups, and a lower value indicates a smaller amount of OH groups. The number of OH groups change the polarity of the tin compound, which relates to solubility in the resist solvent, and parameters of hydrophobicity and hydrophilicity of the tin compound, which relate to the resist performance. From the viewpoint of controlling the performance balance, k1/k2 is preferably controlled within the above range.

From a molecular weight of an ion observed in mass spectrometry, ( "MS"), the molecular weight of the each tin compound contained in the tin composition and its molecular formula can be determined. Specifically, electron-spray ionization method (ESI-mass) is preferable from the viewpoint of sensitivity and detection capability of an unstable compound by the soft ionization. That is, the average composition of the entire sample (tin composition) is observed by NMR, and in contrast, the composition of the organic group R observed by mass analysis represents the composition of organic group R contained in one molecule (composition in each of the tin compounds). In addition, the structure of the tin compound with the largest content in the tin composition and the composition of the organic group R of this tin compound may be identified and the content of each tin compound may be quantified by quantifying the intensity of each peak. Although the tin compounds provide a mass spectrum having a plurality of peaks because the tin atom, oxygen atom, carbon atom, hydrogen atom, etc. present in the tin compound have isotopes, only the strongest intensity peak in the theoretical mass spectrum pattern of the tin compounds is subjected to the analysis as the peak of each of the tin compounds to quantify the peak intensity. Examples of these analysis will be exemplified in the section of the Examples.

### (Purity of Tin Composition)

A calculation method of purity of the tin composition by NMR will be described below. Here, "mol%" representing the purity in terms of tin atom refers to a proportion of the number of tin atoms of the target compound among the number of tin atoms of all compounds having a tin atom (including an unidentified compound). Practically, the proportion is calculated by ¹¹⁹Sn-NMR with a total of integration values of all observed peaks as the denominator and an integration value of a peak of the target compound as the numerator. Note that the measurement range of ¹¹⁹Sn-NMR is a range of 1000 to -1000 ppm, which is a range that sufficiently measures the compound of this analysis target. For example, representing the purity of a tin composition containing five-coordinate Sn and six-coordinate Sn is a value of (k1+k2)/(k3) when a total value of the total integration value (k1) of peaks of five-coordinate Sn (-250 to -350 ppm) in ¹¹⁹Sn-NMR and a total integration value (k2) of peaks of six-coordinate Sn (-450 to -600 ppm) is (k1+k2), and a total value of all integration values of other peaks detected from the ¹¹⁹Sn-NMR (within the range of 1000 to -1000 ppm, including k1 and k2) is (k3). A larger number of this ratio is preferable because of a low concentration of impurities other than the five-coordinate Sn and the six-coordinate Sn in the present tin hydrolysate. A lower limit thereof is preferably not less than 0.7, more preferably not less than 0.8, further preferably not less than 0.9, particularly preferably not less than 0.95, and most preferably not less than 0.99. From the viewpoint of measurement sensitivity of this method, a case in which the corresponding peak other than k1 and k2 may not be detected may be regarded as not less than 0.99. The upper limit is 1.

According to this calculation method, only a compound having a tin atom is the calculation target. For example, a case where the present tin hydrolysate is produced and then an additive or a solvent is added according to each use is within the scope of the present tin hydrolysate even when the present tin hydrolysate and a tin compound, which is another impurity, are contained as long as the present tin hydrolysate is contained.

For the analysis method of ¹¹⁹Sn-NMR, the present tin hydrolysate is dissolved at a high concentration (using a solvent to dissolve the present tin hydrolysate at a high concentration) in order to improve sensitivity, and the results are obtained by using a large number of scans (not less than 1000 times, preferably not less than 10000 times) for analysis, a sufficient relaxation time (not less than 1 second), reverse-gate decoupling, and an appropriate measurement range (1000 to -1000 ppm). As a result, the detection limit for tin compounds (A2), (A3), and (A4) contained in a trace amount may reach 0.01 mol% by using these methods. In addition, even when the sensitivity of the measured peak is insufficient, use of a highly sensitive NMR (for example, use of 600-MHz NMR with a cryoproble) may further improve the detection sensitivity to 0.001 mol%.

Examples of the tin compounds that may be contained in the present tin hydrolysate include, other than the monoalkyltin compound (A1), the following tin compounds (A2), (A3), and (A4).

·R₂SnX₂ (A2)

·SnX₄ (A3)

·RSn(NR')₂(N(R')CHNR'₂) (A4)

### Crystallinity of The Present Tin Hydrolysate

The present tin hydrolysate is preferably a solid, particularly when used for forming a thin film as a resist material which has resistance against semiconductor processes (exposure, development, and etching) etc. Specifically, regulating properties of the solid, namely granular shape, shape, crystallinity, and surface state, within specific ranges may be preferable when the tin hydrolysate is to be used as a resist material. The crystallinity is particularly important in terms of controlling solubility (which contributes to development performance, coating performance, ease of filtering process, and storage stability of a resist solution) and the surface state of the solid (which contributes to hydrophobicity and hydrophilicity, substrate adhesiveness, etc.) while retaining the properties derived from the chemical formula. In addition, the crystallinity also affects adhesiveness when applied on a substrate, roughness and tendency of pattern collapse after exposure, solubility during development, etc., and thereby the crystallinity needs to be appropriately regulated within a required range for desirable resist performance. Specifically, excessively high crystallinity causes difficulty in dissolution in the resist solvent, and causes problems in processes such as dissolution, filtration, and storage. In coating and drying, excessively high crystallinity may cause pattern cracking or collapse at an interface between the crystals or the surface of the crystal. In exposure or development, high crystallinity to increase crystal size may increase roughness of the pattern after development. Meanwhile, excessively low crystallinity causes poor adhesiveness to a substrate and low strength of a resist film, and thereby excessively low crystallinity may cause peeling of a resist film during coating, drying, exposure, development, etc., collapse of the pattern, and increase in roughness on the pattern after development, etc. As above, there is an appropriate range of crystallinity for a resist material having excellent solubility, adhesiveness, and roughness, and thereby the crystallinity needs to be regulated within a specific crystallinity range by appropriately regulating the ratio between the crystal component and an amorphous component.

As an analysis method of the crystallinity, analysis by X-ray diffraction measurement (XRD) may be performed, and may be applied for the cases of powder, formed article, thin film, patterned thin film after exposure, etc. of the present tin hydrolysate. Among values obtained from XRD, the value of a diffraction angle 2θ (°) at the strongest intensity peak, the value of a half-value width (°) of the strongest intensity peak, and the number of detected peak tops may be used as values indicating the crystallinity of the tin compound. The analysis precision described in the present Examples is effective up to a value with two decimal places, and in a comparison between the diffraction angle 20 (°) and the half-value width (°), a value of not less than 0.01 (°) can be regarded to be significant. A specific measurement method will be described in the Examples.

The diffraction angle 20 (°) at the strongest intensity peak of the present tin hydrolysate is preferably 5.00 to 15.00°, and the upper limit is more preferably not greater than 13.00°, further preferably not greater than 11.00°, particularly preferably not greater than 10.00°, and especially preferably not greater than 9.00°. The lower limit is more preferably not less than 5.50°, more preferably not less than 5.80°, and particularly preferably not less than 6.00°. The diffraction angle 20 (°) at the strongest intensity peak correlates to a lattice spacing of the crystal. In the present tin compound having a diffraction angle 20 (°) within the above preferable range, the crystals are arranged with an appropriate lattice spacing, and the crystals have appropriate crystallinity and strength in patterning to achieve both inhibition of pattern collapse and reduction in roughness in fine patterning.

A range of the half-value width (°) of the strongest intensity peak is preferably 1.00 to 4.00°, and the upper limit is more preferably not greater than 3.50°, particularly preferably not greater than 3.00°, especially preferably not greater than 2.50°, and especially further preferably not greater than 2.00°. The lower limit is more preferably not less than 1.05°, further preferably not less than 1.10°, particularly preferably not less than 1.20°, particularly preferably not less than 1.43°, and especially preferably not less than 1.50°. The half-value width (°) of the strongest intensity peak strongly correlates specifically to the crystallinity of the tin compound. The half-value width (°) within the above preferable range may regulate parameters such as solubility (which contributes to development performance, coating performance, ease of filtering process, and storage stability of a resist solution) and the surface state of the solid (which contributes to hydrophobicity and hydrophilicity, substrate adhesiveness, etc.), which are required as the aforementioned resist material, within appropriate ranges.

In the diffraction angle 2θ (°), the number of peak tops detected within a range of 5.00 to 15.00° is preferably not greater than five, more preferably not greater than three, further preferably not greater than two, and particularly preferably not greater than one. The lower limit is more preferably not less than 1.05°, further preferably not less than 1.10°, particularly preferably not less than 1.20°, particularly preferably not less than 1.43°, and especially preferably not less than 1.50°. The half-value width (°) of the strongest intensity peak strongly correlates specifically to the crystallinity of the tin compound. The half-value width (°) within the above preferable range can regulate parameters such as solubility (which contributes to development performance, coating performance, ease of filtering process, and storage stability of a resist solution) and the surface state of the solid (which contributes to hydrophobicity and hydrophilicity, substrate adhesiveness, etc.), which are required as the aforementioned resist material, within appropriate ranges.

### Solubility of The Present Tin Hydrolysate

When used as a resist material, the present tin hydrolysate is dissolved in a resist solvent to form a resist solution in some cases. The solubility of the present tin hydrolysate refers to solubility for dissolution in an organic solvent used for preparing a resist solution. In a resist solution after dissolution, it is preferable that the present tin hydrolysate be completely dissolved without an insoluble material or cloudiness derived from the present tin hydrolysate. The insoluble material derived from the present tin hydrolysate causes performance deterioration and troubles when used as a resist material. Specific examples thereof include a defect formed in patterning which deteriorates performance as a resist material (leading to line width roughness (LWR), pattern collapse, and sensitivity deterioration), device contamination due to occurrence of an impurity and a foreign matter in etching, and clogging and productivity deterioration in the filtering process.

### (Resist Solvent)

The present tin hydrolysate is dissolved in a resist solvent, and examples of the resist solvent include organic solvents, for example, alcohols, esters, and a combination thereof. Specifically, examples of appropriate solvents include a mixture of aromatic compounds (for example, xylene and toluene), ethers (anisole and tetrahydrofuran), halogen solvents (dichloromethane and chloroform), esters (propylene glycol monomethyl ether acetate, ethyl acetate, and ethyl lactate), alcohols (for example, 4-methyl-2-pentanol, 4-methyl-2-propanol, 1-butanol, methanol, isopropyl alcohol, and 1-propanol), and ketones (for example, methyl ethyl ketone, cyclohexanone, and 2-heptanone). These may be used singly or in combination of two or more thereof. Among these, alcohol solvents are preferable for dissolving a tin hydrolysate having an OH group, and 4-methyl-2-pentanol is more preferable. From the viewpoints of toxicity, legal regulation, and volatility, 2-heptanone, 4-methyl-2-pentanol, and ethyl lactate are preferable solvents in a practical production process.

These resist solvents may be selected based on physical properties of the solvent itself such as a solubility parameter, degree of volatility, flammability, toxicity, and viscosity. Meanwhile, a resist solvent may be evaluated for stability (dissolution stability) in a state when the tin hydrolysate or other materials are dissolved in the resist solvent. That is, after dissolving and mixing the components of a resist solution, particularly from preparing the solution to forming a film, properties of the dissolved tin hydrolysate may change due to partial interactions (reaction, condensation, solvation, coordination, etc.) between the tin hydrolysate and the solvent. The solution stability due to these interactions is evaluated as storage stability of the resist solution, described later. From the viewpoint of storage stability and from the viewpoint of stabilization with coordination with the OH group, alcohol solvents are preferable.

### (Method for Evaluating Solubility)

The solubility of the present tin hydrolysate is evaluated by comparing turbidity (transparency) when the tin hydrolysate is dissolved in 4-methyl-2-pentanol at a certain concentration. The specific method, which is disclosed in JP-A-2019-500490, is as follows: preparing a mixed liquid of the tin hydrolysate in 4-methyl-2-pentanol equivalent to 2.0 mass%, and visually observing turbidity (transparency) of this liquid by comparison with a standard turbidity liquid to evaluate the solubility of the corresponding present tin hydrolysate. As the standard turbidity liquid, a kaoline-turbidity standard liquid described in JIS K0110 (0 degrees (transparent), 50 degrees, 100 degrees, 500 degrees, or 1000 degrees (white turbid)) is used, and a turbidity close to each of the standard turbidity liquids is evaluated as turbidity evaluation 1 to 5 as follows.
·Turbidity evaluation 1: 0 degrees (transparent)
·Turbidity evaluation 2: 50 degrees
·Turbidity evaluation 3: 100 degrees
·Turbidity evaluation 4: 500 degrees
·Turbidity evaluation 5: 1000 degrees (white turbid)

### Storage Stability of Resist Solution

A resist solution produced by dissolving the present tin hydrolysate is required to be stable without stirring while no precipitation or sedimentation of solid occurs in a term of at least one week, preferably not less than two weeks, more preferably not less than one month, further preferably not less than three months, and particularly preferably not less than six months. As a specific method for evaluating the storage stability, the above solution sample is stored at 20°C, and turbidity is similarly evaluated after one week, two weeks, and one month after dissolution. As a stably storable resist solution, change in turbidity in this evaluation is preferably absent.

### <<Raw Material of The Present Tin Hydrolysate>>

For producing the present tin hydrolysate as noted above, monoalkyltin compounds (A1) and (B1) described below are preferably used as a raw material (which may be referred to as "precursor"), but not particularly limited thereto. Hereinafter, the monoalkyltin compounds (A1) and (B1) usable as the precursor will be described.

### <Monoalkyltin Compound (A1)>

The monoalkyltin compound (A1) is defined as follows. The monoalkyltin compound (A1) is a compound in which one organic group and three hydrolysable groups X that can undergo a reaction such as hydrolysis are bonded to tetravalent tin. Specifically, the monoalkyltin compound (A1) is represented by the following general formula (A1).

RSnX₃ (A1)

In the general formula (A1), R represents an organic group having 1 to 30 carbon atoms. X is selected from OR', NR'₂, and C=CR'. R' represents an organic group having 1 to 10 carbon atoms. Examples of the organic group R' include a halogenated hydrocarbon group, a hydrocarbon group having a heteroatom such as an oxygen atom and a nitrogen atom, and a hydrocarbon group. Particularly, outgas generated by elimination after exposure when used as the resist is a hydrocarbon, and the organic group R' is preferably a hydrocarbon group in terms of a small effect on a semiconductor device. When a plurality of R' is present in the molecule, the plurality of R' may have a structure different from each other and may be bonded to each other to form a cyclic structure.

### Organic Group R

The organic group R has 1 to 30 carbon atoms. Examples of the organic group R include a halogenated hydrocarbon group, a hydrocarbon group having a heteroatom such as an oxygen atom and a nitrogen atom, and a hydrocarbon group. Particularly, outgas generated by elimination after exposure when used as a resist is a hydrocarbon, and the organic group R is preferably a hydrocarbon group in terms of a small effect on a semiconductor device. The organic group R having a heteroatom has higher decomposability with EUV light, which may improve the resist performance such as sensitivity.

The number of carbon atoms in the organic group R is not greater than 30 as the upper limit when considering ease of elimination of the R group during EUV exposure and volatilization of a generated R-group component. The number is preferably not greater than 20, and more preferably not greater than 10. From the viewpoint of stability of the eliminating component, the lower limit is not less than 1, preferably not less than 2, and more preferably not less than 3.

Outgas generated from elimination after exposure when used as a resist is a hydrocarbon, and the organic group R is preferably a hydrocarbon group in terms of a small effect on a semiconductor device. Specific examples of the preferable hydrocarbon group include: alkyl groups such as a methyl group, an ethyl group, a propyl group, an isopropyl group, a butyl group, an isobutyl group, a sec-butyl group, a t-butyl group, a pentyl group, a hexyl group, a cyclopentyl group, and a cyclohexyl group; aromatic hydrocarbon groups such as aryl groups such as a phenyl group, a tolyl group, a benzyl group, and a naphthyl group and aralkyl groups such as a phenethyl group, an α-methylbenzyl group, and a 2-phenyl-2-propyl group; alkenyl groups such as a vinyl group, a 1-propenyl group, an allyl group, and a 3-butenyl group; and alkyl groups substituted with a halogen atom such as a 2-fluoroethyl group and a 2-iodoethyl group. These may be used in combination of two or more thereof.

Examples of the structure further include the compounds shown in Fig. 10 and Fig. 11. In the figures, R^{a} and R^{b} represent an organic group having 1 to 10 carbon atoms. Examples of such an organic group include a halogenated hydrocarbon group, a hydrocarbon group having a heteroatom such as an oxygen atom and a nitrogen atom, and a hydrocarbon group. The substituent A on the aromatic ring is a halogen atom or an organic group having 1 to 10 carbon atoms. Examples of such an organic group include a hydrocarbon group having a heteroatom such as an oxygen atom and a nitrogen atom, and a hydrocarbon group.

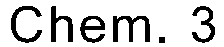

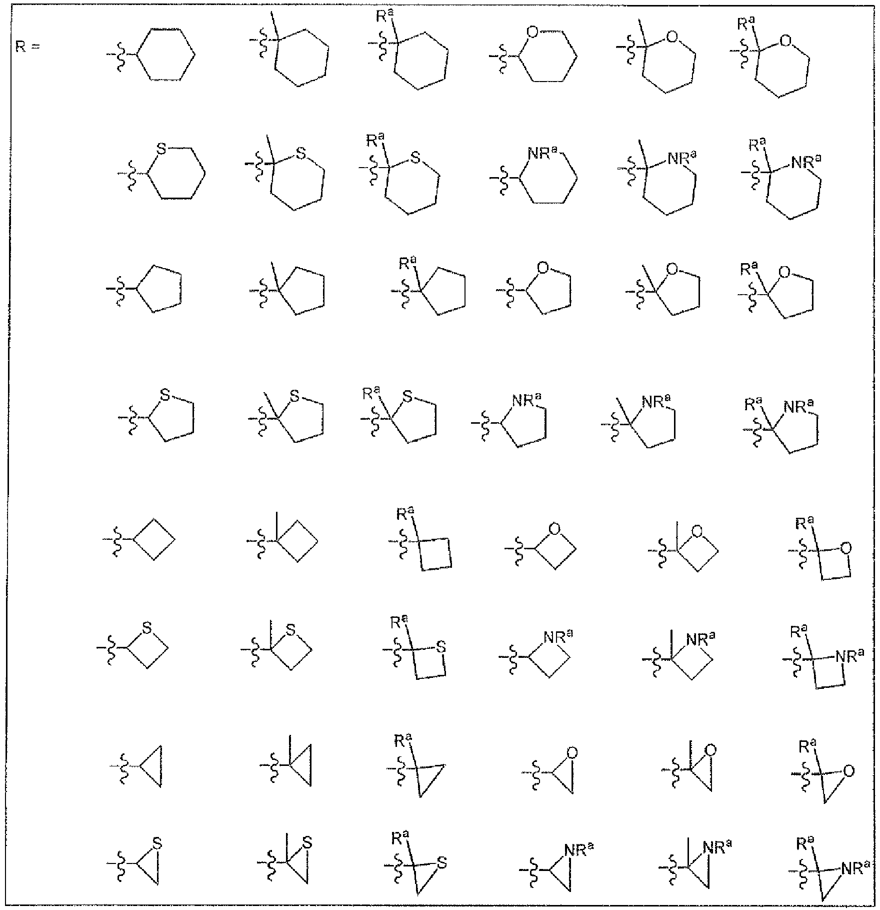

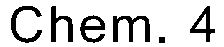

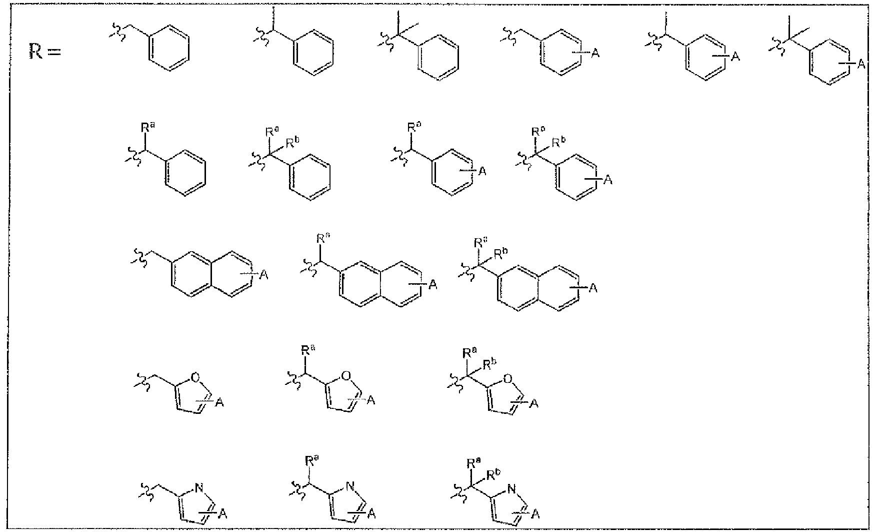

The hydrocarbon groups represented above are classified into primary hydrocarbon groups R¹, secondary hydrocarbon groups R², and tertiary hydrocarbon groups R³, and are typically alkyl groups or aralkyl groups. Preferable examples of each classification include: primary hydrocarbon groups R¹: a methyl group, an ethyl group, an n-propyl group, an n-butyl group, an isobutyl group, a benzyl group, and a phenethyl group; secondary hydrocarbon groups R²: an isopropyl group, a sec-butyl group, a cyclopentyl group, a cyclohexyl group, a cycloheptyl group, and an α-methylbenzyl group; and tertiary hydrocarbon groups R³: a t-butyl group, a t-amyl group, a 1-methylcyclopentyl group, a 1-methyl-cyclohexyl group, and a 2-phenyl-2-propyl group. Each of the groups may exhibit a different property when used as a resist material. Hereinafter, the description will be made with the hydrocarbon groups as a representative example. From the viewpoint of sensitivity (light sensitivity) when using each as preferable EUV resists, secondary hydrocarbon groups R² and tertiary hydrocarbon groups R³, which are easily eliminated, are preferable. Although tertiary hydrocarbon groups R³ are preferable from the viewpoint of hydrophobicity and the viewpoint of controlling solubility due to the ability to mostly increase hydrophobicity near the tin atom, secondary hydrocarbon groups R² may be preferable if the hydrophobicity is excessively high. From the viewpoint of thermal stability that causes influence in distillation etc., primary hydrocarbon groups hardly cause disproportionation and may be easily purified. Meanwhile, secondary and tertiary hydrocarbon groups easily cause a disproportionation reaction, and secondary and tertiary hydrocarbon groups having a low number of carbon atoms (not greater than 6 carbon atoms) are unstable in distillation, and it is often difficult to perform distillation having high purification efficiency due to pyrolysis etc. Thus, it is more important to obtain a highly pure tin compound with a low content of byproducts having close boiling points in the reaction stage, which is prior to purification, such as distillation.

### Substituent X

The substituent X may have any structure as long as it is a hydrolysable group that can be subjected to a reaction such as hydrolysis. Specific examples thereof preferably include OR', NR'₂, and C=CR' in terms of high reactivity, and OR' and NR'₂ are more preferable from the viewpoint of the reactivity of hydrolysis. R' represents an organic group having 1 to 10 carbon atoms, and examples of the organic group include a halogenated hydrocarbon group, a hydrocarbon group having a heteroatom such as an oxygen atom and a nitrogen atom, and a hydrocarbon group. When a plurality of R' is present in the molecule, the plurality of R' may have different structures from each other, and may be bonded to each other to form a cyclic structure. Among these, OR' preferably represents an alkoxy group and NR'₂ preferably represents an alkylamino group in terms of balance between high reactivity of the hydrolysis and stability in synthesis.

Specific examples of the organic group R' include a methyl group, an ethyl group, a propyl group, an isopropyl group, a butyl group, an isobutyl group, a sec-butyl group, a t-butyl group, a t-amyl group, a 2-methyl-pentyl group, a trifluoroethyl group, and a trifluoromethyl group. Examples of NR'₂ include a 1-pyrrolidinyl group in which two substituents on nitrogen are bonded to form a five-membered ring.

The substituent X is preferably an alkyl group having no heteroatom or an alkyl group having fluorine from the viewpoints of low boiling point and stability as the organic group R'. The number of carbon atoms is preferably low from the viewpoint of low boiling point, and the number of carbon atoms is preferably high from the viewpoint of thermal stability and stability against moisture. Specific examples of the substituent X with an excellent balance of these properties include: OR': a t-butoxy group, a t-amyloxy group, a 4-methyl-2-pentaloxy group, a trifluoroethoxy group, and a trifluoromethoxy group; and NR'₂: a dimethylamino group, a diethylamino group, a methylethylamino group, and a pyrrolidyl group. Among these, OR' is preferable from the viewpoint of reactivity of the hydrolysis when used as a resist material, and specifically, a diethylamino group and a diethylamino group are most preferable. NR'₂ is preferable in terms of balance between stability and reactivity, and specifically a t-butoxy group, a t-amyloxy group, and a 4-methyl-2-pentaloxy group are most preferable.

R and the organic group contained in the substituent X in the molecule may be bonded to each other to form a cyclic structure. Examples of the cyclic structure in this case include compounds having a structure represented as follows.

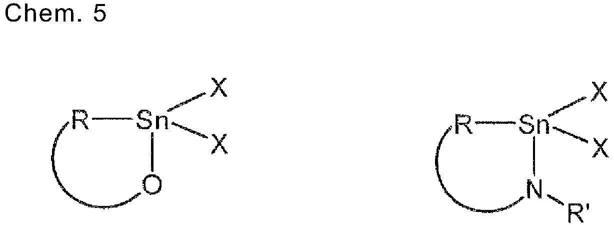

### Structure of Monoalkyltin Compound (A1)

The monoalkyltin compound (A1) (hereinafter, which may be referred to as "tin compound (A1)" may have any structure and physical properties within the above range. When used as an EUV resist material, the tin compound (A1) may preferably have the following physical properties.

### (Boiling Point)

The boiling point of the tin compound (A1) is preferably not higher than 300°C, more preferably not higher than 250°C, further preferably not higher than 200°C, and particularly preferably not higher than 150°C at 1 torr. A lower limit of the boiling point at 1 torr is typically not lower than 0°C, preferably not lower than 10°C, and more preferably not lower than 20°C. The low boiling point enables distillation at low temperature, and is preferable from the viewpoint of ease of vapor deposition when used as a resist material. The boiling point of not less than the lower limit tends to facilitate processes with vapor deposition and a reaction at high temperature when used as an EUV resist and tends to inhibit volatilization or scattering of components and outgas due to excellent thermal stability of the film to be formed.

### (Molecular Weight)

The molecular weight of the tin compound (A1) is preferably not greater than 500, more preferably not greater than 400, and further preferably not greater than 350. The lower limit is preferably not less than 150, more preferably not less than 180, and further preferably not less than 200. An excessively high molecular weight causes an excessively high boiling point, and it may be difficult to perform vapor deposition etc. when using it as an EUV resist. An excessively low molecular weight causes an excessively low boiling point, and it may be difficult to perform the process with vapor deposition and reaction at high temperature, and volatilization or scattering of components and outgas may be problematic due to insufficient thermal stability of the film to be formed.

### (Difference in Molecular Weight of Organic Group R and Substituent X)

A difference between the molecular weights of the organic group R and the substituent X is not particularly limited, and is preferably not greater than 50, more preferably not greater than 30, further preferably not greater than 20, particularly preferably not greater than 10, and especially preferably not greater than 6. The lower limit is 0. Reducing the difference between the molecular weights of R and X reduces the difference in mass of outgases generated when using as a resist, which tends to facilitate condition setting in the EUV process. To regulate EUV sensitivity and the boiling point of the tin compound, the substituent may be changed to regulate the differences between the molecular weights.

Meanwhile, as described later, a smaller difference between the molecular weights of R and X reduces the difference between the molecular weights of the tin compound (A1) and the impurity, which may cause more difficulty in purification.

### <Tin Compound (B1)>

The tin compound (B1), RSnX₂Y, is defined as follows. The tin compound (B1) is a compound in which one organic group R, two hydrolysable groups X that can undergo a reaction such as hydrolysis, and one hydrolysable group Y are bonded to tetravalent tin. Specifically, the tin compound is represented by the following general formula (B1).

RSnX₂Y (B1)

In the general formula (B1), R represents an organic group having 1 to 30 carbon atoms. Examples of the organic group include a halogenated hydrocarbon group, a hydrocarbon group having a heteroatom such as an oxygen atom and a nitrogen atom, and a hydrocarbon group, and these may be used in combination of two or more thereof. The X is same as above. The X and the Y represent a hydrolysable group having a chemical formula different from each other, and selected from OR'^{B}, NR'^{B}₂, and C≡CR'^{B}. The R'^{B} represents an organic group having 1 to 10 carbon atoms, and examples of the organic group include a halogenated hydrocarbon group, a hydrocarbon group having a heteroatom such as an oxygen atom and a nitrogen atom, and a hydrocarbon group. When the X and/or the Y is the NR'^{B}₂, the R^{'B} may be independently same as or different from each other. When a plurality of R'^{B} is present in the molecule, the structure may be different from each other, and may be bonded to each other to form a cyclic structure.

The tin compound (B1) is formed with two hydrolysable groups that can undergo a reaction such as hydrolysis and one hydrolysable group Y, and thereby the tin compound (B1) can undergo hydrolysis at an inequivalent rate.

As a preferable structure of RSnX₂Y (B1), X is preferably NR₂ and Y is preferably the NR'^{B}₂ structure from the viewpoint of reactivity of the hydrolysis, and Y is particularly preferably N(R'^{B})CHNR'^{B}₂ in terms of regulation of the difference between X and Y in hydrolysis.

### Tin Hydrolysate Containing Tin Compounds (A1) and (B1)

Although each of RSnX₃ and RSnX₂Y can singly form the tin hydrolysate via hydrolysis, a mixture containing (A1) and (B1) is preferably used, particularly in order to control the crystallinity without decreasing the purity of the resulting tin hydrolysate. That is, it is an important point that the tin compound (A1) and the tin compound (B1) have the same organic group R and that the organic group R remaining in the tin hydrolysate after hydrolysis is basically equivalent, which differs from impurities contained in a monoalkyltin compound having a structure different from (B1).

In a specific composition of a mixture (A1B1) containing tin compounds (A1) and (B1), a lower limit of the purity of the tin compound (A1) is preferably not less than 10 mol%, more preferably not less than 20 mol%, further preferably not less than 30 mol%, particularly preferably not less than 50 mol%, and still particularly preferably not less than 70 mol%. The upper limit is preferably not greater than 99 mol%, more preferably not greater than 97 mol%, further preferably not greater than 95 mol%, and particularly preferably not greater than 90 mol%. A lower limit of the purity of (B1) is preferably not less than 10 mol%, more preferably not less than 20 mol%, further preferably not less than 30 mol%, particularly preferably not less than 50 mol%, and still particularly preferably not less than 70 mol%. The upper limit is preferably not greater than 99 mol%, more preferably not greater than 97 mol%, further preferably not greater than 95 mol%, and particularly preferably not greater than 90 mol%. The total value of the tin compounds (A1) and (B1) in the composition of the mixture (A1B1) is preferably not less than 80 mol%, more preferably not less than 85 mol%, and further preferably not less than 90 mol%. A sufficiently high total value of tin compounds (A1) and (B1) yields a highly pure tin hydrolysate. When the total value of the tin compounds (A1) and (B1) is not less than 80 mol%, a lower limit of the content of RSnX₂Y is preferably not less than 0.01 mol%, more preferably not less than 0.1 mol%, further preferably not less than 0.5 mol%, particularly preferably not less than 1 mol%, still particularly preferably not less than 3 mol%, and still further preferably not less than 5 mol%. The upper limit is preferably not greater than 30 mol%, more preferably not greater than 25 mol%, further preferably not greater than 20 mol%, and particularly preferably not greater than 15 mol%.

### <Impurity>

### Tin Compounds as Impurities

The monoalkyltin composition (A1B1) according to one embodiment of the present disclosure may contain impurities. Tin compounds, other than tin compounds (A1) and (B1), as impurities are not particularly limited, and examples of tin compounds as representative impurities include the following tin compounds (A2) and (A3). The tin compounds (A2) and (A3) are compounds that are difficult to separate in terms of difficulty in separation with distillation due to structure and boiling point close to those of the tin compound (A1) and in terms of generation due to decomposition of tin compound (A1) in the reaction, heating, etc.

·R₂SnX₂ (A2)

·SnX₄ (A3)

Particularly when tin compound (A1) described below and tin compound (A2) or (A3) have close boiling points, it tends to be difficult to separate with distillation, and inhibition of the reaction and after-treatment is important. When tin compounds (A2) and (A3) are impurities having close boiling points, it is preferable to reduce the contents of tin compounds (A2) and (A3) after the reaction. The amount of tin compounds (A2) and (A3) contained in a synthesized tin compound (crude product) after the reaction is preferably not greater than 3 mol%, more preferably not greater than 2 mol%, further preferably not greater than 1 mol%, particularly preferably not greater than 0.5 mol%, especially preferably not greater than 0.3 mol%, further especially preferably not greater than 0.1 mol%, not greater than 0.05 mol%, or not greater than 0.03 mol%. The lower limit is 0 mol%.

### (Boiling Point of Impurity)

The boiling point here refers to a boiling point compared at the same pressure, not particularly limited to a normal pressure, specifically at a pressure of performing distillation. A case when a difference between the boiling points are close refers to the difference between the boiling points of the tin compounds (A1) and (A2) being typically not greater than 50°C, preferably not greater than 30°C, more preferably not greater than 10°C, and further preferably not greater than 5°C. The lower limit is 0°C.

When R and X have close molecular weights, the difference between the boiling points may be close or intermolecular interaction may be large, and thereby they may be difficult to separate. A case when R and X have close molecular weights refers to a case of the difference being typically not greater than 30, preferably not greater than 20, more preferably not greater than 10, and further preferably not greater than 5. The lower limit is 0.

As an example, a difference between the molecular weights of iPrSn(NMe₂)₃ (A1-1) and iPr₂Sn(NMe₂)₂ (A2-1) is small (the molecular weights are respectively 294 g/mol and 293 g/mol). The difference is as small as 1 g/mol, and since the isopropyl group and the dimethylamino group have extremely similar polarity, a difference in boiling points between the tin compounds (A1-1) and (A2-1) is extremely small. The boiling points of these compounds were measured, and the difference in boiling point between the two compounds was within 2 °C in a pressure range of 0.7 to 10 torr. That is, distillation having high separation ability is required to obtain highly pure tin compound (A1-1).

The tin compound (A1) and a tin compound being a raw material therefor (hereinafter, which may be referred to as "raw material tin compound") (E1) cause a problem of decomposition due to side reactions during the reaction and the subsequent after-treatment step. For example, a disproportionation reaction between tin compounds (A1) and (E1) as in the following formula may occur, and this reaction may be accelerated or inhibited with various reaction conditions.

A decomposition reaction due to light may occur, or the decomposition reaction may be accelerated by light and heat. In addition, the decomposition may be enhanced due to the presence of a slight amount of air, moisture, etc.

### (Decomposition of Tin Compound)

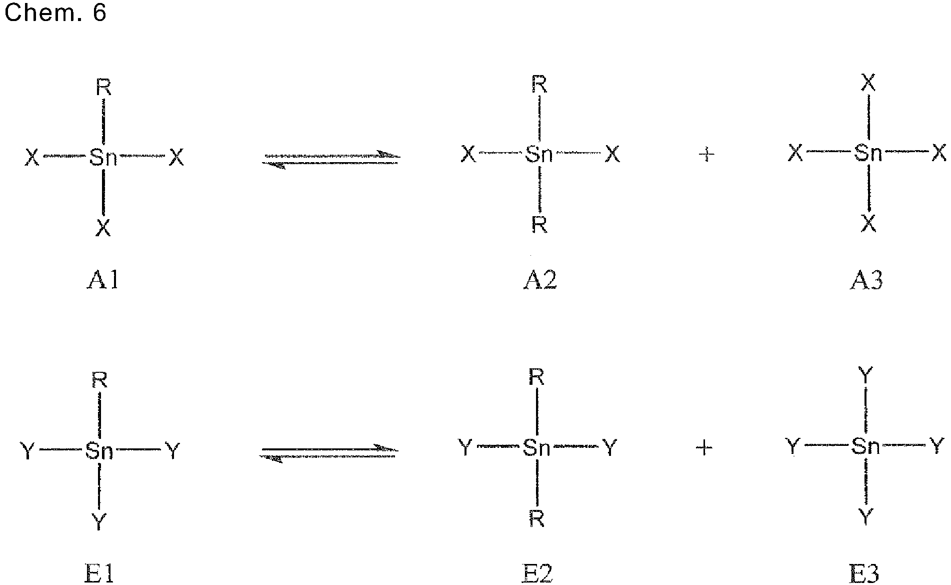

### Other Impurities

In addition, when the tin compound (A1) is RSn(NR₂)₃, the following tin compound (A4) may be contained as an impurity in the synthesized tin compound.

·RSn(NR')₂(N(R')CHNR'₂) (A4)

The tin compound (A4) is generated by decomposition of the tin compound (A1), and the generation may be accelerated by heat, light, and a combination thereof. For example, when the tin compound (A1) is iPrSn(NMe₂)₃ (A1-1), iPrSn(NMe₂)₂(NMeCHNMe₂) (A4-1) represented by the following formula (A4-1) may be generated as tin compound (A4) as an impurity. This impurity has the following chemical shifts in a ¹¹⁹Sn-NMR spectrum and ¹H-NMR spectrum, and can be identified and quantified.

¹¹⁹Sn-NMR (223.8 MHz; C6D6): δ -82 ppm
¹H-NMR (600 MHz; C6D6): δ 3.37 (s, 2H, CH₂), 2.89 (s, 3H, Sn-NMe), 2.86 (s, 12H, Sn-(NMe₂)₂), 2.15 (s, 6H, NMe₂), 1.68 (m, 1H, iPr), 1.33 (s, 6H, iPr)

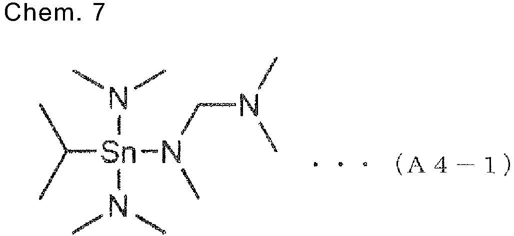

When X represents a dialkylamino group (NR'₂) (here, R'₂ is selected from a methyl group, a primary alkyl group, or a secondary alkyl group), the mechanism of generating the aforementioned compound RSn(NR')₂(N(R')CH₂NR'₂) is unclear but it is structurally presumed that a nitrogen radical (·NR'₂) generated by eliminating one of the three dialkylamino groups in the tin compound (A1) is inserted into a C-H bond adjacent to a nitrogen atom of another close compound (A1). That is, as specifically described in the Examples, the present compound can be produced by decomposition of the tin compound (A1) with heating or light.

The aforementioned compound RSn(NR')₂(N(R')CH₂NR'₂) is represented with R' being a methyl group as a representative example. When R' represents, for example, a primary alkyl group such as an ethyl group (here, R' represents CH₂R¹), that is, when the compound (A1) is represented by RSnN(CH₂R¹)₃, a compound (A4) is represented by RSn[N(CH₂R¹)₂]₂[N(CH₂R¹)CHR¹N(CH₂R¹)₂].

When R' represents a secondary alkyl group such as an isopropyl group (here, R' represents by RCHR²R³, that is, when the compound (A1) is represented by [N(CHR²R³)₂]₃, a compound (A4) is represented by RSn[N(CHR²R³)₂]₂[N(CHR²R³)CR²R³N(CHR²R³)₂].

Further, a divalent tin compound, SnX₂ (A8), may be contained. When the tin compound (A1) is RSn(NR₂)₃, examples thereof include the following tin compound (A8-1).

·Sn(NR'₂)₂ (A8-1)

A content of the tin compound (A8) is preferably not greater than 1.0 mol%, more preferably not greater than 0.5 mol%, further preferably not greater than 0.1 mol%, and particularly preferably not greater than 0.01 mol% in terms of tin atom content relative to the synthesized tin compound from the viewpoint of a highly pure resist material. The lower limit is 0 mol%.

With some raw materials and producing methods used, impurities such as R₃SnX and R₄Sn, which are tin compounds having a larger number of hydrocarbon groups, may be mixed as an impurity.

### <Method for Producing Tin Compound (A1)>

A method for producing the tin compound (A1) is not particularly limited, and the tin compound (A1) may be produced by a conventionally known method. Specific examples of a method for producing a tin compound containing the tin compound (A1) as a main component include the following producing methods.

### (Producing Method 1)

An example of a method for producing tin compound (A1) is a method of obtaining the tin compound (A1) by reacting a raw material tin compound (E1) and a reaction reagent ((M1) or (M2)) in an organic solvent (S1) under a specific condition. The details will be described below, and a typical reaction formula of this producing method is as follows.

RSnY^{E}₃ (E1) + 3MX (M1) → RSnX₃ (A1) + 3MY^{E}

This producing method 1 is preferable in terms of obtaining highly pure RSnX₃ (A1) because purity of the tin compound RSnY^{E}₃ being the raw material can be increased by purification. From the viewpoint of using a tin compound in which the organic group R is introduced in advance as the raw material, tin compounds A2, A3, A4, etc. as impurities may be reduced by another method to reduce impurities that are difficult to remove by distillation.

Hereinafter, material components etc. used for the method for producing the tin compound (A1) will be described.

### Raw Material Tin Compound (E1)

The raw material tin compound (E1) is represented by the following formula.

·RSnY^{E3} (E1)

In the general formula (E1), R represents an organic group having 1 to 30 carbon atoms. Examples of this organic group include a halogenated hydrocarbon group, a hydrocarbon group having a heteroatom such as an oxygen atom and a nitrogen atom, and a hydrocarbon group. Y^{E} is selected from a halogen atom, OR', and NR'₂. Each R' may be same as or different from each other, and represent an organic group having 1 to 10 carbon atoms and optionally having a halogen. When a plurality of R' are present in the molecule, the structures may be different from each other, and may be bonded to each other to form a cyclic structure.

The organic group Y^{E} may have any structure as long as the organic group is substituted by a reaction with the reaction reagent (M1). Specific preferable examples thereof include a halogen atom and an organic group selected from OR' and NR'₂, and a halogen atom is specifically preferable due to the high reactivity. Among these, a Cl atom is preferable because of good balance between stability and reactivity, ease of purification by distillation etc., and ease of preparing the raw material tin compound (E1) with higher purity. Among these, a monoalkyltin chloride is most preferable.

The purity of the raw material tin compound RSnY^{E}₃ can be increased by purification, and a method of using highly pure RSnY^{E}₃ as the raw material is preferable in terms of a low amount of remained impurity which increases the purity of the highly pure tin compound (A1). Specifically, the purity is typically not less than 95 mol%, preferably not less than 97 mol%, more preferably not less than 99 mol%, further preferably not less than 99.5 mol%, and particularly preferably not less than 99.9 mol% in terms of tin atom. The upper limit is 100 mol%.

Meanwhile, a tin compound as an impurity or moisture may contribute to stabilization, such as prevention of crystallizing the target product, or may affect the reaction of synthesizing tin compound (A1). The tin compound to be the impurity may be preferably contained at not less than 0.1 mol%, more preferably not less than 0.2 mol%, and further preferably not less than 0.3 mol%.

Specifically, each of the contents of R₂SnY^{E}₂, R₃SnY^{E}, and R₄Sn is preferably not greater than 3 mol%, more preferably not greater than 2 mol%, further preferably not greater than 1 mol%, and particularly preferably not greater than 0.1 mol% in terms of tin atom content. Meanwhile, from the viewpoint of contribution to stabilization, such as prevention of crystallizing the target product, each of R₂SnY^{E}₂, R₃SnY^{E}, and R₄Sn may be contained at preferably not less than 0.01 mol%, and more preferably not less than 0.1 mol%.

### Reaction Reagent (M1)

The reaction reagent (M1) is one that can provide a substitution reaction with the organic group Y^{E} of the tin compound (E1) (RSnY^{E}₃) being the raw material and that can generate the tin compound (A1) (RSnX₃) being the target product. Examples of preferable structures of the reaction reagent (M1) include MX, MX2, and MX3. For example, the reaction reagent (M1) being MX provides the following theoretical reaction.

·RSnY^{E}₃ (E1) + 3MX (M1) → RSnX₃ (A1)

In the reaction, M represents a metal atom of group 1, group 2, group 12, or group 13. When M is group 1, the reaction reagent (M1) may be represented by "MX." When M is group 2 or group 12, the reaction reagent (M1) may be represented by "MX2." When M is group 13, the reaction reagent (M1) may be represented by "MX3." The plurality of X in the molecule may be different. X is as described in the above section. Specifically, when X is OR', examples thereof include LiOR', NaOR', KOR', MgOR'₂, and ZnOR'₂. LiOR', NaOR', and KOR' are preferable from the viewpoint of high reactivity. When X is NR'₂, examples thereof include LiNR'₂, NaNR'₂, KNR'₂, Mg(NR'₂)₂, and Zn(NR'₂)₂. LiNR'₂, NaNR'₂, and KNR'₂ are preferable from the viewpoint of high reactivity, and Mg(NR'₂)₂ and Zn(NR'₂)₂ are preferable from the viewpoint of stability. Among these, LiNR'₂ (lithium amides: such as lithium dimethylamide and lithium diethylamide) is most preferable in terms of ease of preparing a highly pure reagent.

### Reaction Reagent (M2)

The reaction reagent (M2) refers to a compound selected form reaction reagent (M1) or a compound represented by a chemical formula HX. H represents a hydrogen atom, and X is same as that contained in the tin compound (A1). Examples of the compound corresponding to HX include HOR' (such as methanol, ethanol, t-butanol, and 4-methyl-2-pentanol) and HNR'₂ (such as dimethylamine, diethylamine, and morpholine). Among the options for the reaction reagent (M2), a reaction reagent (M1) is preferable because of high reactivity. From the viewpoint of no contamination with metal after the reaction, a compound corresponding to HX, namely, HOR' (such as methanol, ethanol, t-butanol, and 4-methyl-2-pentanol) and HNR'₂ (such as dimethylamine, diethylamine, and morpholine) are preferable. Particularly, when Y^{E} of the raw material tin compound (E1) (RSnY^{E}₃) is highly reactive NR'₂, use of the compound corresponding to HX may yield the highly pure product without contamination with metal.

### (Amount of Reaction Reagents (M1) and (M2))

The lower limit is preferably not greater than 3.00 eq, further preferably not less than 3.03 eq, and most preferably not less than 3.06 eq relative to the raw material tin compound (E1) in terms of mole equivalent.

The upper limit is preferably not greater than 10.00 eq, more preferably not greater than 8.00 eq, and further preferably not greater than 7.00 eq. A plurality of reaction reagents (M1) and (M2) may be used in combination, and in this case, the total amount of the mole equivalent of the reaction reagents preferably meets this range.

### (Method for Preparing Reaction Reagent (M1))

As for the temperature of a step of preparing the reaction reagent (M1), a lower limit temperature is preferably not lower than about -78°C, more preferably not lower than about -40°C, further preferably not lower than about -20°C, particularly preferably not lower than about -10°C, and especially preferably not lower than about -5°C. The upper limit temperature is preferably not higher than about 40°C, more preferably not higher than about 20°C, and further preferably not higher than about 15°C. Particularly when the reaction reagent (M1) is a lithium amide, which needs to be prepared from an amine and an alkyllithium, temperatures of not higher than the above upper limit tend to inhibit evaporation of the amine or decomposition of the alkylamide. Temperatures of not lower than the above lower limit tend to yield excellent solubility of dimethylamide in a solvent and appropriate viscosity to yield excellent stirring properties.

A lower limit of a reaction time after dropwise addition in preparing the reaction reagent (M1) is preferably not shorter than 0.5 hours (hereinafter, "hour(s)" may be referred to as "h"), more preferably not shorter than 1 h, and further preferably not shorter than 2 h. The upper limit is preferably not longer than 48 h, more preferably not longer than 30 h, and further preferably not longer than 20 h. If the reaction time is excessively short, a reaction reagent (M1) with sufficient purity tends to fail to be generated, or in a case of a slurry, insufficient mixing tends to generate a nonuniform reaction reagent (M1). If the reaction time is excessively long, byproducts tend to be generated or the number of equivalent tends to decrease due to decomposition of the reaction reagent (M1).

It is preferable that the reaction reagent (M1) be continuously stirred after preparing the reaction reagent (M1) and that the reaction reagent (M1) be used for this reaction between 3 to 48 hours after the preparation in terms of retaining the purity of the reaction reagent (M1) and controlling moisture in the reaction reagent (M1).

### (Method for Preparing Reaction Reagent (M2))

The reaction reagent (M2) refers to a compound selected from the reaction reagent (M1) and a compound corresponding to the chemical formula HX. The method for preparing the reaction reagent (M1) is as noted above, and a method about the compound represented by the chemical formula HX will be described. As the compound with chemical formula HX, a commercial compound may be used as is, but a compound subjected to a purification operation such as distillation, adsorption, and column is preferably used in order to prevent contamination with impurity, contamination with moisture, and contamination with metal. Alternatively, products that have been subjected to a purification operation, such as semiconductor grade (EL grade) and dehydration grade may be commercially available. Specifically, the purity is preferably not less than 95%, more preferably not less than 98%, further preferably not less than 99%, particularly preferably not less than 99.9%, and especially preferably not less than 99.99% based on mass. The upper limit is 100%. A preferable organic solvent for the preparation is as shown in the following organic solvent (S1). A specific contamination amount of metal is, as each metal element, preferably not greater than 100 ppm, more preferably not greater than 10 ppm, further preferably not greater than 1 ppm, particularly preferably not greater than 100 ppb, and especially preferably not greater than 10 ppb based on mass. The lower limit is 0 ppb.

### Organic Solvent (S1)

In the present producing method, the raw material tin compound (E1), the reaction reagent ((M1) or (M2)), and the organic solvent (S1) are used. The organic solvent (S1) is not particularly limited, and preferably an organic solvent such as, for example, hydrocarbons (such as hexane, cyclohexane, heptane, decane, and decalin), aromatics (such as benzene, toluene, xylene, and anisole), ethers (such as tetrahydrofuran (THF), diethyl ether, t-butyl methyl ether (TBME), dibutyl ether, 3-methylTHF, tetrahydropyran (THP), and 3-methylTHP), ketones (such as acetone, methyl ethyl ketone (MEK), and methyl isobutyl ketone (MIBK)), amides (such as N,N-dimethylformamide (DMF) and N,N-dimethylacetamide (DMAC)), esters (such as ethyl acetate and butyl acetate), and alcohols (such as methanol, ethanol, isopropanol, butanol, and 4-methyl-2-pentanol). The organic solvent (S1) is preferably an aromatic, hydrocarbon, or ether solvent that hardly reacts with the reaction reagent. These solvents may be used singly or in combination of two or more thereof.

The solvent is preferably one that does not contribute to a metal contamination substance.

The organic solvent (S1) is particularly preferably a hydrocarbon or aromatic solvent that has low solubility for inorganic salts etc. to easily remove byproducts such as inorganic salts etc. after the reaction by filtration, centrifugation, etc. Among these, toluene and hexane are the most preferable solvents at present because the product is easily removed at low temperature in vacuo after the reaction. Meanwhile, ethers are preferable solvents for smoothly providing the reaction because of high solubility of an organometal reaction reagent such as lithium dimethylamide. That is, combining a plurality of solvents such as hydrocarbon, aromatic, and ether solvents may combine the advantages of these solvents. In addition, when HOR' (such as methanol, ethanol, t-butanol, and 4-methyl-2-pentanol) and HNR'₂ (such as dimethylamine, diethylamine, and morpholine) are used as the reaction reagent (M2), the reaction reagent (M2) may also play a role as the solvent.

### (Producing Method 2)

As an example, the tin compound is synthesized with SnX₄, a raw material tin compound, and a reaction reagent RM or RMZ, which has R.

·SnX₄ + RM → RSnX₃ + MX

·SnX₄ + RMZ → RSnX₃ + MXZ^{E}

In the reaction formulas, M represents a metal atom of group 1, group 2, group 12, or group 13, or a hydrogen atom. When M is group 1 or a hydrogen atom, the reaction reagent may be represented by "RM." When M is group 2 or group 12, the reaction reagent may be represented by "RMZ^{E}." When M is group 13, the reaction reagent may be represented by "RMZ^{E}₂." The plurality of X in the molecule may be different. Z^{E} represents a halogen atom or R. The plurality of Z^{E} in the molecule may be different. X is as described in the above section. Specifically, when X is OR', examples thereof include ROH, RLi, RNa, RK, RMgZ^{E}, and RZnZ^{E}. RLi is preferable from the viewpoint of high reactivity, and RMgZ^{E} and RZnZ^{E} are preferable from the viewpoint of preventing decomposition of the target product due to reaction selectivity of monoalkylation and low basicity. Among these, RMgZ is the most preferable. From the viewpoint of no contamination with metal, ROH is preferable.

This technique has a problem of contamination with a byproduct having a plurality of organic groups R due to the reaction form. As for this point, a structure of RSnX₃ (A1) for which this technique is effective is a structure in which the organic group R is a tertiary alkyl group (for example, t-butyl, t-amyl, 1-methyl-cyclopentyl, or 1-methyl-cyclohexyl). In this case, for a bulky tertiary alkyl group, the target product in which one alkyl group is selectively added tends to be obtained with good yield in terms of ease of controlling reactivity of the reaction reagent RM and difficulty in introducing a plurality of bulky tertiary alkyl groups on the Sn atom. In addition, ease of separation by distillation, such as a boiling point of byproducts having a plurality of organic groups R far from that of the target product, also becomes a factor for this technique to effectively work.

### (Producing Method 3)

An example is a method including: a step α of producing MSnX₃ from SnX₂, which is a monoalkyltin compound raw material, and a reaction reagent containing MX; and a step β of reacting the obtained MSnX₃ and an alkylating agent RZ^{F}.

SnX₂ + MX → MSnX₃ (step α)

MSnX₃ + RZ^{F} → RSnX₃ (step β)

In the reaction formulas, M represents a metal atom of group 1, group 2, group 12, or group 13. When M is group 1, the reaction reagent may be represented by "MX." When M is group 2 or group 12, the reaction reagent may be represented by "MX2." When M is group 13, the reaction reagent may be represented by "MX3." The plurality of X in the molecule may be different. X is as described in the above section. Specifically, when X is OR', examples thereof include LiOR', NaOR', KOR', MgOR'₂, and ZnOR'₂. LiOR', NaOR', and KOR' are preferable from the viewpoint of high reactivity. When X is NR'₂, examples thereof include LiNR'₂, NaNR'₂, KNR'₂, Mg(NR'₂)₂, and Zn(NR'₂)₂. LiNR'₂, NaNR'₂, and KNR'₂ are preferable from the viewpoint of high reactivity. Among these, LiNR'₂ is most preferable in terms of ease of preparing a highly pure reagent. In the alkylating agent RZ^{F}, Z^{F} represents a halogen atom (F, Cl, Br, or I), and among these, Br or I is preferable from the viewpoint of reactivity.

This technique has an advantage that the organic group R can be introduced from RZ^{F}, which is an alkyl halide easily synthesized or available, due to the reaction form. In this point, this technique is effective in a case of an unstable organic group R that causes decomposition or side reactions when employed for the producing method 1 or 2. Specifically, when the organic group R has a heteroatom, an unsaturated bond, or an aromatic ring, this technique may be effective.

### (Distillation Purification)

The synthesized tin compound (A1) (crude product) may be further purified by distillation. A product purified by distilling the crude product is referred to as "purified tin compound of the tin compound (A1)."

The higher the proportion of tin compound (A1) in the purified tin compound, the higher the performance of the resist. Therefore, the purity of the tin compound (A1) is preferably 96 mol%, more preferably 97 mol%, further preferably not less than 98 mol%, particularly preferably not less than 99 mol%, especially preferably not less than 99.2 mol%, further especially preferably not less than 99.5 mol%, furthermore preferably not less than 99.8 mol%, and most preferably not less than 99.9 mol%. Meanwhile, a triaminotin compound having excessively high purity may be decomposed or may be unstable during storage or use due to a disproportionation reaction of the organic group R in the tin compound (A1). In this case, the purity is preferably not greater than 100.0 mol%, and more preferably not greater than 99.9 mol%.

The content of an inorganic impurity in the purified tin compound is preferably lower for use as a resist material. Specifically, a content of each inorganic impurity element is preferably not greater than 10 ppm, more preferably not greater than 1 ppm, further preferably not greater than 0.1 ppm, and particularly preferably not greater than 0.01 ppm. The lower limit is 0 ppm.

Note that, if the purified tin compound does not have sufficient quality, another purification process (such as purification by filtration or column and addition of an adsorbent or a reaction reagent) may be performed before and after the distillation.

### <<Application as Resist Material>>

### <Method for Producing Present Tin Hydrolysate>

A method for producing the present tin hydrolysate is preferably hydrolysis, including the following steps.
<Step 1> Blending two or more types of the precursor RSnX₃ (A1), wherein X represents a hydrolysable group, having different structures of the organic group R, to obtain a precursor mixture.
<Step 2> Contacting a blend of the precursor mixture and an organic solvent with liquid water.

In the step 1, two or more types of precursor, namely a precursor mixture is obtained. In this step, this precursor mixture is not hydrolyzed, and the chemical structure does not change. It is preferable that, for example, the precursor forms a gas and/or liquid state and be mixed to a sufficiently uniform state to obtain the precursor mixture. This precursor mixture is used in step 2. Therefore, step 1 is preferably performed under an inert gas atmosphere. In steps 1 and 2, other additives such as a solvent may not be used, but particularly when uniform mixing is performed as the precursor mixture in a liquid state (step 1) to be blended with an organic solvent, this blend is subjected to a contacting reaction (mixing) of liquid water (step 2), and not less than 100 parts by mass of an organic solvent relative to 100 parts by mass of the precursor mixture is preferably blended for the composition.

To obtain the uniformly mixed precursor mixture in step 1, step 1 is preferably performed specifically with the following apparatus under the following mixing condition.

As a result, the tin composition (M) obtained from the mixture obtained under the following preferable mixing condition has low proportions of the tin compounds (P3A) and (P3B), which have only a single organic group R, and has a more uniform composition distribution and molecular weight distribution, which are preferable because an undissolved residue in the resist solvent can be reduced and filterability can be improved. The tin composition is preferable also because crystallization during storage can be inhibited to improve storage stability.

Meanwhile, if the production advances into step 2 in a state when the two or more types of precursor are not sufficiently uniformly mixed, the hydrolysis proceeds in the state of uneven precursors, and the content (%) of each of the tin compounds (P3AB) in the tin composition (M) may decrease or the proportions of tin compounds (P3A) and (P3B) having only a single organic group R may increase. In addition, a distribution shape of a graph in which the contents (%) of each of the tin compounds (P3AB), (P3A), and (P3B) in the tin composition (M) is plotted as the y-axis and the number of content of the organic groups R in one molecule is plotted as the x-axis may have uneven distribution due to many peak tops. The molecular weight distribution of the tin composition (M) tends to be widened.

### <Apparatus and Condition in Mixing>

A container for the mixing in step 1 is not particularly limited, and the mixing is specifically preferably performed with a container equipped with a stirring apparatus under a mixing condition which does not cause deterioration of the precursor and contamination with an impurity. Specifically, the container for mixing is preferably a glass container, a SUS container, or a Teflon (R) container, or a container made of a composite material thereof that is equipped with a stirring apparatus. Particularly, a container having a liquid-contact surface made of glass is preferable because contamination with a metal content can be prevented and the precursor hardly decomposes. The stirring apparatus is preferably a stirring apparatus with blade rotation, such as a stirring blade or a stirring piece (magnetic stirrer), because the liquid mixture can be efficiently stirred. The container and stirring apparatus for mixing are preferably sufficiently washed with ultrapure water and then sufficiently dried because of sufficiently reduced contamination with metal content and halogen. A rotation speed of the stirring apparatus is preferably a number of rotations of not less than 50 rpm, preferably a number of rotations of not less than 100 rpm, preferably a number of rotations of not less than 150 rpm, and further preferably a number of rotations of not less than 200 rpm. The preferable range of the number of rotations is because a uniformly mixed liquid can be produced in a short time with no decomposition. The mixing time is not particularly limited as long as the mixing is sufficiently uniformly performed within a time which does not decompose the precursor, and the upper limit is preferably not longer than 12 hours, more preferably not longer than 6 hours, further preferably not longer than 3 hours, particularly preferably not longer than 1 hour, and still particularly preferably not longer than 30 minutes. The lower limit is preferably not shorter than 1 minute, more preferably not shorter than 2 minutes, and further preferably not shorter than 5 minutes.

The temperature for mixing is not particularly limited, and the upper limit is preferably not higher than 150°C, more preferably not higher than 100°C, further preferably not higher than 50°C, and particularly preferably not higher than 30°C. The lower limit is preferably not lower than -20°C, more preferably not lower than -10°C, and further preferably not lower than -5°C. When the temperature for mixing is not higher than the above upper limit, generation of an impurity or an insoluble material due to decomposition of the precursor during mixing can be inhibited and an ununiform state due to evaporation of the precursor and the solvent can be inhibited. When the temperature is not lower than the above lower limit, the precursors can be uniformly mixed in the liquid state without crystallization and elution.

As a condition of an inert gas filled in the container for mixing, nitrogen and argon are preferable, and highly pure nitrogen or argon is further preferably used. Since the precursor compound may react with light, decompose, and generate an impurity and an insoluble material, the mixing is preferably performed under a light-shielding condition.

### <Solvent in Mixing in Step 1>

When mixing in step 1, a solvent is not necessary when the target precursor mixture can be obtained, but use of an organic solvent may yield more efficient mixing. Using the same solvent as the solvent in hydrolysis in subsequent step 2 is preferable because necessity of a solvent-substitution step is eliminated. The specific organic solvent is not particularly limited, and preferably an organic solvent such as, for example, hydrocarbons (such as hexane, cyclohexane, heptane, decane, and decalin), aromatics (such as benzene, toluene, xylene, and anisole), ethers (such as tetrahydrofuran (THF), diethyl ether, t-butyl methyl ether (TBME), dibutyl ether, 3-methylTHF, tetrahydropyran (THP), and 3-methylTHP), ketones (such as acetone, methyl ethyl ketone (MEK), and methyl isobutyl ketone (MIBK)), amides (such as N,N-dimethylformamide (DMF) and N,N-dimethylacetamide (DMAC)), esters (such as ethyl acetate and butyl acetate), halogen solvents (dichloromethane and chloroform), and alcohols (such as methanol, ethanol, isopropanol, butanol, and 4-methyl-2-pentanol). A combination of solvents that do not react with the used precursor is preferable. Specifically, in a system in which the precursor structure has high reactivity, such as structure having the NR₂ group etc., an aprotic solvent is preferable. The aprotic solvent is specifically an aromatic, hydrocarbon, ether, or halogen solvent. These solvents may be used singly or in combination of two or more thereof. The solvent is preferably a solvent itself that does not contribute to a metal contamination substance. A content of moisture contained in the solvent is preferably not greater than 100 ppm, preferably not greater than 50 ppm, further preferably not greater than 30 ppm, and further preferably not greater than 15 ppm in order to prevent hydrolysis etc. in mixing. The lower limit is 0 ppm.

Methods for obtaining the gas precursor mixture in step 1 include: a method in which two or more types of precursor are mixed in advance and filled in the container, and evaporated to form the precursor mixture; and a method in which vapor of two or more types of the precursor are mixed in an apparatus such as a CVD apparatus and an ALD apparatus (including an attached mixing apparatus and piping). From the viewpoint of reproducibly of uniformly mixing precursors having different boiling points, more preferable is a method of mixing in a place for performing the hydrolysis in step 2, that is, in the apparatus such as an CVD apparatus and an ALD apparatus (including an attached mixing apparatus and piping).

Then, when liquid water is used for the hydrolysis, it is preferred to prepare a precursor mixture using two or more precursors, under an inert gas atmosphere (step 1) and a blend of this and an organic solvent be contacted with liquid water to perform hydrolysis of the precursor mixture (step 2). In this case, the organic solvent used in step 2 is preferably a solvent that does not hydrolyze the precursor, specifically preferably an aprotic solvent, and further preferably a dehydrated aprotic solvent. The water used in step 2 is preferably liquid water.

### Organic Solvent in Hydrolysis

In the present producing method, the organic solvent is not particularly limited, and preferably an organic solvent such as, for example, hydrocarbons (such as hexane, cyclohexane, heptane, decane, and decalin), aromatics (such as benzene, toluene, xylene, and anisole), ethers (such as tetrahydrofuran (THF), diethyl ether, t-butyl methyl ether (TBME), dibutyl ether, 3-methylTHF, tetrahydropyran (THP), and 3-methylTHP), ketones (such as acetone, methyl ethyl ketone (MEK), and methyl isobutyl ketone (MIBK)), amides (such as N,N-dimethylformamide (DMF) and N,N-dimethylacetamide (DMAC)), esters (such as ethyl acetate and butyl acetate), halogen solvents (dichloromethane and chloroform), and alcohols (such as methanol, ethanol, isopropanol, butanol, and 4-methyl-2-pentanol). A combination of solvents that does not react with the precursor is preferable. Specifically, in a system in which the precursor structure has high reactivity, such as hydrolysis, such as a structure having an NR₂ group etc., an aprotic solvent is preferable. The aprotic solvent is specifically an aromatic, hydrocarbon, ether, or halogen solvent. These solvents may be used singly or in combination of two or more thereof. The solvent is preferably a solvent that does not contribute to a metal contamination substance. A content of moisture contained in the solvent is preferably not greater than 100 ppm, preferably not greater than 50 ppm, further preferably not greater than 30 ppm, and further preferably not greater than 15 ppm in order to prevent ununiform hydrolysis that occurs before addition of water. The lower limit is 0 ppm.

### <Apparatus and Condition in Hydrolysis>

An apparatus and a container for hydrolysis in step 2 are not particularly limited, and the hydrolysis is specifically preferably performed with a container equipped with a stirring apparatus under a condition which does not cause deterioration of the precursor and contamination with an impurity. Specifically, the container for hydrolysis is preferably a glass container, a SUS container, a Teflon container, or a container made of a composite material thereof that is equipped with a stirring apparatus. Particularly, a container having a liquid-contact surface made of glass is preferable because contamination with a metal content can be prevented and the precursor hardly decomposes. The stirring apparatus is preferably a stirring apparatus with blade rotation such as a stirring blade or a stirring piece (magnetic stirrer) because the liquid mixture can be efficiently stirred. The container and stirring apparatus for hydrolysis are preferably sufficiently washed with ultrapure water and then sufficiently dried because of sufficiently reduced contamination with a metal content and halogen. A rotation speed of the stirring apparatus is preferably a number of rotations of not less than 50 rpm, preferably a number of rotations of not less than 100 rpm, preferably a number of rotations of not less than 150 rpm, and further preferably a number of rotations of not less than 200 rpm. The preferable range of the number of rotations is because uniform hydrolysis can be performed in a shorter time. The mixing time is not particularly limited as long as the mixing is sufficiently uniformly performed within a time which does not decompose the precursor, and the upper limit is preferably not longer than 12 hours, more preferably not longer than 6 hours, further preferably not longer than 3 hours, particularly preferably not longer than 1 hour, and still particularly preferably not longer than 30 minutes. The lower limit is preferably not shorter than 1 minute, more preferably not shorter than 2 minutes, and further preferably not shorter than 5 minutes. The temperature for hydrolysis is not particularly limited, and the upper limit is preferably not higher than 150°C, more preferably not higher than 100°C, further preferably not higher than 50°C, and particularly preferably not higher than 30°C. The lower limit is not lower than -20°C, more preferably not lower than -10°C, and further preferably not lower than -5°C. When the temperature for mixing is not higher than the above upper limit, generation of an impurity or an insoluble material due to decomposition of the precursor during mixing can be inhibited, and a non-uniform state due to evaporation of the precursor and the solvent tend to be inhibited. When the temperature is not lower than the above lower limit, the precursors tend to be uniformly mixed in the liquid state without crystallization and elution.

As a condition of an inert gas filling the container for hydrolysis, nitrogen and argon are preferable, and highly pure nitrogen or argon is further preferably used. Since the precursor compound may react with light and be decomposed and generate an impurity and an insoluble material, the mixing is preferably performed under a light-shielding condition.

### <Method for Forming Thin Film Containing Present Tin Hydrolysate>

The present tin hydrolysate (P1) described above may be used as a resist material. As for usage as a resist material, a method disclosed in JP-A-2021-21953 may be used, for example. For use as a resist material, examples of a method for forming the thin film (a coating film such as a coating layer and a film) containing the present tin hydrolysate include the following dry method and wet method.

In a dry method, a monoalkyltin compound (precursor) as the raw material of the tin hydrolysate is evaporated by heating or under a reduced pressure for use as vapor. For vapor of the precursor or the precursor deposited on the substrate, water vapor, another gas, etc. is reacted to synthesize the tin hydrolysate. This method is performed on the substrate to form the thin film (coating film) containing the tin hydrolysate on the substrate. As necessary, formation of the tin hydrolysate may be enhanced by combining steps such as a reaction, heating, and washing before or after this step.

One of the wet methods is a method in which a raw material containing a monoalkyltin compound (precursor) as the raw material of the tin hydrolysate is reacted with water etc. in a solution state or a solid state for the hydrolysis to obtain the tin hydrolysate. Thereafter, the tin hydrolysate may be dissolved in an organic solvent etc. to be used as a coating solution. Alternatively, the solution containing the precursor may first be applied onto the substrate, and then a part or entirety of the above hydrolysis steps may be carried out, and then the tin hydrolysate may be generated.

In the applying step, the applying may be performed on the substrate by any coating or printing technique, and the thin film (coating film) containing the tin hydrolysate may be formed on the substrate.

In the method for forming a thin film by a wet method, the tin hydrolysate is generated by the hydrolysis in step 2 before the thin film formation in some cases or after the thin film formation in other cases. In these two cases, it is preferable that the hydrolysis be performed before the tin film formation by using the aforementioned preferable method for hydrolysis in step 2 in order to produce a tin composition (M) having a plurality of the organic groups with appropriate composition and distribution. When the hydrolysis is performed before the thin film formation, a more uniform tin composition (M) can be synthesized because of the reaction with water while appropriate mixing for uniform hydrolysis. That is, the thin film containing a more uniform tin composition (M) having a low proportion of the tin compounds (P3A) and (P3B) with only a single organic group R and having more uniform composition distribution and molecular weight distribution may be obtained in the subsequent film formation.

Meanwhile, when hydrolysis is performed after film formation, the tin composition (M) becomes non-uniform because the hydrolysis proceeds in a state of non-uniform film formation and in a state of insufficient mixing. Specifically, examples of such a case include a case of forming a film in a state of not causing hydrolysis when applying a resist solution on a substrate, and after the film formation, using water etc. to perform the hydrolysis. In this case, the contents (%) of the tin compositions (P3AB) in the tin composition (M) in the thin film after hydrolysis may decrease, or the proportions of the compounds (P3A) and (P3B) with only a single organic group R may increase. In addition, a distribution shape of a graph in which the contents (%) of each of the tin compounds (P3AB), (P3A), and (P3B) in the tin composition (M) in the thin film is plotted as the y-axis and the content of the organic groups R in one molecule is plotted as the x-axis may be an uneven distribution due to many peak tops. The molecular weight distribution of the tin composition (M) tends to be widened.

### <Thin Film Patterning>

The thin film obtained by the above method may be stabilized or partially condensed before light irradiation via drying, heating, etc. The thin film (coating film) is typically thin, and has an average thickness of less than 10 microns, for example. To pattern an extremely small feature, an extremely thin sub-micron thin film with, for example, not greater than about 100 nm, further not greater than 50 nm, and particularly not greater than 30 nm may be desired, for example. The obtained thin film (coating film) is treated so that a part of the composition has resistance against development or etching by exposure, and thereby the thin film can be referred to as "resist."

The thin film (coating film) is exposed to appropriate radiation, for example, extreme ultraviolet ray, electron beam, or ultraviolet ray by using a selected pattern or a patterned negative portion to form a latent image having a developer-resistant region and a developer-soluble region. After exposure to the appropriate radiation and before development, the latent image may be differentiated from the non-irradiated region by reaction with heating or another method of the thin film. The latent image is contacted with a developer to form a physical image, namely a patterned thin film. The patterned thin film may be further heated to stabilize the patterned residual thin film on the surface. The patterned thin film may be used as a physical mask for further processing according to the pattern, for example, for etching the substrate and/or performing adhesion of an additional material. The patterned thin film may be used as a resist as desired, and then the remained patterned thin film may be removed at an appropriate time in processing, but the patterned thin film may be incorporated in a final structure.

Hereinafter, a condition of each process will be described in further detail.

### <Preparation and Filtration of Resist Solution>

A resist solution used for a wet method is typically mixed sufficiently and prepared by using a mixing apparatus appropriate for a volume of the material to be formed. In addition, a given contaminant or another insoluble component may be removed by using appropriate filtration. In some embodiments, the prepared resist solution may be mixed for use. Into the resist solution, various additives may be added in addition to the tin compound, which is the main component.

### <Coating on Substrate>

The precursor in a dry method and a resist solution in a wet method are appropriately selected according to adhesiveness to the substrate and subsequent processability. The precursor in a dry method and a resist solution in a wet method typically adhere to the substrate surface. The substrate may have a plurality of layers on the surface. In some embodiments, the substrate surface may be treated in order to adhere to the precursor in a dry method and the resist solution in a wet method. The substrate surface may be cleaned and/or smoothened as necessary. The appropriate substrate surface may contain any reasonable material. Some particularly interesting substrates (for example, a silicon wafer and a silica substrate) have another inorganic material such as a ceramic material, a polymer substrate, for example, an organic polymer, a composite thereof, and a combination thereof on the substrate surface and/or in the substrate surface layer. As the substrate, a relatively thin wafer with a circular structure etc. may be convenient, but any structure with any reasonable shape may be used.

A polymer substrate or a substrate having a polymer layer a on non-polymer structure may be desirable for specific use due to its low cost and flexibility. Such a polymer may be selected based on a relatively low processing temperature that can be used for processing the patterning material described herein. As such a polymer, for example, polycarbonate, polyimide, polyester, polyalkene, a copolymer thereof, and a mixture thereof are preferably contained.

Typically, the substrate desirably has a plain surface, particularly for high-resolution use. In a specific embodiment, however, the substrate may have substantial topography, and the resist coating is intended to fill or planarize the feature for specific patterning use. Such a function of the resist material is described in US-A-2015/0253667 (Bristol et al.), titled "Pre-Patterned Hard Mask for Ultrafast Lithographic Imaging", which is incorporated herein by reference.

To coat a substrate with a precursor in a dry method and a resist solution in a wet method, any appropriate coating process may be typically used. Examples of coating methods in the case of a wet method preferably include spin-coating, spray coating, dip coating, knife-edge coating, and printing means (for example, ink-jet printing and screening printing). Examples thereof in the case of a dry method include vapor deposition, such as physical vapor deposition and chemical vapor deposition. Some of these coating means form a pattern in the coating process, but resolution obtained by printing etc. at present is at a considerably lower level than resolution obtained by radiation-based patterning described herein. To provide larger control relative to the coating process, the coating material may be applied by many coating steps. For example, spin-coating is performed a plurality of times in a wet method, and vapor deposition is performed a plurality of times in a dry method to yield a desired final coating thickness. A thermal treatment described below may be applied after each of the coating steps or after a plurality of the coating steps.

When patterning is performed using radiation, spin-coating may be a desired means for coating a substrate with relative uniformity, but there may be an edge effect. The wafer may be rotated at a speed of about 500 to about 10000 rpm in some embodiments, about 1000 to about 7500 rpm in further embodiments, and about 2000 to about 6000 rpm in additional embodiments. The rotation speed may be regulated so as to obtain a desired coating thickness.

The spin-coating may be performed for a time of about 5 seconds to about 5 minutes, and about 15 seconds to about 2 minutes in further embodiments. By using initial low-speed rotation (for example, 50 to 250 rpm), initial bulk coating with the composition may be performed on the entire substrate. To remove given edge beat, back-surface rinsing, edge-beat removing step, etc. may be performed by using water or another appropriate solvent. A person skilled in the art would consider an additional range of the spin-coating parameter within the above clear range to recognize the parameter being included within the scope of the present disclosure.

The thickness of the coating film typically tends to depend on the concentration and viscosity of the resist solution and the rotation speed for the spin-coating in a wet method, and on vapor deposition pressure in a dry method. In a case of another coating process, the thickness may be typically regulated by selecting the coating parameter. In some embodiments, to facilitate formation of a small and highly customized feature in a subsequent patterning process, a thin coating may be desirably used. For example, the coating film after drying may have an average thickness of not greater than about 10 µm, not greater than about 1 µm in other embodiments, not greater than about 250 nm in further embodiments, about 1 to about 50 nm in additional embodiments, about 2 to about 40 nm in other embodiments, and about 3 to about 25 nm in some embodiments. A person skilled in the art would consider an additional range of thickness within the above clear range to recognize the thickness being included within the scope of the present disclosure. The thickness may be evaluated by using a contactless method with X-ray reflectance and/or polarization analysis based on optical properties of the film. In typical, the coating film is relatively uniform for facilitating the processing. Variation of the thickness of the coating film differs from not greater than only ±50% from the average coating thickness in some embodiments, not greater than only ±40% in further embodiments, and not greater than only about ±25% relative to the average coating thickness in additional embodiments. In some embodiments, such as highly uniform coating on a larger substrate, the uniformity of the coating may be evaluated by removing the edge with 1 cm. That is, the uniformity of the coating is not evaluated on the portion within 1 cm from the edge of the coating. A person skilled in the art would consider an additional range within the above clear range to recognize being included within the scope of the present disclosure.

Multiple coating processes can lead to partial evaporation of the solvent during the coating process itself, as the surface area of the droplets forming the coating material is increased and that stimulates evaporation. The volatilization of the solvent tends to increase the viscosity of the coating material by increasing the concentration of a species of the material. A goal during the coating process is removal of a sufficient amount of the solvent, to react a precursor for a dry method, or to react active molecules in the resist solution for a wet method in order to stabilize them for further processing. That is, during the coating step or the subsequent heating step, the solvent may be removed and the hydrolysate of the tin compound may be formed or condensed. In typical, the precursor in the dry method and the resist solution in the wet method may be heated before the radiation exposure in order to enhance densification. In the dried coating film, the precursor in the dry method and the resist solution in the wet method typically forms a polymer-metal oxo/hydroxo network based on the oxo-hydroxo ligand to the metal. Here, the metal also has some hydrocarbon groups or a polymer solid constituted with a polynuclear oxo/hydroxo species.

In the case of a wet method, the solvent-removing process may not be quantitatively controlled to a specific amount of the solvent remained in the coating material, and the properties of the obtained resist solution may be empirically evaluated for selecting process conditions effective for the patterning process.

Heating is not needed for success of the process, but the coated substrate may be desirably heated in order to accelerate the process and/or increase reproducibility of the process. In an embodiment of applying heating to remove the solvent, the coated substrate having the coating film may be heated at about 45 to about 250°C, or may be heated at about 55 to about 225°C in further embodiments. The heating to remove the solvent may be performed typically for at least about 0.1 minute, about 0.5 to about 30 minutes in further embodiments, or about 0.75 to about 10 minutes in additional embodiments. A person skilled in the art would consider an additional range of the heating temperature and time within the above clear range to recognize being included within the scope of the present disclosure. As a result of the heating treatment and densification, the coating film may exhibit an increase in refractive index and radiation absorption without considerably impairing the contrast.

### <Patterning by Exposure and Patterned Coating Film>

The coating film may be finely patterned by using radiation. As noted above, the composition of the coating film corresponding to the composition of the resist solution may be designed so as to sufficiently absorb radiation with a desired form. The absorption of radiation generates energy to break a bond between the metal and the hydrocarbon group, and at least a part of the hydrocarbon group is consequently no longer usable for stabilizing the material. A radiation-decomposed product having a hydrocarbon group or its fragment may not be dispersed from the film according to process parameters and the identity of such a product. The absorption of a sufficient dose of radiation condenses the exposed coating film, that is, forms a reinforced metal-oxo/hydroxo network, which may contain water absorbed from surrounding atmosphere. The radiation may typically be transmitted according to a selected pattern. Such a radiation pattern is transferred to the coating film as a latent image having a corresponding irradiated region and non-irradiated region. In the irradiated region, the components forming the coating film tend to chemically change. As described below, a pattern having an extremely sharp edge may be formed by selectively removing the non-irradiated portion or selectively removing the irradiated portion in the coating film in development.

The radiation may typically be directed to the coated substrate through a mask, or a radiation beam may be controllably scanned in the entire substrate. The radiation may typically include electromagnetic radiation, electron beam (beta-radiation), or another appropriate radiation. The electromagnetic radiation may typically have a desired wavelength or wavelength range, such as visible light, ultraviolet ray, and X-ray. The resolution that may be achieved relative to the radiation pattern typically depends on the wavelength of the radiation, and a pattern with higher resolution may be typically achieved with radiation having a shorter wavelength. Therefore, to achieve a pattern with particularly high resolution, ultraviolet ray, X-ray, or electron beam may be desirably used.

According to international standard ISO 21348 (2007) recited herein by reference, ultraviolet ray spreads between wavelengths of not shorter than 100 nm and shorter than 400 nm. Krypton fluoride laser may be used as an ultraviolet ray source at 248 nm. Under the admitted standard, the ultraviolet ray region may be classified by some methods into extreme ultraviolet ray (EUV) with not shorter than 10 nm and shorter than 121 nm and far ultraviolet ray (FUV) with not shorter than 122 nm and shorter than 200 nm. The 193-nm line from argon fluoride laser may be used as a radiation source for FUV. The EUV light is used for lithography at 13.5 nm, and this light is generated from a Xe or Sn plasma source excited by using high-energy laser or discharge pulse. Soft X-ray may be defined to be with not shorter than 0.1 nm and shorter than 10 nm.

A dose of the electromagnetic radiation may be featured by fluence or radiation dose obtained by integrated radiation flux relative to an exposure time. An appropriate radiation fluence may be about 1 to about 150 mJ/cm², about 2 to about 100 mJ/cm² in further embodiments, or about 3 to about 50 mJ/cm² in further embodiments. A person skilled in the art would consider an additional range of the radiation fluence within the above clear range to recognize being included within the scope of the present disclosure.

In electron beam lithography, electron beam typically induces secondary electrons, which typically change the irradiated material. The resolution may be at least partially a function within a range of the secondary electrons in the material. Here, higher resolution is typically considered to be obtained from secondary electrons within a shorter range. Based on high resolution that may be achieved by electron lithography using the inorganic coating material described herein, the range of the secondary electrons in the inorganic material is restricted. The electron beam may be featured by energy of the beam, and appropriate energy may be within a range of about 5 V to about 200 kV, or within a range of about 7.5 V to about 100 kV in further embodiments. A proximity-corrected beam radiation dose at 30 kV may be within a range of about 0.1 µC/cm² to about 5 mC/cm², within a range of about 0.5 µC/cm² to about 1 mC/cm² in further embodiments, or within a range of about 1 µC/cm² to about 100 µC/cm² in other embodiments. A person skilled in the art may calculate corresponding radiation dose of another beam energy based on suggestions herein, and would consider an additional range of the electron beam properties within the above clear range to recognize being included within the scope of the present disclosure.

Based on the design of the precursor in a dry method and the resist solution in a wet method, there is a large contrast of material properties between the irradiated region and the non-irradiated region having a substantially unchanged hydrocarbon group in the coating film. The contrast with the dose may be improved by a thermal treatment after the irradiation, but satisfactory results may be obtained without thermal treatment after the irradiation in some embodiments. It is considered that the thermal treatment after exposure is annealing of the irradiated region to increase the condensation therein based on thermal breakage of the hydrocarbon group - metal bond without significant condensation in the non-irradiated region of the coating film. In an embodiment using thermal treatment after the irradiation, thermal treatment after the irradiation may be performed at a temperature of about 45 to about 250°C, about 50 to about 190°C in additional embodiments, or about 60 to about 175°C in further embodiments. The post-exposure heating may be performed for at least about 0.1 minute in typical, about 0.5 to about 30 minutes in further embodiments, or about 0.75 to about 10 minutes in additional embodiments.

A person skilled in the art would consider an additional range of the temperature and time of the heating after the irradiation within the above clear range to recognize being included within the scope of the present disclosure. This high contrast of the material properties further facilitates formation of a sharp line in the pattern after development, described in the following section. As a result, the coating film after exposure to radiation is patterned with an irradiated region and a non-irradiated region.

### <Development and Patterned Structure>

Development of the image includes contacting the coating film having a latent image with a developer composition, and includes any one of: removing the non-irradiated portion to form a negative-type image; or removing the irradiated portion to form a positive-type image. When the precursor in a dry method and the resist solution in a wet method described herein are used, effective negative patterning or positive patterning having desired resolution may be performed by using an appropriate developer liquid based on the typically same coating. Particularly, the irradiated region is at least partially condensed to increase the properties of the components constituting the coating film, and the irradiated region consequently has resistance against dissolution with an organic solvent. The non-irradiated region tends to be still soluble in the organic solvent. In the irradiated region, the hydrocarbon group - tin bond is cleaved to release the hydrocarbon group, and thereby the irradiated region is further condensed to tend to increase metal-oxide-like properties of the components constituting the coating film. Meanwhile, the non-irradiated material does not release the hydrocarbon group and is hydrophobic, and thereby hardly dissolves in a weak base or acid aqueous solution. Therefore, the base aqueous solution may be used for positive patterning to remove the irradiated material while retaining the non-irradiated material.

The precursor in a dry method and the resist solution in a wet method that has a hydrocarbon group generates an inherently relatively hydrophobic material. By irradiation for breaking at least a part of the organometallic bond, the material is converted into a less hydrophilic, namely more hydrophilic material. This change in properties provides remarkable contrast between the irradiated region and the non-irradiated region of the coating film, which may perform both positive-type patterning and negative-type patterning with the same coating film. Specifically, the irradiated region of the coating film is condensed to a certain extent to be a composition containing a larger amount of the metal oxide, but the condensation extent is typically intermediate even without significant heating, and therefore the irradiated material becomes relatively insoluble against development with a conventional developer.

In the case of negative-type image formation, the developer may be an organic solvent such as a solvent used for forming a resist solution. The selection of the developer is typically affected by a dissolution parameter relating to the components of the coating film (chemical components in each of the irradiated region and the non-irradiated region), and volatility, flammability, toxicity, viscosity, and latent chemical interaction with other process materials of the developer. Specifically, examples of appropriate developers include aromatic compounds (for example, benzene, xylene, and toluene), esters (for example, propylene glycol monomethyl ether acetate, ethyl acetate, ethyl lactate, n-butyl acetate, and butyrolactone), alcohols (for example, 4-methyl-2-pentanol, 1-butanol, isopropanol, 1-propanol, and methanol), ketones (for example, methyl ethyl ketone, acetone, cyclohexanone, 2-heptanone, and 2-octanone), and ethers (for example, tetrahydrofuran, dioxane, and anisole). The development may be performed for about 5 seconds to about 30 minutes, about 8 seconds to about 15 minutes in further embodiments, or about 10 seconds to about 10 minutes in additional embodiments. A person skilled in the art would consider an additional range within the above clear range to recognize being included within the scope of the present disclosure.

In the case of positive-type image formation, the developer may typically be an acid or base aqueous solution. In some embodiments, the base aqueous solution may be used for obtaining a sharper image. To reduce contamination from the developer, a developer containing no metal element may be desirably used. Therefore, desired as a developer is a quaternary ammonium hydroxide composition, for example, tetraethylammonium hydroxide, tetrapropylammonium hydroxide, tetrabutylammonium hydroxide, or a combination thereof. Typically, particularly interesting quaternary ammonium hydroxides may be represented by a formula R⁴NOH, wherein R = a methyl group, an ethyl group, a propyl group, a butyl group, or a combination thereof. The coating material described herein is typically a polymer resist, and may be developed with a developer the same as a commonly used developer at present, specifically tetramethylammonium hydroxide (TMAH). Commercial TMAH is available at 2.38 mass%, and this concentration may be used for the treatment described herein. Further, mixed tetraalkylammonium hydroxide may be used. The developer may contain the tetraalkylammonium hydroxide or a similar quaternary ammonium hydroxide at typically about 0.5 to about 30 mass%, about 1 to about 25 mass% in further embodiments, or about 1.25 to about 20 mass% in other embodiments. A person skilled in the art would consider an additional range of the developer concentration within the above clear range to recognize being included within the scope of the present disclosure.

In addition to the main developer composition, the developer may contain an additional component to facilitate the development process. Examples of an appropriate additive include dissolved salts having: a cation selected from the group consisting of ammonium, d-block metal cation (such as hafnium, zirconium, and lanthanum), f-block metal cation (such as cerium and lutecium), p-block metal cation (such as aluminum and tin), alkali metal (such as lithium, sodium, and potassium), and a combination thereof; and an anion selected from the group consisting of fluorine, chlorine, bromine, iodine, nitrate, sulfate, phosphate, silicate, borate, peroxide, butoxide, formate, oxalate, ethylenediamine tetraacetate (EDTA), tungstate, molybdate, etc., and a combination thereof. Other examples of potentially useful additives include a molecular chelating agent, for example, a polyamine, an alcoholamine, an amino acid, a carboxylic acid, or a combination thereof. When the optionally selected additive is present, the developer may contain the additive at not greater than about 10 mass%, or the additive at not greater than about 5 mass% in further embodiments. A person skilled in the art would consider an additional range of the additive concentration within the above clear range to recognize being included within the scope of the present disclosure. The additive may be selected so as to improve the contrast, sensitivity, and line width roughness. The additive in the developer may inhibit formation and precipitation of the metal oxide particles.

In the case of a weaker developer, for example, an aqueous developer at a lower concentration or a diluted organic developer or composition (the coating having a lower development rate), development process at higher temperature may be used to increase the rate of the process. In the case of a stronger developing liquid, the temperature in the development process may be lowered in order to reduce the rate of the development and/or control dynamics of the development. The temperature for the development may be typically regulated among appropriate values corresponding to the volatility of the solvent. Further, a developer containing the dissolved coating film component near the developer-coating interface may be dispersed by an ultrasonic wave treatment during the development.

The developer may be applied to the coating film having the latent image by using any reasonable means. For example, the developer may be sprayed on the patterned coating material. In addition, spin-coating may be used. In the case of an automatic treatment, a puddle method including statically pouring the developer onto the coating material may be used. If desired, spin rinsing and/or drying may be used to complete the development process. Examples of the appropriate rinsing solution include ultrapure water, methyl alcohol, ethyl alcohol, propyl alcohol, and a combination thereof for the negative patterning, and include ultrapure water for the positive patterning. After the image is developed, the coating film is mounted on a substrate as the patterned coating film.

When the development step has been completed, the patterned coating film may be subjected to a thermal treatment in order to further condense the material, further dehydrate the material, increase the density, or remove the remained developer from the material. This thermal treatment may be particularly desirable for an embodiment of incorporating the oxide coating material into a final device, but when the coating film is desirably stabilized to facilitate further patterning, the thermal treatment may be desirably performed in some embodiments in which the coating film is used as the resist and finally removed. Particularly, baking of the patterned coating film may be performed under a condition such that the patterned coating film exhibits etching selectivity at a desired level. The patterned coating film may be heated to a temperature of about 100 to about 600°C in some embodiments, about 175 to about 500°C in further embodiments, or about 200 to about 400°C in additional embodiments. The heating may be performed for at least about 1 minute, about 2 minutes to about 1 hour in other embodiments, or about 2.5 minutes to about 25 minutes in further embodiments. The heating may be performed in the air, in vacuo, or in an inert gas atmosphere such as Ar or N₂. A person skilled in the art would consider an additional range of the temperature and time for the thermal treatment within the above clear range to recognize being included within the scope of the present disclosure. Similarly, a non-thermal treatment including blanket UV exposure or exposure to oxidative plasma such as O₂ may be used for a similar purpose.

With a conventional organic resist, an excessively large aspect ratio (value of height divided by width) of the structure tends to collapse the pattern. The pattern collapse may be involved with mechanical instability of the structure with a high aspect ratio in which a force involved with the processing step, for example, a surface tension, changes a structural element. A structure with a low aspect ratio is more stable against a latent deformation force. When a precursor in a dry method and a resist solution in a wet method described herein are used, a structure having a thinner coating film may be effectively processed, and thereby improved patterning may be achieved without a patterned coating film with a high aspect ratio. Therefore, a feature with extremely high resolution has been formed without depending on a feature with a high aspect ratio in the patterned coating film.

The obtained structure may have a sharp edge and extremely low line width roughness. Particularly, the obtained structure enables the ability to reduce line width roughness, and in addition, form high contrast, a small feature, and a space between features, and form a two-dimensional pattern (for example, a sharp corner) with extremely sufficiently resolution. Therefore, in some embodiments, adjacent linear portions of adjacent structures may have an average pitch (half pitch) of not greater than about 60 nm (30-nm half pitch), not greater than about 50 nm (25-nm half pitch) in some embodiments, or not greater than about 34 nm (17-nm half pitch) in further embodiments.

The pitch may be evaluated by design, and may be confirmed by scanning electron microscopy (SEM), for example, a top-down image. When used herein, the pitch refers to a spatial period of the repetitive structural element, namely a center distance, and the half-pitch is a half of the pitch, as commonly used in this technical field. The feature size of the pattern may also be represented by an average width of the feature typically evaluated at a place far from the corner, etc. The feature may refer to a gap between the material elements and/or the material element. The average width may be not greater than about 25 nm in some embodiments, not greater than about 20 nm in further embodiments, and not greater than about 15 nm in additional embodiments. The average line width roughness may be not greater than about 5 nm, not greater than about 4.5 nm in some embodiments, or about 2.5 to about 4 nm in further embodiments. The line width roughness is evaluated by analyzing the top-down SEM image to derive a 3σ-deviation from the average line width. The average includes roughness with both high frequency and low frequency, that is, each of a short correlation length and a long correlation length. The line width roughness of the organic resist is mainly featured by a long correlation length, but the organometal coating material of the present embodiment exhibits a remarkably short correlation length. In the pattern-transferring process, a short correlation length is smoothened during the etching process, which may generate extremely highly precise pattern. A person skilled in the art would consider an additional range of the pitch, the average width, and the line width roughness within the above clear range to recognize being included within the scope of the present disclosure.

### <Further Processing of Patterned Coating Film>

After the patterned coating film is formed on the substrate, the substrate may be further processed to facilitate formation of a selected device. In addition, further adhesion, etching, and/or patterning of a material may be typically performed to complete the structure.

The patterned coating film may not be finally removed. The quality of the patterned coating film is desirably improved for forming an improved device (for example, a device having a smaller mounting area, etc.) in any cases.

Alternatively or additionally, adhesion of a further material according to the mask pattern may change properties of the structure on the lower side and/or provide contact with the structure on the lower side. The further coating material may be selected based on desired material properties. In addition, the density of the patterned inorganic coating material may provide high injection resistance, and thereby ions may be selectively injected into the structure on the lower side through an opening of the mask. In some embodiments, the material to further adhere may be a dielectric, a semiconductor, a conductor, or another appropriate material. The material to further adhere may adhere using an appropriate means, for example, a solution-based procedure, chemical vapor deposition (CVD), sputtering, physical vapor deposition (PVD), or another appropriate means.

A plurality of additional layers may typically adhere. As for the adhesion of the plurality of the layers, additional patterning may be performed. If desired, any additional patterning may be performed by using the coating material described herein in an additional amount, a polymer-based resist, another patterning means, or a combination thereof.

As noted above, the patterned coating film may not be removed.

When the patterned coating film is not removed, the patterned coating film is incorporated into the structure. In an embodiment in which the patterned coating film is incorporated into the structure, the properties of the patterned coating film may be selected so as to provide not only the desired patterning properties but also the properties of the material in the structure.

When the patterned coating film is desirably removed, the patterned coating film functions as the conventional resist. The patterned coating film is used for patterning a material to adhere later before removal and/or for selectively etching the substrate via a space in the condensed coating material. The condensed coating material may be removed by using an appropriate etching process. Specifically, to remove the condensed coating material, dry etching is performed by using, for example, BCl₃ plasma, Cl₂ plasma, HBr plasma, Ar plasma, or plasma with another appropriate process gas. Alternatively or additionally, to remove the patterned coating material, wet etching using, for example, an acid or base aqueous solution, HF (aq), buffered HF (aq) / NH₄F, oxalic acid, etc. may be used.

The present resist material may be utilized for performing a multi-patterning. That is, this process may be applied for steps of multi-coating and multi-patterning. As for multi-patterning, a remarkable difference between the inorganic coating material described herein and a conventional organic resist is that the organic resist is still soluble in a conventional resist-casting solvent even after the heating/baking. The resist material described herein may be cured by heating/baking, and consequently becomes insoluble in an organic solvent. Thus, a coating layer etc. may be formed thereafter on the resist material.

### EXAMPLES

Hereinafter, the present disclosure will be further specifically described with Examples, but the present disclosure is not limited to the following Examples unless departing from the sprit. Note that "parts" and "%" in the Examples mean mass basis unless otherwise mentioned.

As used raw materials, the following materials were used unless otherwise described.

Each of tin compounds may be referred to as follows.
Precursor
   ·iPrSn(NMe₂)₃: isopropyltris(dimethylamide)tin, ¹¹⁹Sn-NMR: -64 ppm ... Compound (1)
Tin Compounds (A2, A3, and A4) being Impurities
   ·Tin compound (A2): iPr₂Sn(NMe₂)₂: diisopropyl form, ¹¹⁹Sn-NMR: -18 ppm ... Compound (2)
   ·Tin compound (A3): Sn(NMe₂)₄: tetrakisamide form, ¹¹⁹Sn-NMR: -120 ppm ... Compound (3)
   ·Tin compound (A4): iPrSn(NMe₂)₂(NMeCHNMe₂), ¹¹⁹Sn-NMR: -82 ppm ... Compound (4)
   ·Tin compounds other than Compounds (1) to (4): other impurities
Organic Solvent
   ·Dehydrated hexane: n-hexane (dehydrated) (produced by KANTO CHEMICAL CO., INC.) (water content: 10 ppm)

### <<Preparation and Analysis of Monoalkyltin Compound (Precursor)>>

The provided precursors were prepared to have compositions in the following Comparative Examples and Examples. The following Tables 2 and 3 each show detailed compositions such as functional groups in the obtained precursor.

Note that abbreviations of the organic group R in Tables 2 and 3 are as follows.
·iPr: isopropyl group, molecular formula C₃H₇
·tBu: tertial-butyl, molecular formula C₄H₉
·1Me-cPen: 1Me-cyclopentyl, molecular formula C₆H₁₁
·3Butenyl: 3-butenyl, molecular formula C₄H₇

### <Comparative Example 1-1>

Precursor L1: RSn(NMe₂)₃, purity: 99.2 mol% (R = isopropyl), a monoalkyltin compound (precursor) having a composition (contents of tin compounds (1) to (4)) described in the following Table 1 and text was prepared and provided.

**[Table 1]**

| | -64ppm RSnX₃ | -18ppm R₂SnX₂ | -82ppm RSnX₂Y | -120ppm SnX₄ |
|---|---|---|---|---|
| Precursor | Compound (1) | Compound (2) | Compound (4) | Compound (3) |
| L1 (mol%) | 99.20 | 0.00 | 0.00 | 0.80 |

### (Method for Producing Precursor L1)

Prepared and used were a light-shielded 200-L reaction vessel made of glass (jacket with circulating water), a cooling condenser equipped with an internal coil, a stirring apparatus (stirring blade: twinstar, diameter: 350 mm, width: 110 mm, made of SUS coated with Teflon(R)), and a 50-L dropping apparatus made of glass.

The pressure in the reaction apparatus was reduced to 3 kPa and then substituted with nitrogen, and this procedure was repeated three times. Hexane (36.6 kg, moisture: 21 ppm) and n-butyllithium [41.0 kg, 96.8 mol (3.09 eq), 15% hexane solution (containing hexane corresponding to 34.9 kg)] were added, and while stirring the mixture at 150 rpm [speed of blade tip (m/s): 3.14×0.35×150/60 = 2.74 (m/s)], dimethylamine (8.69 kg, 193.6 mol, 6.18 eq) was added dropwise over 1 h with keeping the temperature between -5 to 10°C. The obtained slurry of lithium dimethylamide was stirred at 23 to 27°C for 1 h.

The temperature of the obtained slurry of lithium dimethylamide was regulated to -10°C, and a hexane solution containing isopropyltrichlorotin (8.40 kg, 31.3 mol, 1.00 eq) (4.20 kg as hexane amount) was added dropwise through the dropping apparatus made of glass over 2 h while keeping a temperature range (internal temperature: -10°C to 0°C). Thereafter, the dropping apparatus was rinsed with hexane (0.61 kg) to be added dropwise.

After the dropwise addition, the temperature was raised to 25°C over 3 h, and then the mixture was stirred for 16 h. The obtained reaction liquid was filtered with a pressurized filtering apparatus to remove a white solid (LiCl), and a clear filtrate was obtained. The white solid was further washed with dehydrated hexane (7.3 kg × 3) to be combined with the filtrate. The obtained reaction liquid was condensed under a reduced pressure. The obtained condensate liquid (10.3 kg) was fed into a light-shielded single-distillation apparatus made of glass under a nitrogen atmosphere. The condensed liquid was introduced into the distillation apparatus under a nitrogen-inert gas atmosphere, and single distillation was performed under a reduced pressure with heating to obtain a corresponding tin compound (1) as a distillation fraction (distillation apparatus: single-distillation apparatus made of glass and wrapped with cloth for shielding light, distillation condition: internal temperature: 70 to 80°C, degree of pressure reduction: 0.3 kPa). The tin compound (1) obtained by this single distillation was subjected to precise distillation purification by using a distillation tower having 30 theoretical steps under a condition with a reflux ratio of 10. The obtained tin compound (1) subjected to the precise distillation was specified as the precursor L1.

### <Comparative Example 1-2>

Precursor L2: RSn(NMe₂)₃, purity: 99.8 mol% (R = tertial-butyl)

### <Comparative Example 1-3>

Precursor L3: RSn(NMe₂)₃, purity: 99.9 mol% (R = 1-Methyl-cyclopentyl)

### <Comparative Example 1-4>

Precursor L4: RSn(OtBu)₃, purity: 99.7 mol% (R = 3-Butenyl)

### <Example 1-1>

Precursor L5: Mixture of the precursors L1 and L2 at a mass ratio of 7:3

### <Example 1-2>

Precursor L6: Mixture of the precursors L1 and L3 at a mass ratio of 7:3

### <Example 1-3>

Precursor L7: Mixture of the precursors L1 and L4 at a mass ratio of 7:3

**[Table 2]**

| | Precursor | R^{A}* | X1 * * | R^{B}* | X2* * | Precursor R^{A}/R^{B} (mole ratio) |
|---|---|---|---|---|---|---|
| Comparative Example 1-1 | L1 | iPr | NMe₂ | - | - | - |
| Comparative Example 1-2 | L2 | tBu | NMe₂ | - | - | - |
| Comparative Example 1-3 | L3 | 1-Me-cPen | NMe₂ | - | - | - |
| Comparative Example 1-4 | L4 | 3-Butenyl | OtBu | - | - | - |
| Example 1-1 | L5 | iPr | NMe₂ | tBu | NMe₂ | 71/29 |
| Example 1-2 | L6 | iPr | NMe₂ | 1Me-cPen | NMe₂ | 73/27 |
| Example 1-3 | L7 | iPr | NMe₂ | 3Butenyl | OtBu | 76/24 |

| | | | | | | |
|---|---|---|---|---|---|---|
| * R^{A} and R^{B} are organic groups (here, alkyl groups) and each indicates that they are different. * * X1 and X2 are any of the X's of RSnX₃, R2SnX₂, RSnX₂Y and SnX₄, also each indicates that they are different. | | | | | | |

### <<Preparation of Tin Hydrolysate with Hydrolysis and Analysis>>

### <Comparative Example 2-1>

Used as apparatuses for mixing and hydrolysis were a container: three-necked 100-mL glass flask (light-shielded with aluminum foil, washed with ultrapure water and then dried) and a stirring apparatus: magnetic stirrer (stirring piece: made of Teflon, bar, 20 mm in length). Under an inert gas (G1-grade nitrogen, produced by TAIYO NIPPON SANSO CORPORATION) atmosphere and light-shieled condition, 10 mL of dehydrated hexane (moisture: 10 ppm) was added into the flask by using an air-tight syringe. Thereafter, 1.0 g of the precursor L1 (3.4 mmol, calculation value as iPrSn(NMe₂)₃) was added into the flask with an air-tight syringe. The obtained liquid was cooled with an ice bath, and while stirring the liquid at 200 rpm, desalted water (18.2 MΩ) (1.0 mL) was added over 3 minutes with keeping the temperature within 0 to 10°C. As a result, a slurry of white solid was formed. Thereafter, the slurry was filtered with filter paper (Kiriyama 5B) to obtain a white solid. The solid was rinsed twice with desalted water (18.2 MΩ) (3.0 mL), and recovered into a 20-mL glass vial. The glass vial was dried in vacuo at 40°C for 8 h to obtain a white solid tin hydrolysate H1.

The obtained tin hydrolysate was used, and the composition and crystallinity of the tin hydrolysate were analyzed with the following measurement device under the following condition. The following Table 3 shows the results.

### NMR Analyzer and Method

·NMR analyzer: produced by Bruker, Avance Neo, 600 MHz, probe: cryo 5 mm BBO

The tin hydrolysate was dissolved in a measurement solvent described in the Examples described later to measure NMR (¹H-NMR, ¹³C-NMR, ¹¹⁹Sn-NMR, and correlation NMR thereof). From the obtained NMR charts, composition analysis and purity analysis of the tin hydrolysate were performed based on the aforementioned sections of the composition analysis and the purity analysis of the tin hydrolysate.

### ESI-MS Analyzer and Method

·ESI-MS analyzer: produced by Waters, Xevo G2-XS Qtof, measurement mode: ESI positive, solvent: acetonitrile

Analysis method: a theoretical mass spectrum including isotopes of tin compounds was calculated with an analysis software attached to the apparatus, a peak with strongest intensity was detected from the theoretical mass spectrum as peaks of the tin compounds, and the peak intensity was quantified.

### XRD Analyzer and Method

·XRD analyzer: produced by PANalytical, X'Pert Pro MPD, X-ray source, CuKα concentration method optics, scanning range: 3 to 50°, calculation was performed with half-value width analysis method: profile-fitting method (Pearson-VII function, pseudo-Voigt function).

### <Comparative Examples 2-2 to Comparative Example 2-4>

Tin hydrolysates H2 to H4 described below were obtained by performing the same manner as of Comparative Example 2-1 except that the precursor was changed to the precursors L2 to L4 as in the following Table 3 (the precursor amount was unified to 1.0 g, and the other reagent was used at the same amount). The composition and crystallinity of the obtained tin hydrolysates were analyzed, and shown in the following Table 3.

### <Example 2-1>

Used as apparatuses for mixing and hydrolysis were a container: three-necked 100-mL glass flask (light-shielded with aluminum foil, washed with ultrapure water and then dried) and a stirring apparatus: magnetic stirrer (stirring piece: made of Teflon, bar, 20 mm in length). Under an inert gas (G1-grade nitrogen, produced by TAIYO NIPPON SANSO CORPORATION) atmosphere and light-shieled condition, 10 mL of dehydrated hexane (moisture: 10 ppm) was added into the flask by using an air-tight syringe. Thereafter, 0.70 g (2.38 mmol) of the precursor L1 and 0.30 g (0.97 mmol) of the precursor L2 were added by using an air-tight syringe under an inert gas atmosphere and light-shielding condition. The obtained liquid was cooled with an ice bath, and stirred at 200 rpm for 5 minutes. This yielded a mixed liquid of the precursors L1 and L2 (mole ratio of the precursors L1:L2 = 0.71:0.29). Into this mixed liquid, desalted water (18.2 MΩ) (1.0 mL) was added over 3 minutes with keeping the temperature within 0 to 10°C. As a result, a slurry of white solid was formed. This slurry was further stirred for 10 minutes with keeping the temperature within 0 to 10°C. Thereafter, the slurry was filtered with filter paper (Kiriyama 5B) to obtain a white solid. The solid was rinsed twice with desalted water (18.2 MΩ) (3.0 mL), and recovered into a 20-mL glass vial. The glass vial was dried in vacuo at 40°C for 8 h to obtain a white solid tin hydrolysate H5.

### <Example 2-2>

A mixed liquid of the precursors L1 and L3 was prepared (mole ratio of the precursors L1:L3 = 0.73:0.27) in the same manner as in Example 2-1 by using 0.70 g (2.38 mmol) of the precursor L1 and 0.30 g (0.90 mmol) of the precursor L3. A tin hydrolysate H6 was obtained in the same manner except for the above.

### <Example 2-3>

A mixed liquid of the precursors L1 and L4 was prepared (mole ratio of the precursors L1: L4 = 0.76:0.24) in the same manner as in Example 2-1 by using 0.70 g (2.38 mmol) of the precursor L1 and 0.30 g (0.90 mmol) of the precursor L4. A tin hydrolysate H7 was obtained in the same manner except for the above.

**[Table 3]**

| | Precur sor | Tin hydrolys ate | R^{A} | R^{B} | NMR | NMR | mass | | mass | XRD | |
|---|---|---|---|---|---|---|---|---|---|---|---|
| | | | | | R^{A}/R^{B} (mole ratio) in tin hydrolys ate | Five-coordinat e (iPrSnO₄) | Six-coordinat e (iPrSnO₅) | Structure of main peak | Structure identification result of main peak | Diffraction angle 2θ of top of strongest intensity peak | Peak half-value width |
| | | | | | | -337ppm | -513ppm | | | (°) | (°) |
| Comparati ve Example 2-1 | L1 | H1 | iPr | - | - | 1.04 | 1.00 | R^{A}12 Sn12 O 14 (OH)6 | Tin dodecamer containing only R^{A} in one molecule | 7.87 | 0.83 |
| Comparati ve Example 2-2 | L2 | H2 | tBu | - | - | 0.89 | 1.00 | R^{A}12 Sn12 O 14 (OH)6 | Tin dodecamer containing only R^{A} in one molecule | 7.74 | 0.23 |
| Comparati ve Example 2-3 | L3 | H3 | 1Me-cPen | - | - | 0.64 | 1.00 | R^{A}12 Sn12 O 14 (OH)6 | Tin dodecamer containing only R^{A} in one molecule | 7.27 | 0.23 |
| Comparati ve Example 2-4 | L4 | H4 | 3Bute nyl | - | - | 0.44 | 1.00 | Undetermina ble main peak due to plurality of peaks | Complex mixture with various numbers of Sn | 6.39 | 1.56 |
| Example 2-1 | L5 | H5 | iPr | tBu | 70/30 | 0.84 | 1.00 | R^{A}8 R^{B}4 Sn12 O 14 (OH)6 | Tin dodecamer containing R^{A} and R^{B} in one molecule | 7.73 | 1.16 |
| Example 2-2 | L6 | H6 | iPr | 1Me-cPen | 75/25 | 1.88 | 1.00 | R^{A}10 R^{B}2 Sn12 O 14 (OH)6 | Tin dodecamer containing R^{A} and R^{B} in one molecule | 7.54 | 1.40 |
| Example 2-3 | L7 | H7 | iPr | 3Bute nyl | 78/22 | 1.12 | 1.00 | R^{A}10 R^{B}2 Sn12 014 (OH)6 | Tin dodecamer containing R^{A} and R^{B} in one molecule | 7.61 | 1.21 |

### Analysis Result of Tin Hydrolysate H1

### (R = isopropyl, chemical formula: C₃H₇)

As a result of ¹¹⁹Sn-NMR measurement of the tin hydrolysate H1, Sn NMR (MeOD): peaks at 1:1 were observed with five-coordinate (RSnO₄): -337 ppm and six-coordinate (RSnOs): -513 ppm as shown in Table 3. This correlates to the NMR results of tin dodecamer cluster (nBuSn)₁₂O₁₄(OH)₆ reported in Organometallics 19, 2000, 1940-1949. That is, the compound corresponding to a composition formula RSnO_{(3/2-x/2)}(OH)ₓ was obtained.

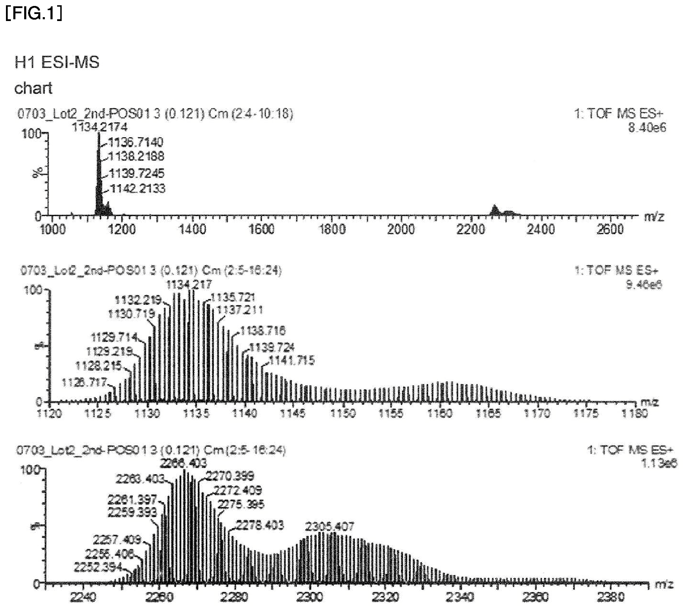

As a result of analysis by electro-spraying ionization mass spectrometry (ESI-MS) of the tin hydrolysate H1, FIG. 1 shows a spectrum of ESI-MS of H1. In this spectrum, observed were peaks corresponding to a divalent ion equivalent for the composition formula RSnO_{(3/2-x/2)} (specifically, a chemical formula [(C₃H₇Sn)₁₂O₁₄(OH)₆]⁺², calculated value m/z = about 1134), monovalent ion (m/z = about 2268), and their adducts of potassium etc. (equivalent for m/z+40). This divalent ion corresponded to the chemical formula (RSn)₁₂O₁₄(OH)₆⁺².

### Analysis Result of Tin Hydrolysate H2

### (R = tertial-butyl, chemical formula: C₄H₉)

As a result of ¹¹⁹Sn-NMR measurement of the tin hydrolysate H2, peaks at about 0.9:1 were observed with five-coordinate : six-coordinate as shown in Table 3. A compound corresponding to the composition formula RSnO_{(3/2-x/2)}(OH)ₓ was obtained.

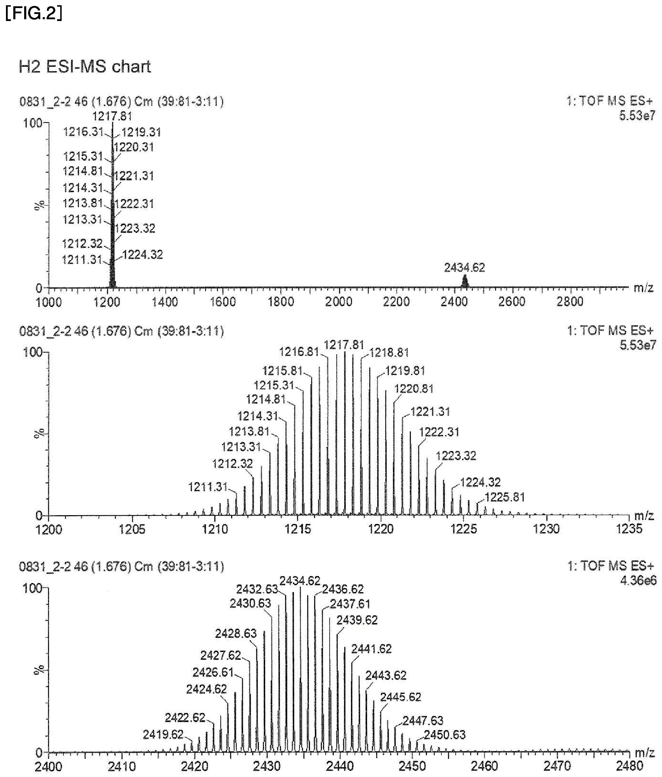

As a result of analysis by electro-spraying ionization mass spectrometry (ESI-MS) of the tin hydrolysate H2, FIG. 2 shows a spectrum of ESI-MS of H2. In this spectrum, observed were peaks corresponding to a divalent ion (specifically, a chemical formula [(RSn)₁₂O₁₄(OH)₆]⁺², calculated value m/z = about 1218) and a monovalent ion (m/z = about 2435) that corresponded to the composition formula RSnO_{(3/2-x/2)}.

### Analysis Result of Tin Hydrolysate H3

### (R = 1Methyl-cyclopentyl, chemical formula: C₆H₁₁)

As a result of NMR identification of the tin hydrolysate H3, peaks at about 0.6:1 were observed with five-coordinate : six-coordinate as shown in Table 3. A compound corresponding to the composition formula RSnO_{(3/2-x/2)}(OH)ₓ was obtained. ¹H NMR (600 MHz MeOD/CDCl3 1/1): 2.0-2.4 (m, 2H), 1.6-1.9 (m, 6H), 1.48 (Me, 3H RSnO4), 1.28 (Me, 3H RSnO5).

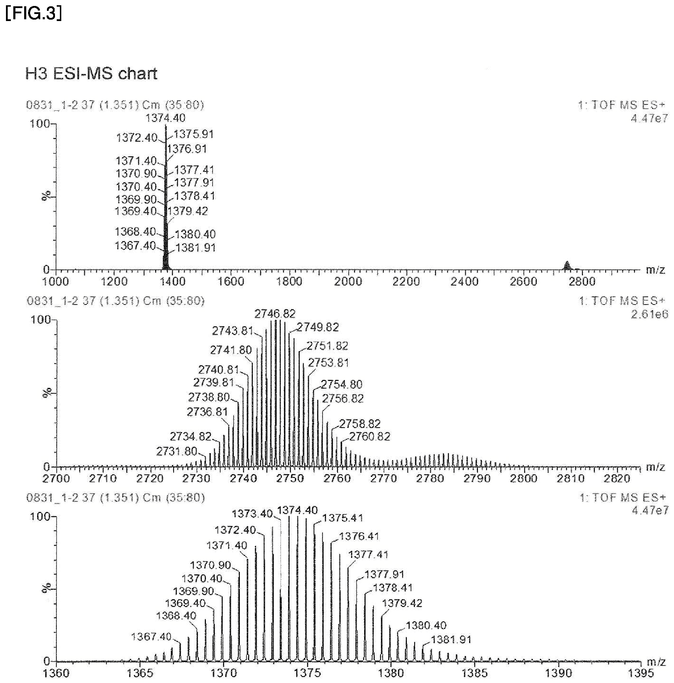

As a result of analysis by electro-spraying ionization mass spectrometry (ESI-MS) of the tin hydrolysate H3, FIG. 3 shows a spectrum of ESI-MS of H3. In this spectrum, observed were peaks corresponding to a divalent ion (specifically, a chemical formula [R(Sn)₁₂O₁₄(OH)₆]⁺², calculated value m/z = about 1374) and a monovalent ion (m/z = about 2747) that was a compound corresponding to the composition formula RSnO_{(3/2-x/2)}.

### Analysis Result of Tin Hydrolysate H4

### (R = 3-butenyl, chemical formula: C₄H₇)

As a result of NMR identification of the tin hydrolysate H4, peaks at about 0.4:1 were observed with five-coordinate : six-coordinate as shown in Table 3. A compound corresponding to RSnO_{(3/2-x/2)}(OH)ₓ was obtained.

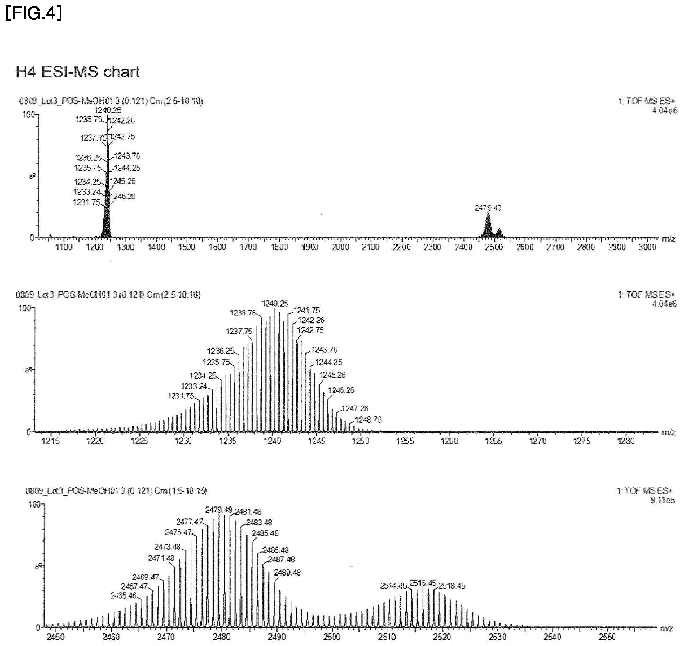

As a result of analysis by electro-spraying ionization mass spectrometry (ESI-MS) of the tin hydrolysate H4, FIG. 4 shows a spectrum of ESI-MS of H4. In this spectrum, observed were peaks corresponding to a divalent ion (specifically, a chemical formula [(RSn)₁₂O₁₄(OH)₆]⁺², calculated value m/z = about 1240) and a monovalent ion (m/z = about 2480) that was a compound corresponding to the composition formula RSnO_{(3/2-x/2)}.

### Analysis Result of Tin Hydrolysate H5

### (R^{A} = isopropyl, chemical formula: C₃H₇, R^{B} = tertial-butyl, chemical formula: C₄H₉)

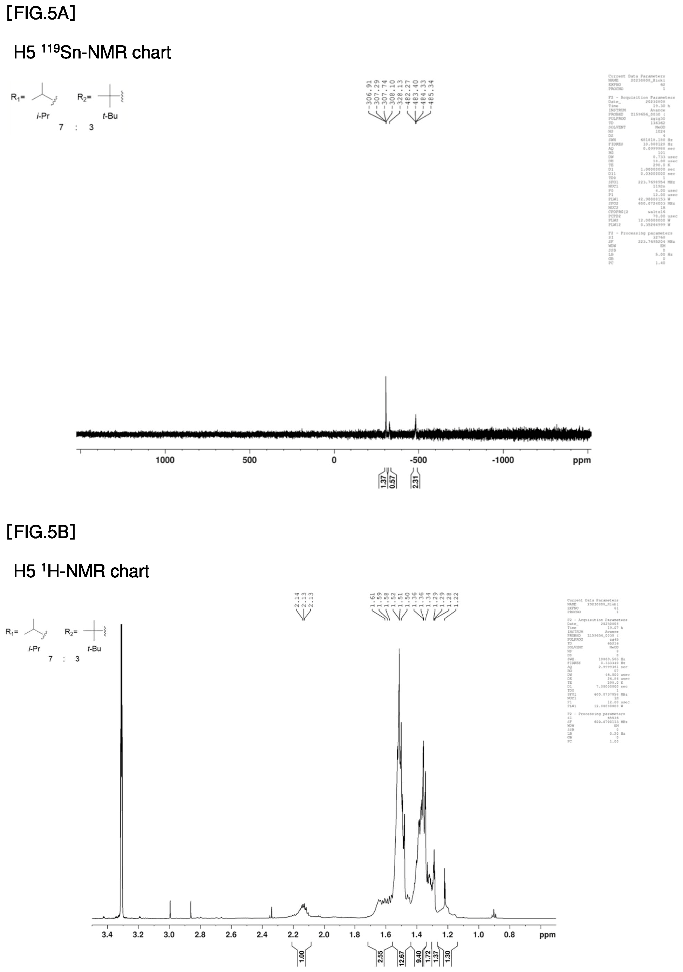

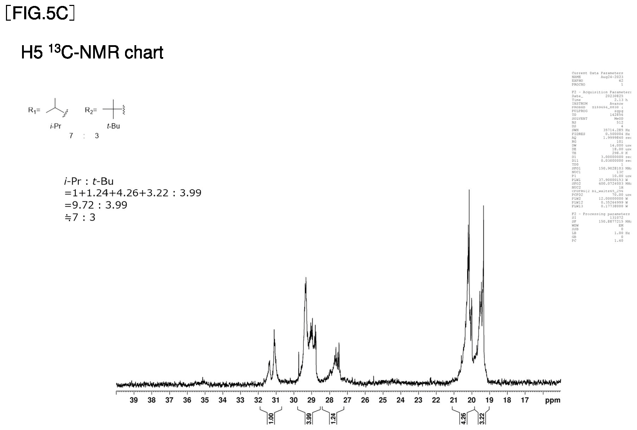

As a result of NMR identification of the tin hydrolysate H5, peaks at about 0.84:1 were observed with five-coordinate : six-coordinate as shown in Table 3. A compound corresponding to a composition formula RSnO_{(3/2-x/2)}(OH)ₓ was obtained. In addition, corresponding peaks with detectable intensity other than k1 and k2 were absent, and thereby the value of (k1+k2)/(k3) indicating the purity was not less than 0.99. From the analysis result with ¹H-NMR and ¹³C-NMR, the composition mole ratio R^{A}:R^{B} was calculated to 70/30. This composition correlated the mole ratio of the mixed precursor used as the raw material. FIG. 5A to 5C show NMR spectrums.

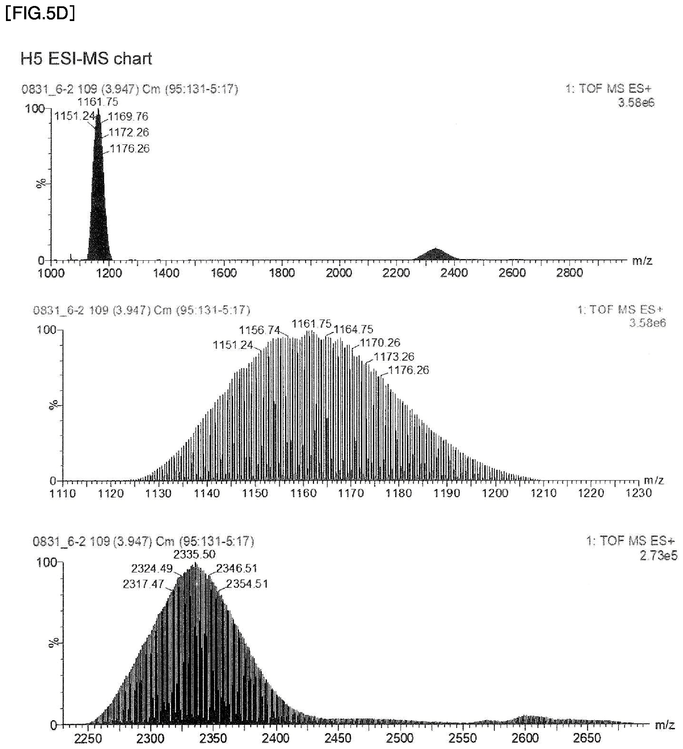

As a result of analysis by electro-spraying ionization mass spectrometry (ESI-MS) of the tin hydrolysate H5, FIG. 5D shows a spectrum of ESI-MS of H5. In this spectrum, peaks corresponding to a divalent ion (specifically, a chemical formula [(R^{A}Sn)₇(R^{B}Sn)₅O₁₄(OH)₆]⁺², calculated value m/z = about 1162) and a monovalent ion (m/z = about 2336) that were a compound corresponding to RSnO_{(3/2-x/2)} were observed with the strongest intensity, which corresponded to the tin compound (P3AB) having substituents of seven R^{A} = isopropyl and five R^{B} = tertial-butyl. Peaks corresponding to a compound having different composition of R^{A} and R^{B} were observed therearound. That is, it has been revealed that R^{A} and R^{B} are present as different types of alkyl groups in one molecule of the tin hydrolysate.

The following Table A-1 shows the molecular weights of the peaks, the peak intensities, and the content (%) of each of the tin compounds detected by ESI-MS. Eleven types of tin compound (P3AB) contained in the present tin hydrolysate H5 were detected, and the tin compounds (P3A) and (P3B) having a single organic group R were similarly detected. The content of each tin compound was calculated by the following formula as described above. 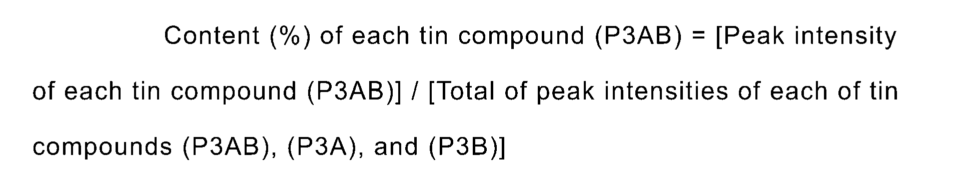 Content (%) of each tin compound (P3AB) = [Peak intensity of each tin compound (P3AB)] / [Total of peak intensities of each of tin compounds (P3AB), (P3A), and (P3B)]

The total value of the contents (%) of each tin compound (P3AB) in this formula was 97.2%. A tin compound having the largest content (%) was a tin compound having seven R^{A} = isopropyl and five R^{B} = tertial-butyl in one molecule, and its content was 16.2%. The content of the tin compound having the largest content was larger than the content of the tin compound (P3A) having only the single organic group R^{A}, 1.8%.

**[Table A-1]**

| | iPr | tBu | | |
|---|---|---|---|---|
| Mi | C₃H₇ | C₄H₉ | | Ni |
| Peak molecular weight | R^{A} | R^{B} | Peak intensity | Content (%) |
| 2266 | 12 | 0 | 242600 | 1.8% |
| 2280 | 11 | 1 | 598300 | 4.5% |
| 2294 | 10 | 2 | 1014000 | 7.7% |
| 2308 | 9 | 3 | 1478000 | 11.2% |
| 2322 | 8 | 4 | 1905000 | 14.4% |
| 2336 | 7 | 5 | 2141000 | 16.2% |
| 2350 | 6 | 6 | 1936000 | 14.7% |
| 2364 | 5 | 7 | 1532000 | 11.6% |
| 2378 | 4 | 8 | 1077000 | 8.2% |
| 2392 | 3 | 9 | 630200 | 4.8% |
| 2406 | 2 | 10 | 327300 | 2.5% |
| 2420 | 1 | 11 | 184500 | 1.4% |
| 2434 | 0 | 12 | 135630 | 1.0% |
| Total | | | 13201530 | 100.0% |

| | | | | |
|---|---|---|---|---|
| iPr : isopropyl tBu : tertiary-butyl | | | | |

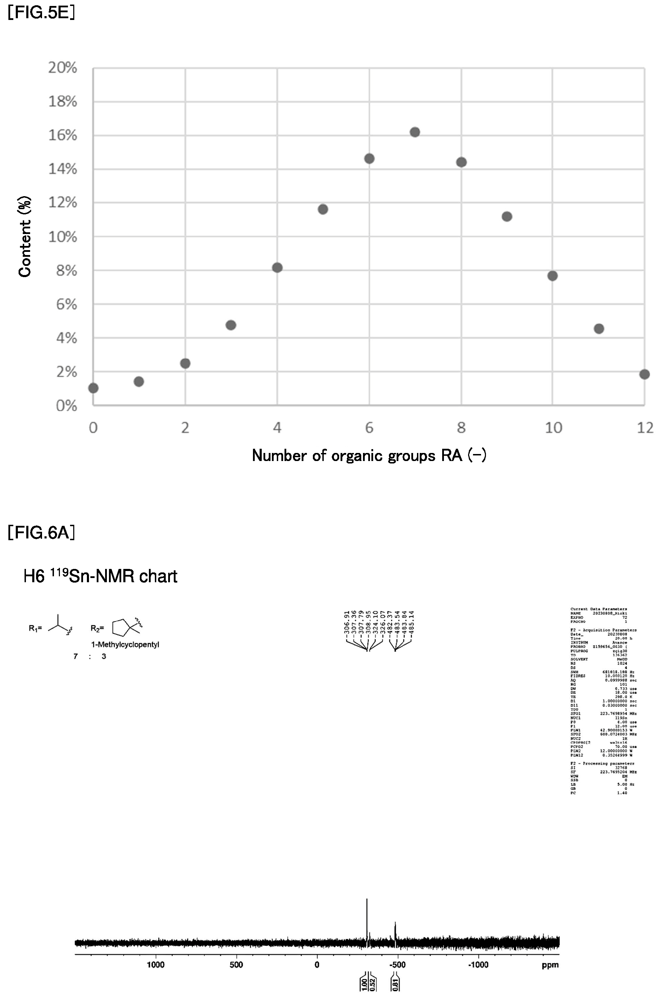

As shown in FIG. 5E, a graph in which the numbers of the organic groups R^{A} of each of the tin compounds were plotted as the x-axis and the contents (%) were plotted as the y-axis exhibited a single-peak distribution structure with the tin compound having the largest content (%) as the peak top (maximum point). From the molecular weight and the content (%) of each of the tin compounds, the number average molecular weight Mn, the weight average molecular weight Mw, and the molecular weight distribution Mw/Mn of the tin hydrolysate H5 were calculated as shown in the following Table A-2.

**[Table A-2]**

| | Calculation method | |
|---|---|---|
| Number average molecular weight Mn | Σ(Mi × Ni) / Σ(Ni) | 2339.51 |
| Weight average molecular weight Mw | Σ(Mi² × Ni) / Σ(Mi × Ni) | 2340.03 |
| Molecular weight distribution | Mn/Mw | 1.00022 |

### Analysis Result of Tin Hydrolysate H6

### (R^{A} = isopropyl, chemical formula: C₃H₇, R^{B} = 1-Methyl-cyclopentyl, chemical formula: C₆H₁₁)

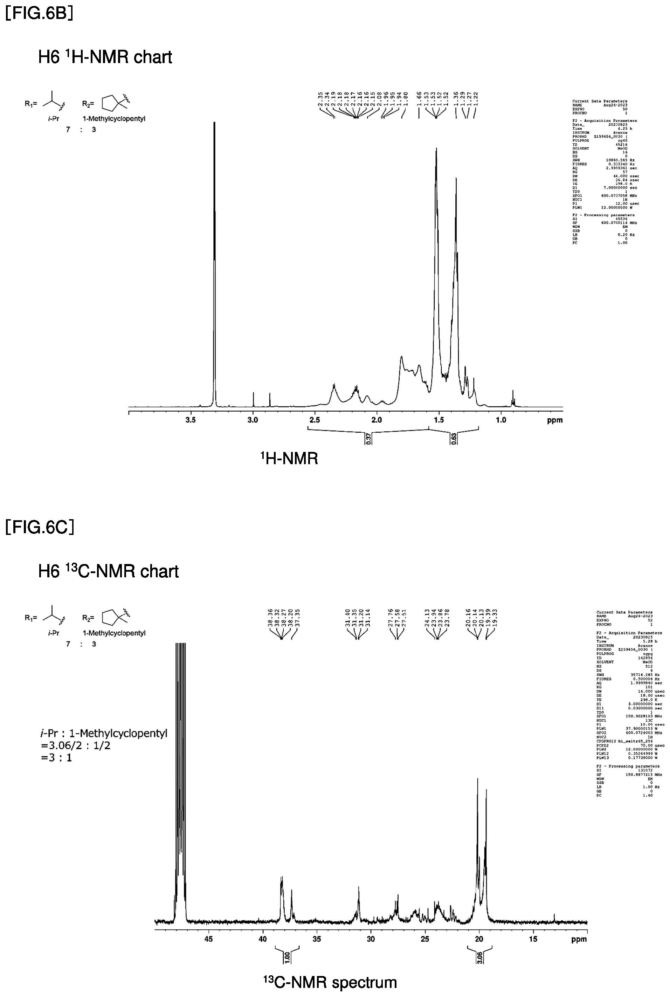

As a result of NMR identification of the tin hydrolysate H6, peaks at about 1.88:1 were observed with five-coordinate : six-coordinate as shown in Table 3, and a compound corresponding to RSnO_{(3/2-x/2)}(OH)ₓ was obtained. From the analysis result with ¹H-NMR and ¹³C-NMR, the composition mole ratio R^{A}:R^{B} was calculated to 75/25. In addition, corresponding peaks with detectable intensity other than k1 and k2 were absent, and thereby the value of (k1+k2)/(k3) indicating the purity was not less than 0.99. This composition correlated the mole ratio of the mixed precursor used as the raw material. FIG. 6A to 6C show NMR spectrums of H6.

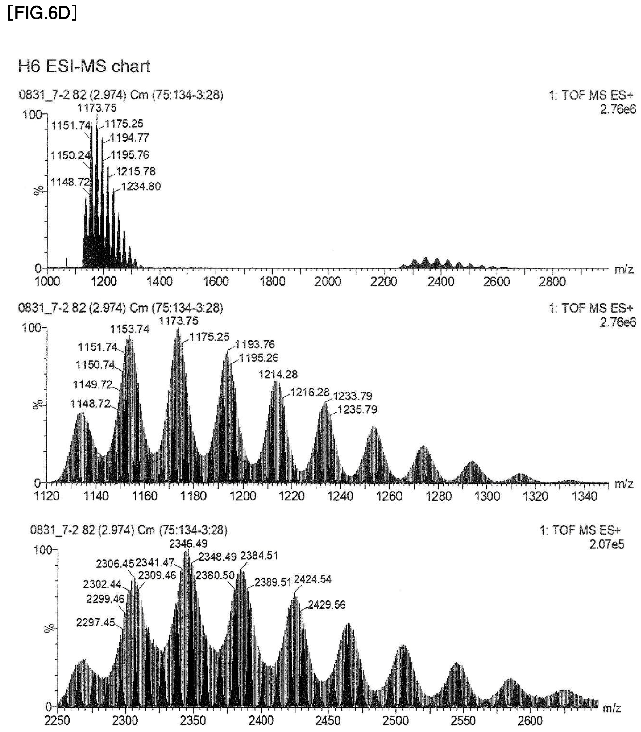

As a result of analysis by electro-spraying ionization mass spectrometry (ESI-MS) of the tin hydrolysate H6, FIG. 6D shows a spectrum of ESI-MS of H6. In this spectrum, peaks corresponding to a divalent ion (specifically, a chemical formula [(R^{A}Sn)₁₁(R^{B}Sn)₁O₁₄(OH)₆]⁺², calculated value m/z = divalent ion (m/z = about 1154) and a monovalent ion (m/z = about 2306) that corresponded to the composition formula RSnO_{(3/2-x/2)} were observed with the strongest intensity, which corresponded to the tin compound (P3AB) having substituents of eleven R^{A} = isopropyl and one R^{B} = 1-Methyl-cyclopentyl. Peaks corresponding to a tin compound having different composition of R^{A} and R^{B} were observed therearound. That is, it has been revealed that R^{A} and R^{B} are present as different types of alkyl groups in one molecule of the tin hydrolysate.

The following Table B-1 shows the molecular weights of the peaks, the peak intensities, and the content (%) detected by ESI-MS. Eleven types of the tin compound (P3AB) contained in the present tin hydrolysate H6 were detected as shown in Table B-1, the tin compound (P3A) having the single organic group R was similarly detected, and (P3B) was not detected. The content of each tin compound was calculated by the following formula as described above. 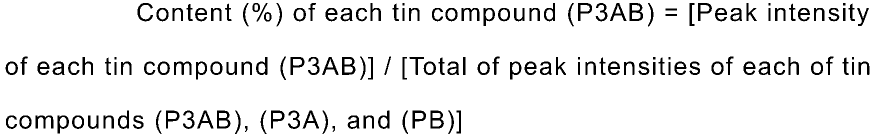 Content (%) of each tin compound (P3AB) = [Peak intensity of each tin compound (P3AB)] / [Total of peak intensities of each of tin compounds (P3AB), (P3A), and (PB)]

The total value of the contents (%) of each tin compound (P3AB) in this formula was 84.8%. A tin compound having the largest content (%) was a tin compound having eleven R^{A} = isopropyl and one R^{B} = 1-Methyl-cyclopentyl in one molecule, and its content was 19.0%. The content of the tin compound having the largest content was larger than the content of the tin compound (P3A) having only the single organic group R^{A}, 15.2%.

**[Table B-1]**

| | iPr | Me-cPen | | |
|---|---|---|---|---|
| Mi | C₃H₇ | C₆H₁₁ | | Ni |
| Peak molecular weight | R^{A} | R^{B} | Peak intensity | Content (%) |
| 2266 | 12 | 0 | 1309000 | 15.2% |
| 2306 | 11 | 1 | 1633000 | 19.0% |
| 2346 | 10 | 2 | 1438000 | 16.7% |
| 2386 | 9 | 3 | 1217000 | 14.1% |
| 2426 | 8 | 4 | 953000 | 11.1% |
| 2466 | 7 | 5 | 721700 | 8.4% |
| 2506 | 6 | 6 | 521900 | 6.1% |
| 2546 | 5 | 7 | 364100 | 4.2% |
| 2586 | 4 | 8 | 243500 | 2.8% |
| 2626 | 3 | 9 | 137700 | 1.6% |
| 2666 | 2 | 10 | 38460 | 0.4% |
| 2706 | 1 | 11 | 24590 | 0.3% |
| 2746 | 0 | 12 | 0 | 0.0% |
| Total | | | 8601950 | 100.0% |

| | | | | |
|---|---|---|---|---|
| iPr : isopropyl | | | | |

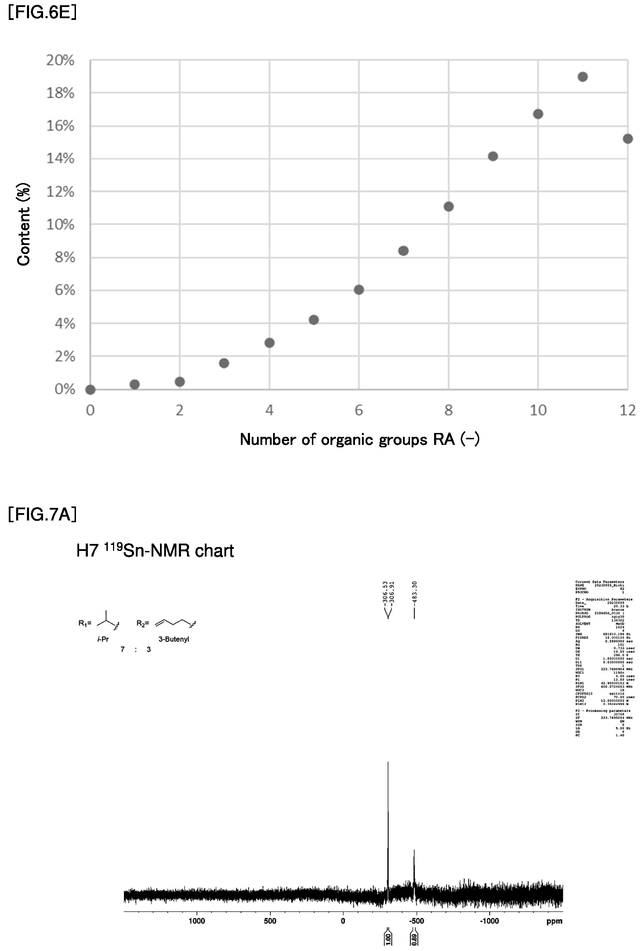

As shown in FIG. 6E, a graph in which the numbers of the organic groups R^{A} of each of the tin compounds were plotted as the x-axis and the contents (%) were plotted as the y-axis exhibited a single-peak distribution structure with the tin compound having the largest content (%) as the peak top (maximum point). From the peak molecular weight (Mi) and the content (%) (Ni) of each of the tin compounds, the number average molecular weight Mn, the weight average molecular weight Mw, and the molecular weight distribution Mw/Mn of the tin hydrolysate H6 were calculated as shown in the following Table B-2.

**[Table B-2]**

| | Calculation method | |
|---|---|---|
| Number average molecular weight Mn | Σ(Mi × Ni) / Σ(Ni) | 2382.73 |
| Weight average molecular weight Mw | Σ(Mi² × Ni) / Σ(Mi × Ni) | 2386.52 |
| Molecular weight distribution | Mn/Mw | 1.00159 |

### Analysis Result of Tin Hydrolysate H7

### (R^{A} = isopropyl, chemical formula: C₃H₇, R^{B} = 3-Butenyl, chemical formula: C₄H₇)

As a result of NMR identification of the tin hydrolysate H7, peaks at about 1.1:1 were observed with five-coordinate : six-coordinate as shown in Table 3, and a compound corresponding to the composition formula RSnO_{(3/2-x/2)}(OH)ₓ was obtained. In addition, corresponding peaks with detectable intensity other than k1 and k2 were absent, and thereby the value of (k1+k2)/(k3) indicating the purity was not less than 0.99. From the analysis result with ¹H-NMR and ¹³C-NMR, the composition mole ratio R^{A}:R^{B} was calculated to 78/22.

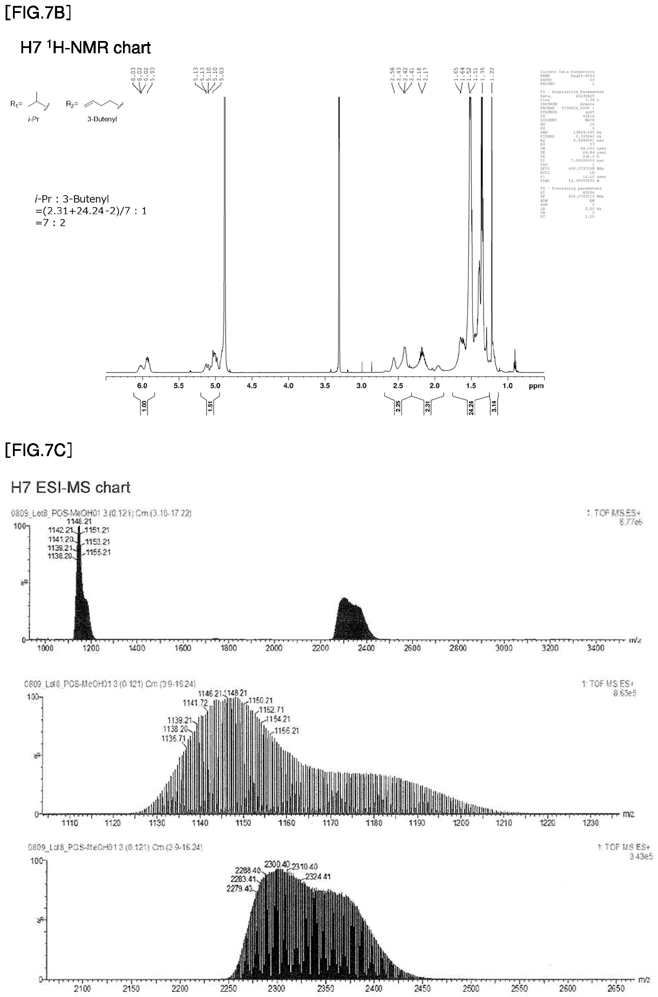

This composition correlated the mole ratio of the mixed precursor used as the raw material. FIG. 7A to 7B show NMR spectrums of H7.

As a result of analysis by electro-spraying ionization mass spectrometry (ESI-MS) of the tin hydrolysate H7, FIG. 7C shows a spectrum of ESI-MS of H7. In this spectrum, peaks corresponding to a divalent ion (specifically, a chemical formula [(R^{A}Sn)₁₀(R^{B}Sn)₂O₁₄(OH)₆]¹², calculated value m/z about 1148) and a monovalent ion (m/z = about 2300) that corresponded to the composition formula RSnO_{(3/2-x/2)} were observed with the strongest intensity, and peaks corresponding to a compound having different composition of R^{A} and R^{B} were observed therearound. That is, it has been revealed that R^{A} and R^{B} are present as different types of alkyl groups in one molecule of the tin hydrolysate.

### <<Solubility, Filterability, and Storage Stability of Resist Solution>>

The obtained tin hydrolysate was used for producing a solution (resist solution) with a resist solvent by the following method. The obtained resist solution was subjected to a dissolution test, a filtration test, and a storage stability test to be evaluated based on the following evaluation criteria.

### <Comparative Example 3-1 to Comparative Example 3-4 and Example 3-1 to Example 3-3>

Specifically, each of the tin hydrolysates H1 to H7 (0.100 g) and 4-methyl-2-pentanol (4.90 g) was weighed in a 20-mL transparent vial made of glass to prepare a resist solution. The vial containing this resist solution was put in an ultrasonic wave generator filled with water at room temperature (23°C), and irradiated with ultrasonic wave for 5 minutes to perform dissolution operation.

### <Comparative Example 3-5>

A resist solution in which 4.0 g of a mixed liquid obtained from **H1** and 1.0 g of a mixed liquid obtained from H2 were further mixed was prepared instead of the resist solution in the Comparative Example 3-1 in accordance with JP-A-2019-500490, and the dissolution operation was performed again by irradiation with ultrasonic wave for 5 minutes similarly to Comparative Example 3-1.

### Method for Evaluating Solubility

The solubility of the tin hydrolysate was evaluated by comparing turbidity (transparency) when the tin hydrolysate was dissolved in the resist solvent at a certain concentration. The specific method, which is disclosed in JP-A-2019-500490, is as follows: preparing 5.0 g of a mixed liquid of the tin hydrolysate in 4-methyl-2-pentanol equivalent to 2.0%, and visually observing turbidity (transparency) of this liquid while comparison with a standard turbidity liquid to evaluate the solubility of the corresponding present tin hydrolysate. As the standard turbidity liquid, a kaoline-turbidity standard liquid described in JIS K0110 (0 degrees (transparent), 50 degrees, 100 degrees, 500 degrees, or 1000 degrees (white turbid)) was used, and a turbidity close to each of the standard turbidity liquids was evaluated based on the following evaluation criteria 1 to 5 as follows.

### (Evaluation Criteria)

·Turbidity evaluation 1: 0 degrees (transparent)
·Turbidity evaluation 2: 50 degrees
·Turbidity evaluation 3: 100 degrees
·Turbidity evaluation 4: 500 degrees
·Turbidity evaluation 5: 1000 degrees (white turbid)

### Method for Evaluating Filterability

The filterability of the tin hydrolysate was evaluated by using a liquid in which the tin hydrolysate was dissolved in the resist solvent at a certain concentration, and by comparing degree of clogging of a filter.

The specific method, which is disclosed in JP-A-2019-500490, is as follows: preparing 5.0 g of a mixed liquid of the tin hydrolysate in 4-methyl-2-pentanol equivalent to 2.0%, and evaluating degree of clogging in filtering this liquid based on the following evaluation criteria.

As a specific procedure, 5.0 g of the mixed liquid was filtered with 10-mL syringe and a filter having a pore diameter of 0.2 µm while pressurizing (about 300 kPa) for evaluation.
(Used filter: 0.2 µm, made of PTFE, effective filtering area: 4.0 cm², produced by ADVANTEC CO., LTD., disposable membrane filter unit DISMIC 25HP045AN)
(Evaluation Criteria)
   ·Filterable at 5.0 g without clogging: "1"
   ·Filterable at not less than 2.0 g but clogged: "2"
   ·Clogged at not greater than 2.0 g: "3"

### Method for Evaluating Storage Stability

The resist liquid after filtration in the method for filterability test was introduced into a brown glass vial (20 mL) in the air, and a lid of the vial was closed. In this state, the vial was stored at 20°C under a light-shielded condition for one month. After the storage, the resist liquid was transferred into a transparent vial, and the evaluation was performed in the same manner as of the solubility evaluation to specify the result as evaluation of the storage stability.

**[Table 4]**

| | Tin hydrolysate | Solubility MIBC 2% solution | | |
|---|---|---|---|---|
| | | Cloudiness of solution | Filterability | Cloudiness of solution (after storage at 20°C for one month) |
| Comparative Example 3-1 | H1 | 4 | 3 | 1 |
| Comparative Example 3-2 | H2 | 5 | 3 | 4 |
| Comparative Example 3-3 | H3 | 4 | 3 | 5 |
| Comparative Example 3-4 | H4 | 3 | 2 | 1 |
| Example 3-1 | H5 | 1 | 1 | 1 |
| Example 3-2 | H6 | 1 | 1 | 1 |
| Example 3-3 | H7 | 1 | 1 | 1 |
| Comparative Example 3-5 | Described in text | 4 | 3 | 2 |

From Example 3-1 to Example 3-3 in the Table 4, it has been revealed that the tin hydrolysate obtained by using the precursor in which a plurality of types of organic group R (R^{A}, R^{B}) are mixed yields a resist solution with high solubility and high storage stability.

From Comparative Example 3-1 to Comparative Example 3-4, it has been found that a tin hydrolysate obtained by using a precursor constituted with a single organic group (only R^{A}) exhibits high crystallinity, low solubility, and poor storage stability.

Further, from Comparative Example 3-5, it has been found that in a case when a plurality of types of the tin hydrolysate constituted with a single organic group (only R^{A}) according to JP-A-2019-500490 also exhibits low solubility. That is, the tin hydrolysate with high solubility may not be obtained unless one molecule of the tin compound has a plurality of types of the alkyl group.

### <<Production of Patterned Thin Film>>

### <Example 4 (Prophetic)>

The obtained tin hydrolysates H5 to H7 of Example 3-1 to Example 3-3 are dissolved in 4-methyl-2-pentanol (5 mL) so that the concentration is 2.0% while using ultrasonic wave, and the obtained solution is filtered with a 0.2-µm syringe filter to obtain a transparent resist solution containing the tin hydrolysate.

A silicon wafer (Si substrate, 100 mm in diameter) having an oxide surface is ozone-treated to be used as a substrate for adhering a resist thin film. Before adhesion of the resist, the surface of the Si substrate is treated with hexamethyldisilazane (HMDS) vapor. The resist solution is applied on the substrate by spin-coating at 2000 rpm, and baked on a hotplate at 90°C for 2 minutes. The film thickness after the coating and baking is measured to be about 22 nm with an ellipsometer. The coated substrate is exposed to ultraviolet ray (light source: xenon excimer lamp (172 nm, 7.2 eV), produced by Ushio Inc., light source intensity: 0.7 mW/cm²) by using a pattern, and the pattern is projected onto the substrate. Then, the substrate is immersed in 2-heptanone for 15 seconds, and further rinsed with the same developer for 15 seconds to form a negative-type image, namely an image (patterned thin film) in which the non-exposed portion is removed and only the pattern-exposed portion is remained in the thin film.

The patterned thin film has higher sensitivity and lower LWR (roughness) than that using the tin compounds of Comparative Examples, and is an excellent resist material.

The specific embodiments of the present disclosure have been described in the above Examples, but the Examples are merely examples, and not limitedly interpreted. It is anticipated that various modifications obvious to a person skilled in the art are within the scope of the present disclosure.

## Claims

1. A tin compound, comprising:
a tin atom;
an organic group R; and
at least one of an oxo-ligand and a hydroxo-ligand,
wherein one molecule of the tin compound includes two or more types of the organic group R and includes a Sn-O-Sn structure, and
wherein the organic group R has 1 to 30 carbon atoms.

2. The tin compound according to claim 1, wherein the tin compound has formula RSnO_{(3/2-X/2)}(OH)_{X}, wherein 0 ≤ x ≤ 3.

3. The tin compound according to claim 1 or 2, wherein the tin compound is a compound comprising a cation having formula (RSn)₁₂O₁₄(OH)₆⁺².

4. The tin compound according to any one of claims 1 to 3, wherein the organic group R has 3 to 10 carbon atoms.

5. The tin compound according to any one of claims 1 to 4, wherein the organic group R is a hydrocarbon group.

6. The tin compound according to any one of claims 1 to 5, wherein the organic group R is a hydrocarbon group, and 20 to 99 mol% of substituents constituting the organic group R is a secondary hydrocarbon group R².

7. The tin compound according to any one of claims 1 to 5, wherein the organic group R is a hydrocarbon group, and 1 to 50 mol% of substituents constituting the organic group R is a tertiary hydrocarbon group R³.

8. The tin compound according to any one of claims 1 to 5, wherein the organic group R is a hydrocarbon group, and 1 to 50 mol% of substituents constituting the organic group R is a cyclic hydrocarbon group R^{c}.

9. The tin compound according to any one of claims 1 to 5, wherein the organic group R is a hydrocarbon group, and 1 to 50 mol% of substituents constituting the organic group R is a hydrocarbon group R^{u} having an unsaturated bond.

10. The tin compound according to any one of claims 1 to 9, wherein the organic group R has an isopropyl group and a t-butyl group.

11. The tin compound according to any one of claims 1 to 10, wherein the organic group R has an isopropyl group and a methylcyclopentyl group.

12. The tin compound according to any one of claims 1 to 11, wherein the organic group R has a saturated hydrocarbon group.

13. The tin compound according to any one of claims 1 to 12, wherein the organic group R has not less than 50 mol% of isopropyl groups.

14. A tin composition, comprising:
the tin compound according to any one of claims 1 or 3 to 13,
wherein three or more types of a tin compound (P3AB) have a cation having formula (R^{A}Sn)ₓ(R^{B}Sn)_{y}O₁₄(OH)₆⁺² measured by ESI-mass,
wherein "x" represents an integer satisfying 0 < x < 12, "y" represents an integer satisfying 0 < y < 12, "x" and "y" satisfy x+y=12, and
in a proportion of a composition of the organic group R calculated by NMR measurement of the tin composition,
an organic group in a largest proportion is represented by R^{A},
an organic group in a second largest proportion is represented by R^{B}, and
the organic group R may have an organic group other than the organic groups R^{A} and R^{B}.

15. The tin composition according to claim 14, wherein a total value of contents (%) of the tin compound (P3AB) calculated by a following calculation formula A is not less than 80%,
<calculation formula A>
the content (%) of the tin compound (P3AB) = [a peak intensity of the tin compound (P3AB)] / [a total of peak intensities of the tin compound (P3AB), a tin compound (P3A), and a tin compound (P3B)],
the peak intensity refers to a peak intensity measured by ESI-MASS, and
the tin compound (P3A) represents a tin compound having only the single organic group R^{A}, and
the tin compound (P3B) represents a tin compound having only the single organic group R^{B}.

16. The tin composition according to claim 15, wherein a content (%) of a tin compound (P3AB-1) with the largest content (%) calculated by the calculation formula A is larger than a content of the tin compound (P3A) having only the single organic group R^{A}.

17. The tin composition according to any one of claims 14 to 16,
wherein, as for a distribution shape of a graph of the contents (%) of the tin compounds (P3AB), (P3A), and (P3B) ,
wherein the tin compounds (P3AB), (P3A), and (P3B) in the tin composition are plotted as a y-axis and a number of the organic groups R^{A} contained in one molecule is plotted as an x-axis, when a tin compound with a largest content is represented as a tin compound (P3AB-1),
the tin compound (P3AB-1) exhibits a peak top (maximum point), and
the distribution shape has a single-top distribution structure.

18. The tin composition according to any one of claims 14 to 17,
wherein a value of a molecular weight distribution Mw/Mn is 1.00001 to 1.05,
wherein the value being calculated from peak molecular weights (Mi) and contents (%) (Ni) of the tin compound (P3AB),
a tin compound (P3A), and
a tin compound (P3B) in the tin composition.

19. The tin composition according to any one of claims 14 to 18,
wherein the tin composition has a ratio [(k1 +k2)/(k3)] of not less than 0.9,
wherein the ratio is of a total value (k1+k2) in ¹¹⁹Sn-NMR of a total (k1) of peak integration values of a five-coordinate Sn (-250 to - 350 ppm) and
a total (k2) of peak integration values of a six-coordinate Sn (-450 to -600 ppm) relative to a total value (k3) of all peak integration values (including k1 and k2) within a range of 1000 to -1000 ppm detected from the ¹¹⁹Sn-NMR.

20. The tin compound according to any one of claims 14 to 19,
wherein the tin composition has a ratio (k1/k2) of 0.5 to 2.5,
wherein the ratio is of a total (k1) of peak integration values of a five-coordinate Sn (-250 to -350 ppm) to a total (k2) of peak integration values of a six-coordinate Sn (-450 to -600 ppm) in ¹¹⁹Sn-NMR.

21. A method for producing at least one of a tin compound and a tin composition, comprising:
a tin atom,
an organic group R;
and at least one of an oxo-ligand and a hydroxo-ligand,
the method comprising:
blending the two or more precursors RSnX₃ (A1) having different structures of the organic group R to obtain a precursor mixture, wherein X represents a hydrolysable group; and
contacting a blend of the precursor mixture and an organic solvent with liquid water.

22. The method for producing at least one of a tin compound and a tin composition according to claim 21, the method comprising:
blending not less than 100 parts by mass of the organic solvent relative to 100 parts by mass of the precursor mixture.

23. A tin compound or a tin composition produced by the producing method according to claim 21 or 22.

24. A resist solution, comprising:
at least one of
the tin compound according to any one of claims 1 to 13;
the tin composition according to any one of claims 14 to 20, and an organic solvent.

25. A patterning method, comprising:
applying the resist solution according to claim 24 on a substrate;
exposing a thin film of the resist solution with radiation; and
developing the thin film by using a developer liquid.

26. A thin film on a substrate, the thin film comprising:
at least one of
the tin compound according to any one of claims 1 to 13,
and the tin composition according to any one of claims 14 to 20.

27. A patterned thin film on a substrate, the patterned thin film comprising:
at least one of
the tin compound according to any one of claims 1 to 13,
and the tin composition according to any one of claims 14 to 20.

28. A method for producing a patterned substrate, the method comprising:
the patterning method according to claim 25.
